(19) Europäisches Patentamt
European Patent Office
Office européen des brevets

(11) Publication number: **0 130 462**
**A2**

(12) # EUROPEAN PATENT APPLICATION

(21) Application number: **84107007.1**

(22) Date of filing: **20.06.84**

(51) Int. Cl.[4]: **H 05 K 3/20**, H 05 K 3/12

(30) Priority: **24.06.83 US 508056**
**25.07.83 US 516689**
**25.07.83 US 516677**
**05.06.84 US 616239**

(43) Date of publication of application: **09.01.85**
**Bulletin 85/2**

(84) Designated Contracting States: **AT BE CH DE FR GB IT LI NL SE**

(71) Applicant: **CHOMERICS, INC., 77 Dragon Court, Woburn Massachusetts 01887 (US)**

(72) Inventor: **Seeger, Richard Earle, Jr., Kittery Point, Maine 08905 (US)**
Inventor: **Morgan, Noredin Hassan, 9 Dragon Court, Woburn, Massachusetts 01801 (US)**

(74) Representative: **Modiano, Guido et al, MODIANO, JOSIF, PISANTY & STAUB Modiano & Associati Via Meravigli, 16, I-20123 Milan (IT)**

(54) **Printed circuits.**

(57) Described herein is a composite structure comprising (a) a solid dielectric support surface; (b) a layer or pathway comprising a thermoset resin and containing sufficient electrically conductive metal particles, in the configuration of at least an electric circuit element, to provide desired properties and preferably to satisfy the Soldering Standard Test (hereinafter defined) and preferably to provide an electric circuit element having a low surface resistivity of 0.1 ohm per square or less. Also described are inks for printed circuit devices, circuit transfer means, and methods for making the same.

EP 0 130 462 A2

0130462

1C367/734
SS*f
6/1/84
0391K/0056S

# PRINTED CIRCUITS

This invention involves inks for printed circuit devices, circuit transfer means, printed circuit devices and methods for making the same.

## BACKGROUND OF THE INVENTION

Printed circuits for electrical use often have to meet certain critical requirements. They should have the capability of being wettable by solder so that a good bond between the circuit and the lead is achievable. They should be capable of being electroless metal plated for adaptability to many product applications. Because they must be handled, the printed circuits should have good adhesion to the dielectric substrate. In the case of this invention, good adhesion will be

characterized as a certain level of "pull strength". Last, but certainly not the least, the circuit should have good electrical conductivity.

There are many processes known for making printed circuits or printed circuit boards. A wide variety of approaches have been defined by the prior art for making them, but each that are discussed below, are often found wanting in one or more respects.

U.S Patent 4,396,666 describes a method of painting an epoxy composition containing 65-85 percent by weight of a solderable metal powder onto a substrate and then slightly pyrolytically decomposing the cured epoxide to expose sufficient of the metal for soldering. The process of that patent suffers from some obvious deficiencies. One apparent deficiency is that the decomposition of the resin can be irregular and so will be the exposed surface of the circuit. Obviously, expulsion of volatile matter from the circuit will open up the surface to crater formation, pits and the like, and the integrity of the circuit could be adversely affected. Pyrolytic decomposition can attack the integrity of the film and especially the binder portion, thus the adhesion of the metal particles to the substrate must be suspect. Owing to the high pyrolytic temperatures, viz. at least 200°C.,

1C367/734
SS*f



substantial damage to the substrate would occur if it was made of a thermoplastic material.

Japanese patent application 56,357/73 (published January 26, 1981, Publication No. 2,435/81) describes printing a circuit pattern with a conductive ink on a transfer paper and then bringing the printed surface of the transfer paper into contact with a board for instant thermocompression bonding. The pattern is formed by a screen printing process onto the transfer paper. The application cites the following advantages for this process, including simplicity, accuracy, uniformity, non-polluting steps, recycling of poorly formed boards and manufacturing versatility. In attempts to follow the procedure of the Japanese patent there are problems in obtaining transfers to the dielectric surface and resultant products can be lacking in desired parameters of conductivity, solderability and or plateability.

The ink employed in the Japanese application contained silver suspended in a solvent containing solution of a thermoplastic copolymer. Example 1 employs a vinyl chloride-vinylacetate copolymer and example 2 uses an "acrylic resin" with no description of its composition. In example 1, the "silver powder" comprised 89.47% of the solids weight of the composition and in example 2, it

comprised 88.09% of the solid weight of the composition. The authors state that they obtain good plateability, easily soldered circuits and good adhesion. However, the authors fail to state the kind of board that was used.

Though the technique of the Japanese application may be capable of transfer of the circuit to the board, the technique is found wanting in several respects:

The amount of thermoplastic resin in the ink can cause the resin to coat the metal sufficiently to adversely affect soldering wettability and electroless plating of the circuit. In addition use of a thermoplastic resin limits the ability to effectively solder the circuit, indeed, it significantly limits the technology to soldering techniques less than the state-of-the-art methods.

Another technique is the dusting method of U.S. Patent 4,327,124, patented April 27, 1982. In that patent, a phenolic thermosetting resin (B-stage) is loaded with copper powder to achieve 70-75% loading and this is silk screened onto a board to form the circuit pattern. Then copper powder is dusted onto the print of wet resin film. The film is then cured and treated with solder.

In addition to the fact that the dusting of copper powder is an awkward process which gives no

assurance of uniform metal distribution, the use of copper powder *per se* is a questionable selection in view of its propensity to form non-conductive oxide over a period of time. Metal powders of metals which will form oxides more readily forms oxides simply because of the increased surface area provided by the powder.

Other techniques are known where 90% by weight or slightly higher of silver particle-containing inks are known for certain circuit pattern applications see U. S. Patent 4,264,477, issued August 28, 1971. However, none of such known techniques obtain the advantages of the present invention.

## DESCRIPTION OF THE INVENTION

The invention comprises in its various aspects a novel highly-metal particle loaded thermosetting adhesive binder containing printing ink; a print transfer composition comprising a release layer carrying a pathway formed by the ink and optionally, a thermosetting adhesive; the use of a transfer composition in a method of forming a composite structure such as a printed circuit board and products produced by the novel method which products include printed circuit articles or devices which have one or more highly-desirable features

achievable by use of this invention.

This invention is directed in part to (A) a composite structure such as a printed circuit article or device comprising *inter alia*

(a) a solid dielectric support surface;

(b) a layer or pathway comprising a thermoset resin and electrically conductive metal particles, in the configuration of at least an electric circuit element, with the metal particles being present in an amount of from about 68 to about 87 percent of the volume fraction based on the dried layer, said electric circuit element having good plateability by electroless plating techniques.

(c) a reactive adhesive interface between the support surface and the lower surface of the layer (b) comprising the thermoset resin.

Most preferably the composite structure satisfies the Soldering Standard Test (hereinafter defined) and/or the Plateability Standard Test (hereinafter defined) and/or has conductive circuit elements with a surface resistivity below 0.5 ohms/square and prefably between 0.1 to 0.01 ohms/square. The composite structure can have multiple layers of pathways in electrical contact with each other at selected areas and separated from each other at other selected areas by a dielectric.

The pathways can each extend in planes at angles to each other and over non-planar supports as around the sides of a board base.

The invention includes (B) a print transfer composition comprising inter alia a solid release surface having coated thereon a pathway in the configuration of an electric circuit or a precursor to or an element of an electric circuit, a thermosetting resin composition comprising electrically conductive metal particles in an amount of from 54 to 87 percent of the volume fraction. As used herein, "electrically conductive metal particles" shall mean particles which comprise (1) an electrically conductive metallic component and (2) passes through 100 mesh size, U.S. Sieve standard, although most preferably the particles pass a screen of 200 mesh size and are substantially restrained on a 350 mesh screen, U. S. Sieve Standard..

Also included within this invention is (C) the print transfer composition (B) wherein the thermosetting resin has been advanced by some degree of crosslinking, such as an A-stage resin advanced to, e.g., a B-stage resin. In a preferred embodiment of the use of an advanced resin is a degree of crosslinking whereby the coating is essentially tack free, preferrably the coated

release surface is sufficiently tack free to allow stacking of the surfaces with the coating thereon without deleteriously altering the coating.

This invention includes (D) a print transfer article suitable for transferring a metallic particulate circuit to a dielectric solid support surface which comprises

(a) a solid release surface;

(b) a layer, in the form of at least an electric circuit element, deposited on the release surface containing a thermosetting resin composition which includes (i) a thermosetting resin and (ii) electrically conductive metal particles, wherein the amount of metal particles in the resin composition is sufficient to satisfy the Soldering Standard Test; and optionally,

(c) a layer of a reactive adhesive provided over the thermosetting resin composition.

This invention encompasses (E) a printing ink for making the aforementioned thermosetting resin composition comprising a mixture of *inter alia* (i) a thermosetting resin in an amount of 32 to 13 percent of the volume fraction and (ii) electrically conductive metal particles in an amount of 68 to 87 percent of the volume freaction of the dried ink. Preferably the ink satisfies the Soldering Standard Test, the Plateability Test and

is capable of producing a circuit having a surface resistivity of 0.5 and most preferably 0.1 ohms per square or lower.

The invention further includes (F) the process of making the aforementioned composite structure and the print transfer composition, which includes inter alia the steps of

(1) providing a release surface;

(2) applying an ink of the thermosetting resin composition containing the desired amount of the electrically conductive metal particles to the release surface as a film (viz. pathway) in the configuration of at least an electric circuit element;

(3) providing a dielectric surface;

(4) providing a reactive adhesive interface capable of inter-acting with the thermosetting resin composition of (2) above and the dielectric surface;

(5) contacting the release surface and the dielectric surface so that the film of electrical circuit element is facing the dielectric surface and is separated therefrom by the adhesive interface;

(6) applying sufficient heat and pressure to form a composite structure whereby the thermosetting resin is essentially sufficiently

cured and the adhesive is essentially sufficiently inter-acted whereby the electrical circuit is transferred from the release surface to become effectively bonded to the dielectric surface;

(7) separating the release surface from the composite structure, to provide an electrical circuit having a resistivity of below 0.5 ohm per square, preferably below about 0.1 ohm per square, and most preferably below about 0.05 ohm per square.

Other embodiments of the invention will be further described below or will become apparent from the description herein set forth.

It should be noted that it is a feature of this invention that highly intricate circuit design can be printed rapidly and efficiently to form desirable printed circuit devices. Such devices include circuit boards, connectors, flexible dielectric base circuits as well as rigid base circuits. The inks of this invention are preferably highly-loaded with metal particles in the range of 93 and preferably, 94 to 98 percent metal particles. The volume fraction of such inks is such that the metal particles comprise 68 to 87 percent of the volume fraction with from 13 to 32 percent of the volume fraction being a thermosetting resin, all calculated on the dry weight of the ink. The

transfer devices can carry ink pathways where the volume percent of the metal particles in the pathway is somewhat broader as in the range of 54 percent to 87 percent of the volume fraction of the pathway with the remainder being thermosetting resin binder. In those cases where less than about 93 to 94 percent by weight metal particles or 68 percent of the volume fraction is used, down to the lower limits of about 90 percent and about 54 percent respectively, some of the most advantageous features of the present invention are not obtained. In the preferred embodiment, excellent solderability is obtained which includes good wettability and high pull strength of resulting pathways. Excellent platability is obtained by use of the transfer process particularly in conjunction with the most preferred ranges of metal particles. Thus, plating by electroless nickel and/or electroless copper techniques can be used without activation of the surface to provide considerable advantages. In those cases where volume fractions of 68 percent to 87 percent metal particles is used in the ink, high conductivity can be obtained as in cases where resistivity is below .5 ohms/per square, preferably below 0.1 ohms/per square in the range of 0.1 to 0.01 ohms/per square and surface resistivities as low as 0.005 can sometimes be obtained. It is a

further feature of this invention that the use of the transfer paper and transfer device enables great flexibility in circuit patterns both in single circuit pattern layered devices and multi-circuit pattern devices. Flexibility is further enhanced in that circuit patterns can be formed on transfer sheets and transferred to dielectric boards on more than one planar surface thereof as, for example, on a top planar surface extended over the edge of the board and onto a side or rear surface thereof by compressing a transfer sheet against angular surfaces of the board.

## BRIEF DESCRIPTION OF THE DRAWINGS

FIG. 1 is a top view of a circuit board embodying the invention;

FIG. 2 is a sectional view taken along line 2-2 of FIG. 1;

FIG. 3 is a top view of a substrate supporting the pathways of a thermosetting resin composition forming a circuit board;

FIG. 4 is a sectional view of the circuit board of FIG. 3 in a heated press which achieves in a preferred embodiment of compacting the pathways;

FIG. 5 is a view similar to FIG. 4 showing a reduction in height (thickness) of the pathways after compacting of e.g., 25 to 40 percent.

FIG. 6 is a side elevational view showing circuit lines (pathways) as an ink slurry on a transfer (e.g. peel-off) carrier layer;

FIG. 7 is a view showing the application of heat to volatilize the solvent in the ink while the sheet is on a support;

FIG. 8 is a view showing an adhesive applied over the pathways to hold it on the transfer layer during further processing and the application of pressure by a press to compact the pathways;

FIG. 9 is a view showing the lamination of electrical pathways to a dielectric board while applying heat and pressure to compact the pathways;

FIG. 10 is a view of the board and circuit pathways after removing the transfer layer; and

FIG. 11 is an enlarged sectional view taken along line 6-6 of FIG. 10 and it should be noted that the pathways while shown indented slightly into the planar surface of the board may be level with the top surface of the board and most often are not indented at all, and

FIG. 12 is an enlarged cross sectional view of a multi-electric circuit pathway device where a transfer sheet of this invention is used to form laminated layers of conductive circuits.

DETAILED DESCRIPTION OF THE INVENTION

The ability of metals to conduct electricity is well known in the art. When the metals have the capability of being converted to their oxides in air, their ability to conduct electricity is dependant upon their degree of oxidation to the oxide; the oxide form being non-conductive. When the same metal is comminuted, there is more surface area available for reaction with oxygen, thus the particles become more readily non-conductive. Consequently, the desired particulate metals, when used for electrical conductance, are those which are relatively inert to oxygen, such as the noble or precious metals, e.g., silver, gold, palladium, platinum, rhodium, ruthenium, and the like.

Of the noble or precious metals, silver is the most electrically conductive and the most widely used member of that family in making printed circuits. However, its cost is such that whenever it can be replaced by a less expensive metal, prudence dictates such replacement. Thus in making electrically conductive films from silver particles, other materials are substituted for silver whenever possible.

Heretofore, in making an electrically conductive element on a dielectric substrate, there

were a number of countervailing factors which dictated against the substitution of silver by other materials. For example, in order to adequately adhere silver particles to a dielectric surface one is required to use an adhesive or binding resin. However, in order to satisfy the application requirements of the circuit, the silver particles have to be adequately bonded to the dielectric surface, and this requires the use of substantial amounts of adhesive and/or binder. As a result, the particles of silver become encased (or encapsulated) by the adhesive/binder. When the surface of the circuit has to be soldered or electrolessly metal plated, then a portion of the adhesive/binder encapsulating the metal has to be removed to allow direct adhesion of solder or electroless metal (viz. nickel) to the metal particles. This serves to destroy the integrity of the adhesive/binder system and diminishes its strength. This problem is compounded when a portion of the silver is replaced by a filler material such as particles of other metals as nickel, copper, zinc, iron, alloys, etc. In such a case, the degradation of the encapsulating adhesive/binder serves to expose those oxidizable metals which lowers the conductivity of the circuit.

This invention does a number of remarkable things. This invention allows one to bind the

electrically conductive metal particles in such a fashion that the volume fraction taken up by these particles represents a large portion, indeed the major portion, of the electric circuit element. In the preferred embodiment, the volume fraction of the particles is at least about 54 percent and preferably at least about 68 to 87 percent of the volume of the electric circuit element on a dried basis. This can translate where the electrically conductive particles are silver particles to a solids weight percent of the thermosetting resin composition of at least 90 percent, preferably at least about 94 percent, and most preferably at least about 95 percent, to a maximum of about 98 percent. Generally in any given system the higher the electrically conductive metal the superior will be the electrical conductivity of the electric circuit element.

This invention allows the metal particles to be sufficiently exposed at the surface of the circuit pathway without the need to degrade the resin binder. It has been determined that a small amount of silver is required to achieve the desired level of conductivity. For example, by using the high metal loadings set forth above for this invention, one may combine a mixture of, e.g., 25 weight percent silver particles with 75 weight

percent of nickel particles (a weight ratio of 1 to 3), and achieve therewith 65 percent of the electrical conductivity achieved using 100 weight percent of silver particles. Generally as this weight ratio is increased so is the resultant conductivity.

Consequently, the electric circuit element of the preferred embodiment of this invention is wettable by solder (passes the "Soldering Standard Test" as hereinafter described) and can be readily electroless nickel plated (as per the "Plateability Standard Test", hereinafter defined).

These advantages are achieved by separating the function of binders as employed in previous ink deposited printed circuits. Instead of having the binder for the electrically conductive metal particles function as an adhesive to the dielectric surface, this invention preferably tailors it solely for holding the particles together in the form of an electric circuit element. In a separate step the particles and binder are blended to produce a mixture containing the uniquely high electrically conductive metal particle loadings. This is considered a unique and unobvious composition.

This composition is made more unique by making the resin binder one which on cure crosslinks into a thermoset condition. It is thus called a

"thermosetting resin" because it can thermoset or be in a thermoset condition. Tnus the composition comprises the high volume loading of the conductive metal in a thermosetting binder. When cured, the binder most effectively holds the resin particles together to make a more superior electric circuit element that can be wetted by solder and electroless nickel coated preferably without the need of an activator.

Next, instead of coating (or printing) the metal/binder composition onto a dielectric substrate or circuit board as is frequently done in the prior art, the composition is printed as a film onto a release surface substrate that gently holds the composition in the desired circuit element configuration. This allows an interesting transition to occur in the coated or printed element film. It is believed that because of the particle loading and the higher density of the particles to the resin, a facile but real settling action of the particles occurs and the particles can be seen under elecron microscope to be congregated and concentrated at the surface defining the interface with the release surface. Since this surface of the film is to be eventually the exposed surface of the circuit element, an enriched metal surface is provided for soldering and electroless metal plating.

The advantages that settling provides can be achieved and indeed enhanced by compacting the wet film or semi-dry film while on the release surface and/or during the transfer step. Compaction achieves densification of the film and the concentration of the particles at the release surface/film interface without using the release surface as a substrate. Thus vertical printing followed by heating and compaction may be employed and settling alone is not required.

The resin/particle composition on the release surface is partially cured. This can be defined in another way. The resin is induced into a partial degree of crosslinking, oftentimes characterized as going from one stage to another, as an A-stage resin to a B-stage resin. This serves to adhere the particles into a unified film which can be handled sufficiently for transferring to the dielectric surface.

In the practice of this invention, the bonding of the thermosetting film loaded with metal particles is achieved by creating a separate adhesive interface between the film and the dielectric surface. Thus, the binder alone is need not be the agent which permits the particles to be bonded to the dielectric surface. This adhesive interface can be an adhesive material supplied as an

overcoat over the film while it is still on the release surface or it can be a separately supplied adhesive film (or layer) supplied to the dielectric surface prior to joining the thermosetting film with the dielectric surface. In another embodiment, the adhesive may be part of the structure of the dielectric surface; e.g., the dielectric surface can be a thermosetting resin prepeg to which the thermosetting film is supplied and they are bonded and cured together into an integrated composite structure.

Important to this invention is the kind of bond achieved between the thermosetting resin film to be transferred to the dielectric surface, and the dielectric surface. For this invention, that bond must withstand very severe conditions. The ultimate composite must be able to pass the Soldering Standard Test and the Plateability Standard Test without diminishing its physical and electrical properties. The ultimate composite should be able to withstand temperatures in air of about 260°C. (500°F) for 20 seconds without diminishing its physical and electrical properties.

The release surface containing the thermosetting film is brought into contact with the dielectric surface such that the film faces the dielectric surface. The multilayers comprising the

release surface, the thermosetting resin film, the adhesive interface and the dielectric surface are subjected to enough heat and pressure to cause the film to be essentially cured (C-stage) and adhesion is provided for the ultimate composite structure. Then the release surface is removed from the cured resin. The more dense, more highly loaded, i.e. concentrated, metal particle surface of the film is now exposed.

In a preferred embodiment, when the multilayers are formed they are subjected to sufficient pressure during curing to cause some compaction of the thermosetting film. This causes further densification of the circuit element, improving its conductive qualities. Such compaction is permanent in the structure of the film because the resin is thermoset in that condition. It has been noted that such compaction does not result in smearing of the film, and thus the fine edges achieved in printing are maintained. Preferably compaction of 25 to 40% of original printed pathway thickness is carried out.

This invention overcomes many deficiencies in printed circuitry of the past in terms of simplicity, ease of operation, functional utilization and performance. As seen from the foregoing the invention relies upon the

interfunctionality of the materials employed to provide advantages not contained in prior art products and processes.

As pointed out above, a fundamental facet of the invention is the utilization of a resin composition comprising

1. a thermosettable resin and
2. electrically conductive metal particles.

## THERMOSETTABLE RESINS

Thermosettable (or thermosetting) resins are organic or inorganic, synthetic or natural resin materials, preferably organic and synthetic, which upon activation by heat, catalysis and/or radiation undergo a crosslinking reaction. The degree of crosslinking determines whether the resin becomes partially or fully cured. Cured means that the level of crosslinking is such that the resin is termed thermoset, i.e., the resin is a crosslinked solid wherein crosslinking is essentially complete. Thermosettable resins comprise functional groups or moieties bonded within the skeletal framework of the resin that cause the crosslinking to occur. For example, the known phenolic resins crosslink by the condensation reaction of methylol groups with themselves. This condensation can be aided by

adding a functional equivalent such as hexamethylenetetraamine. Urea-formaldehyde resins operate by the same methylol condensation, as do the melamine-formaldehyde resins. Another class of thermosettable resins are the epoxy resins. These resins are based upon the reactions of vicinal epoxy groups with active hydrogen compounds such as amines, phenolic or alcoholic hydroxyl, mercaptans, silanic hydride, amides, carbamates, ureas, and the like, or acids and bases. Silicone resins are typically of the formula

$$R_nSiO_{\frac{4-n}{2}}$$

wherein n has an average value of about 0.5 to about 1.7, R is any organic radical which is carbon bonded to the Si or $C_4$ or larger organic moieties bonded to the Si by a carbon-oxygen-silicon bond, are typically formed by the hydrolysis and condensation of silane monomers such as

$$R_nSiX_{4-n}$$

wherein n and R are as above defined and X is a hydrolyzable group such as halide (Cl, Br, F and I), alkoxy (preferably 1 to 4 carbon atoms) and aroxy

(preferably no more than 1 ring structure). Another class of resins combines the chemistry of silicones as above defined with organo functional interreactions as pointed out herein. In those resins, R contains organofunctionality such as aminoalkyl, acryloxyalkyl, methacryloxyalkyl, glycidyloxyalkyl, 3,4-epoxy cyclohexylalkyl, mercaptoalkyl, and the like.

Other thermosetting resin are formed by the reaction of isocyanate groups in the resin skeleton with active hydrogen compounds, including the above and water. The resulting polymers can be termed polyurethanes, polyureas, and combinations of them.

Other thermosetting resins are formed by free radical addition methods. For example, bis, tris and tetraacrylates and methacrylates can be readily crosslinked by incorporating a free radical initiator in the resin or by subjecting the resin to appropriate radiation that induces the formation of free radicals, e.g., electron beam, or ultraviolet radiation, or any form of radiation which causes the vinylic radicals to interreact.

Systems which combine these methods of crosslinking are most suitable in the practice of this invention. For example, a resin which possesses both condensation and free radical crosslinking capabilities can be utilized through one of

those routes to advance polymerization so that the resin is non-tacky but not fully cured. Final curing can be effected at a later stage as e.g., herein characterized for the print transfer composition after it has been applied to form the composite product.

Specific thermosettable resins which are suitable for use in this invention are described as follows:

(1) An unsaturated polyester. These polyesters are typically the condensation products of a diol and an unsaturated dicarboxylic acid or anhydride. The diol is generally selected from ethylene glycol, diethylene glycol, propylene glycol, dipropylene glycol, neopentyl glycol, alkoxylated derivatives of bisphenol-A, 2,2,4-trimethyl-1,3-pentanediol, 2,2-dimethyl-3-hydroxypropyl 2,2-dimethyl-3-hydroxypropionate, and 1,3-butanediol. The unsaturated acids include maleic acid and fumaric acid. Acids without reactive double bonds which may be used in modifying amounts include phthalic acid, isophthalic acid, terephthalic acid, and adipic acid. Anhydrides of the above acids, such as maleic anhydride and phthalic anhydride are often used.

The unsaturated polyesters are generally

prepared by heating approximately equimolar amounts of the diol with the carboxylic acid or anhydride at temperatures in excess of about 200°C for periods of about 4 to about 24 hours. The polyesters typically have number average molecular weights (Mn) in the range of from about 500 to about 5000, and they contain unsaturation distributed along the chain. These polyesters have acid numbers in the range of from about 2 to about 60. (The acid number is the milligrams of potassium hydroxide needed to neutralize one gram of sample). Many of the polyesters have hydroxyl numbers approximately equal to or greater than their acid numbers.

An additional group of polyesters are also contemplated for use herein. These polyesters are prepared by incorporating dicyclopentadiene into the backbone of the polyester. These polyesters are described, for example, in U.S. Patents 3,347,806; 3,933,757; 4,029,848; 4,148,765 and 4,224,430.

(2) A half-ester of a hydroxyl-terminated polyester characterized by the following empirical formula:

$$\text{(I)}\quad [HO\overset{O}{\overset{\|}{C}}-CH=CH\overset{O}{\overset{\|}{C}}-O]_n-R-(OH)_m$$

wherein n has an average value between about 1.5 and 2, m is 2-n, R is the hydroxyl-free residue of a

predominantly hydroxyl- terminated polyester having a molecular weight not exceeding about 1500 and obtained by the condensation of a diol with a dicarboxylic acid or anhydride.

These are described in U.S. Patent 4,294,751.

The predominantly hydroxyl-terminated polyester used to produce the half ester is typically prepared from (a) a diol selected from the class consisting of 1,2-propylene glycol, 1,3-butanediol, 2,2-dimethyl-1,3-propanediol, dipropylene glycol, diethylene glycol, 2,2-dimethyl-3-hydroxypropyl 2,2-dimethyl-3-hydroxypropionate, and mixtures thereof, and mixtures of ethylene glycol and the aforementioned diols, and (b) a dicarboxylic acid or anhydride selected from the class consisting of maleic acid and anhydride, fumaric acid, orthophthalic acid and anhydride, isophthalic acid, terephthalic acid, bicyclo [2.2.1] hept-5-ene-2,3-dicarboxylic acid and bicyclo [2.2.1] hept-5-ene-2, 3-dicarboxylic acid anhydride, and mixtures thereof. The diol and dicarboxylic acid or anhydride are heated until a polyester is formed possessing an acid number of less than about 15, preferably less than about 10 and most preferably, less than about 5. When the molar ratio of diols to

dicarboxylic acids is greater than about 1.5, the hydroxyl number is typically in excess of about 65, and most desirably in excess of 100. Hydroxyl numbers for the hydroxyl terminated polyester can be as high as 250 and greater. Polyester esterification catalysts such as amines or tin compounds may optionally be used to increase the rate of formation of the polyester.

The half ester of formula (I) is conveniently prepared by reacting the predominantly hydroxyl-terminated polyester oligomer with maleic anhydride in a stoichiometric ratio of one mole of hydroxyl per 0.75 to 1.2 moles of maleic anhydride. A catalyst may optionally be used to carry out this reaction. These catalysts include tin compounds and amine compounds.

(3) A half ester of an organic polyol characterized by the following empirical formula:

$$\text{(II)} \quad (HO{-}\overset{O}{\overset{\|}{C}}{-}CH{=}CH\overset{O}{\overset{\|}{C}}{-}O)_a{-}R_1{-}(OH)_b$$

wherein a is a number having an average value of about 1.5 to less than about 4, b is equal to the free valence of $R_1$ less the average value of a, $R_1$ is the hydroxyl-free residue of an organic polyol which contained from 2 to 4 inclusive, hydroxyl groups, OH, in formula (II).

The organic polyol which is reacted with the maleic anhydride to form the half ester depicted by empirical formula (II) contains at least two carbon atoms and which may contain from 2 to 4, inclusive, hydroxyl groups. These polyols include alkane diols, triols, tetraols, aliphatic ether containing diols, triols, tetraols, cycloaliphatic containing diols, triols, and tetraols, and aromatic containing diols, triols, and tetraols, and the like. Specific illustrations of organic polyols suitable in the practice of this invention include the following: ethylene glycol, diethylene glycol, 2,2,4-trimethyl-1,3-pentane diol, dipropylene glycol, propylene glycol, polypropylene glycol having an average molecular weight of about 150 to about 600, triethylene glycol, 1,4-cyclohexane dimethanol, neopentyl glycol, 2,2-dimethyl-3-hydroxypropyl 2,2-dimethyl-3-hydroxy-propionate, the ethylene and propylene oxide adducts of 2,2-dimethyl-3-hydroxypropyl 2,2-dimethyl-3-hydroxypropionate, triethanolamine, 1,3-butanediol, tetraethylene glycol, 2,2-bis(4- hydroxyphenyl)-propane and the ethylene and propylene oxide adducts of 2,2-bis(4-hydroxyphenyl)propane, pentaerythritol, erythritol, glycerine, trimethylolpropane, 1,4-butanediol, 1,6-hexanediol, the polycaprolactone ester of a polyol in which from about 1 to about 5,

preferably from about 1.5 to about 4.0 equivalents of caprolactone are esterified with a polyol (as described in, for example, U.S. Patent 3,169,045) such as trimethylolpropane or diethylene glycol (preferably the polycaprolactone ester of a polyol is the polycaprolactone ester of trimethylolpropane in which about 1.5 equivalents of caprolactone are reacted with trimethylolpropane or the polycaprolactone ester of trimethylolpropane where about 3.6 equivalents of caprolactone are esterified with trimethylolpropane), 2-ethyl-1,3-hexanediol, 1,5-pentanediol, tripropylene glycol, 2,2-bis(4-hydroxycyclohexyl)propane, 1,2,6-hexane triol, 1,3-propane diol, and the like.

The half-esters of formula (II) are described in for example U.S. Patent 4,263,413.

These half esters may also be blended with a polyepoxide or an unsaturated polyester.

(4) A poly(acrylate) characterized by the following empirical formula:

(III) 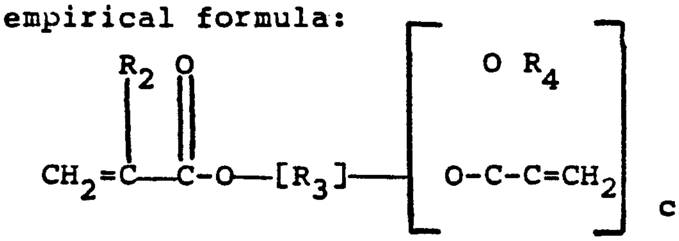

wherein $R_3$ is the hydroxy-free residue of an organic polyhydric alcohol which contained alcoholic hydroxyl groups bonded to different carbon atoms,

$R_2$ and $R_4$ are independently hydrogen or methyl, and c is 1 to 3.

The polyhydric alcohol suitable for preparing the poly(acrylate) typically contains at least two carbon atoms and may contain from 2 to 4, inclusive, hydroxyl groups. These polyhydric alcohols include alkane diols, triols, tetraols, aliphatic ether containing diols, triols, tetraols, cycloaliphatic containing diols, triols, and tetraols, and aromatic containing diols, triols, and tetraols, and the like. Specific illustrations of organic polyols suitable in the practice of this invention include the following: ethylene glycol; diethylene glycol; 2,2,4-trimethyl-1,3-pentanediol; dipropylene glycol; propylene glycol; polypropylene glycol having an average molecular weight of about 150 to about 600, triethylene glycol; 1,4-cyclohexane dimethanol; neopentyl glycol; 2,2-dimethyl-3-hydroxypropyl,2-dimethyl-3-hydroxy-propionate; polyethylene glycol having an average molecular weight of about 150 to about 600; 2,2-bis[4-(2-hydroxyethoxy)phenyl]propane; 2,2-bis[4-(2-hydroxypropoxy)phenyl]propane; triethanolamine; 1,3-butanediol; tetraethylene glycol; 2,2-bis(4-hydroxyphenyl)propane; glycerine; trimethylolpropane; 1,4-butanediol, the polycaprolactone ester of trimethylolpropane which

contains about 1.5 equivalents of caprolactone ester; the polycaprolactone ester of trimethylolpropane which contains about 3.6 equivalents of caprolactone; 2-ethyl-1,3-hexanediol, 1,5-pentanediol, tripropylene glycol, 2,2-bis-(4-hydroxycyclohexyl)propane; 1,2,6-hexane triol; 1,3-propanediol; 1,6-hexanediol and the like. Mixtures of the aforementioned polyols may also be used in this invention.

The poly(acrylate) of the aforementioned organic polyhydric alcohol can be prepared by the reaction of acrylic acid or methacrylic acid or their simple esters with the polyhydric alcohol under conditions well known in the art.

The above half-esters, and the polyacrylates, typically have low viscosities and consequently they may be used in filled resin compositions where a small amount to no solvent is employed.

(5) A vinyl ester resin produced by the addition of an unsaturated monocarboxylic acid to a polyepoxide.

The vinyl esters which may be used in this invention are produced from the addition of an unsaturated monocarboxylic acid to a polyepoxide. These vinyl esters are well known in the art and many are commercially available. These are

described in, for example, U.S. Patents 3,377,406; 3,637,618; 4,197,340 3,317,365, and 3,373,075.

The unsaturated carboxylic acid which may be used includes acrylic acid, methacrylic acid, crotonic acid, and acids prepared from the reaction of hydroxyalkyl acrylates or methacrylates with maleic anhydride, phthalic anhydride, and the like.

The polyepoxides may be saturated or unsaturated, aliphatic, cycloaliphatic, aromatic or heterocyclic and may be substituted, if desired, with non-interfering substituents, such as halogen atoms, hydroxyl groups, ether radicals, and the like.

The epoxides which may be used herein include: glycidyl ethers of novolac resins, i.e., phenol-aldehyde condensates. Preferred resins of this type are those of the formula:

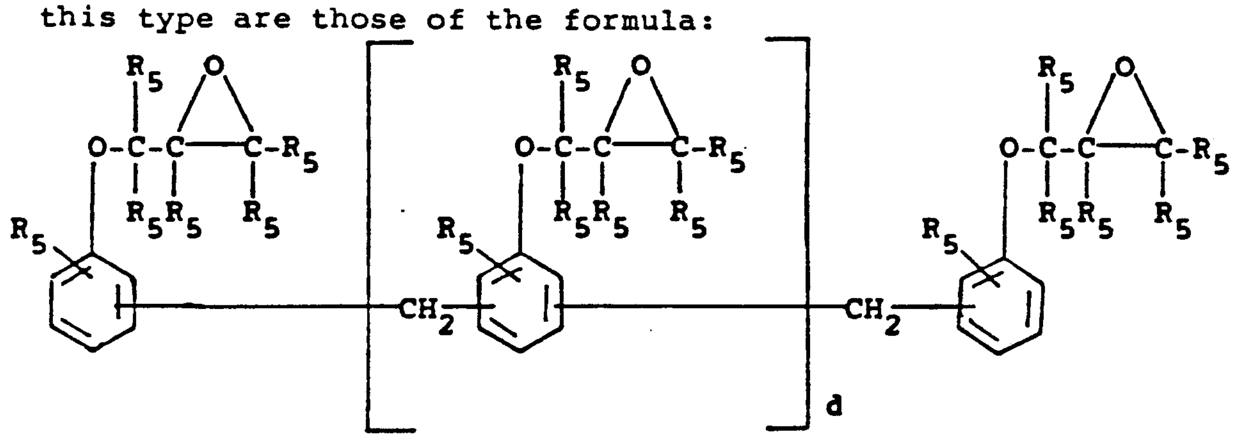

wherein $R_5$ is hydrogen or an alkyl radical and d has a value of from 0.1 to about 5, and preferably less than 1.0. Preparation of these polyepoxides is

illustrated in, for example, U. S. Patents 2,216,099 and 2,658,885.

Other groups of epoxy-containing compounds suitable for use herein include: the epoxidized esters of the polyethylenically unsaturated monocarboxylic acids, such as epoxidized linseed or soybean oil, methyl linoleate, monoglycerides of tung oil fatty acids, and the like; the epoxidized esters of unsaturated monohydric alcohols and polycarboxylic acids, such as, di(2,3-epoxyoctyl)pimelate; epoxidized esters of unsaturated alcohols and unsaturated carboxylic acids, such as 3,4-epoxycyclohexylmethyl-3,4-epoxycyclohexane carboxylate, and the like; epoxidized derivatives of polyethylenically unsaturated polycarboxylic acids, such as dimethyl 8,9,12,13-diepoxyeicosanedioate; epoxidized polyesters obtained by reacting an unsaturated polyhydric alcohol and/or unsaturated polycarboxylic acid or anhydride, such as the polyester obtained by reacting, 8,9,12,13-eicosanedienedioic acid with ethylene glycol; and epoxidized polyethylenically unsaturated hydrocarbons, such as the epoxidized 2,2-bis(2-cyclohexenyl)-propane and epoxidized dimer of cyclopentadiene; and the like.

A preferred polyepoxide includes the

glycidyl polyethers of polyhydric phenols and polyhydric alcohols. Especially preferred are the diglycidyl polyethers of 2,2-bis(4-hydroxyphenyl)propane having the following formula:

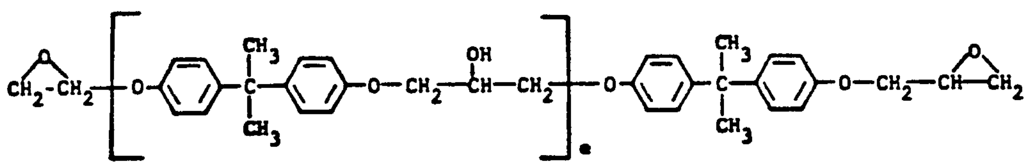

wherein e has values so that the average molecular weight of the saturated polyepoxide is from 340 to about 2000. Acid modified vinyl ester resins may also be included in this invention. These are described, for example, in U.S. Patents 3,634,542; 3,548,030 and 3,564,074.

(6) A urethane poly(acrylate) characterized by the following empirical formula:

$$(CH_2=\underset{R_6}{\underset{|}{C}}-\overset{O}{\overset{\|}{C}}-O-R_7-O-\overset{O}{\overset{\|}{C}}-NH-R_8-NH\overset{O}{\overset{\|}{C}}-O\!\!\rightarrow_f R_9$$

wherein $R_6$ is hydrogen or methyl; $R_7$ is a linear or branched divalent alkylene or oxyalkylene radical having from 2 to about 5 carbon atoms; $R_8$ is a divalent radical remaining after reaction of a substitued or unsubstitued diisocyanate; $R_9$ is the hydroxyl-free residue of

an organic polyhydric alcohol which contained hydroxyl groups bonded to different carbon atoms; and f has an average value of from 2 to 4. These compounds are typically the reaction products of a polyol in which the hydroxyl groups are first reacted with a diisocyanate using one equivalent of diisocyanate per hydroxyl group, and the free isocyanate groups are then reacted with a hydroxyalkyl ester of acrylic or methacrylic acid.

The polyhydric alcohol suitable for preparing the urethane poly(acrylate) typically contains at least two carbon atoms and may contain from 2 to 4, inclusive, hydroxyl groups. Such polyols are described in (3) and (4) supra. A preferred polyol is one based on the polycaprolactone ester of a polyhydric alcohol such as described in, for example, U.S. Patent. 3,169,945. Unsaturated polyols may also be used.

Diisocyanates suitable for preparing the urethane poly(acrylate)s are well known in the art and include aromatic, aliphatic, and cycloaliphatic diisocyanates. Such diisocyanates may be extended with small amounts of glycols to lower their melting point and provide a liquid diisocyanate.

The hydroxyalkyl esters suitable for final reaction with the polyisocyanate formed from the polyol and diisocyanate are exemplified by

hydroxyethyl acrylate, hydroxypropyl acrylate, hydroxyethyl methacrylate, and hydroxypropyl methacrylate. Any acrylate or methacrylate ester or amide containing an isocyanate reactive group may be used herein, however.

Urethane poly(acrylates) such as the above are described in for example, U.S. Patents 3,700,643, 4,131,602, 4,213,837, and 3,772,404.

(7) A urethane poly(acrylate) characterized by the following empirical formula:

$$\left(CH_2=\underset{R_{10}}{\underset{|}{C}}-\overset{O}{\overset{\|}{C}}-O-R_{11}-O-\overset{O}{\overset{\|}{C}}-NH\right)_g R_{12}$$

wherein $R_{10}$ is hydrogen or methyl; $R_{11}$ is a linear or branched alkylene or oxyalkylene radical having from 2 to about 5 carbon atoms; $R_{12}$ is the polyvalent residue remaining after reaction of a substituted or unsubstitued polyisocyanate; and g has an average value of from about 2 to about 4. These compounds are typically the reaction products of a polyisocyanate with a hydroxyalkyl ester of acrylic or methacrylic acid using one equivalent of the hydroxyalkyl ester per isocyanate group.

Polyisocyanates suitable for preparing the urethane poly(acrylate) are well known in the art

and include aromatic, aliphatic, and cycloaliphatic polyisocyanates. Some diisocyanates may be extended with small amounts of glycol to lower their melting point and provide a liquid diisocyanate.

Urethane poly(acrylates) such as the above are described in, for example, U.S. Patent 3,297,745 and British Patent 1,159,552.

(8) A half-ester or half-amide characterized by the following empirical formula:

$$CH_2=\underset{R_{13}}{\underset{|}{C}}-\overset{O}{\overset{\|}{C}}-W-R_{14}-Z-\overset{O}{\overset{\|}{C}}-CH=CH-\overset{O}{\overset{\|}{C}}-OH$$

wherein $R_{13}$ is hydrogen or methyl, $R_{14}$ is an aliphatic or aromatic radical contining from 2 to about 20 carbon atoms, optionally containing -O- or $-\overset{R_{15}}{\overset{|}{N}}-$; W and Z are independently -O- or $-\overset{R_{15}}{\overset{|}{N}}-$; and $R_{15}$ is hydrogen or low alkyl. Such compounds are typically the half-ester or half-amide product formed by the reaction of a hydroxy, amino, or alkylamino containing ester or amide derivatives of acrylic or methacrylic acid with maleic anhydride, maleic acid, or fumaric acid. These are described in, for example, U.S. Patents 3,150,118

and 3,367,992.

(9) An unsaturated isocyanurate characterized by the following empirical formula:

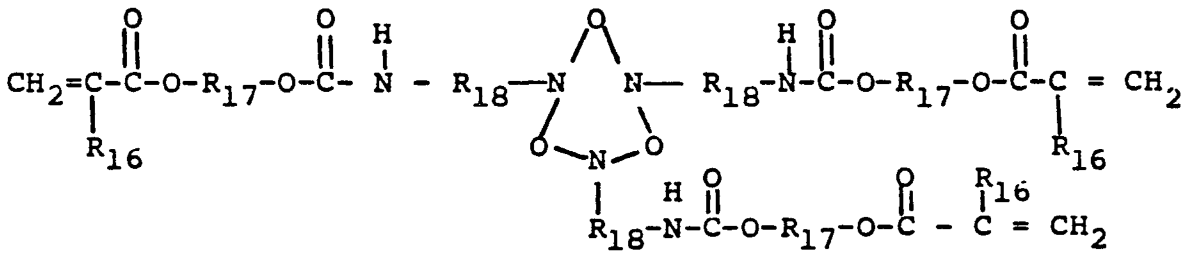

wherein $R_{16}$ is hydrogen or methyl, $R_{17}$ is a linear or branched alkylene or oxyalkylene radical having from 2 to about 5 carbon atoms, and $R_{18}$ is a divalent radical remaining after reaction of a substituted or unsubstituted diisocyanate. Such products are typically produced by the trimerization reaction of a diisocyanate followed by reaction of the remaining free isocyanate groups with a hydroxyalkyl ester of acrylic or methacrylic acid.

It is understood that during the formation of the isocyanurate, a diisocyanate may participate in the formation of two isocyanurate rings thereby forming cross-linked structures in which the isocyanurate rings may be linked by the diisocyanate used. Polyisocyanates might also be used to increase this type of cross-link formation.

Diisocyanates suitable for preparing the isocyanurate are well known in the art and include

aromatic, aliphatic, and cycloaliphatic diisocyanates. Such diisocyanates may be extended with small amounts of glycols to lower their melting point and provide a liquid diisocyanate.

The hyroxyalkyl esters suitable for final reaction with the free isocyanurate groups remaining after trimerization of the diisocyanate to an isocyanurate are exemplified by hydroxyethyl acrylate, hydroxypropyl acrylate, hydroxethyl methacrylate, and hydroxpropyl methacrylate. Any acrylate or methacrylate ester or amide containing an isocyanate reactive group may be used herein, however.

Such unsaturated isocyanurates are described in, for example, U.S. Patent 4,195,146.

(10) Poly(amide-esters) as characterized by the following empirical formula:

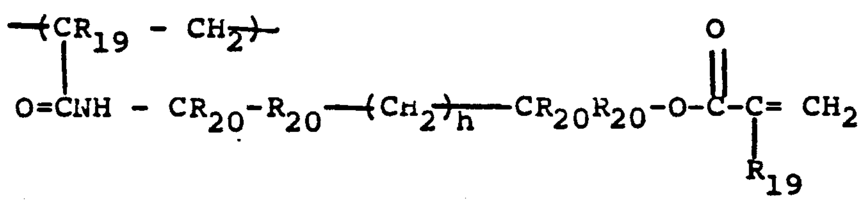

wherein $R_{19}$ is independently hydrogen or methyl, $R_{20}$ is independently hydrogen or lower alkyl, and h is 0 or 1. These compounds are typically the reaction product of a vinyl addition prepolymer having a plurality of pendant oxazoline or

5,6-dihydro-4H-1,3-oxazine groups with acrylic or methacrylic acid. Such poly(amide-esters) are described in, for example, British Patent 1,490,308.

(11) A poly(acrylamide) or poly(acrylate-acrylamide) characterized by the following empirical formula:

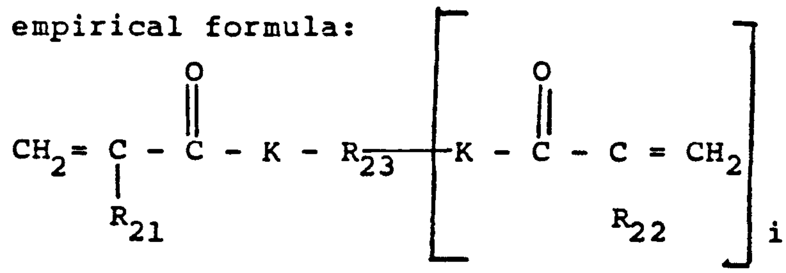

wherein $R_{23}$ is the polyvalent residue of an organic polyhydric amine or polyhydric aminoalcohol which contained primary or secondary amino groups bonded to different carbon atoms or, in the case of an aminoalcohol, amine and alcohol groups bonded to different carbon atoms; $R_{21}$ and $R_{22}$ are independently hydrogen or methyl; K is independently -O- or $-\overset{R_{24}}{\overset{|}{N}}-$; $R_{24}$ is hydrogen or lower alkyl; and i is 1 to 3.

The polyhydric amine suitable for preparing the poly(acrylamide) contains at least 2 carbon atoms and may contain 2 to 4, inclusive, terminal or pendant amine groups. The polyhydric amines include alkane polyamines and aromatic containing polyamides. Also included are amine terminated

polyamides and polyamines containing ether, amino, and ester groups in the organic residue.

The polyhydric amino-alcohols suitable for preparing the poly(acrylate-acrylamide) contain at least 2 carbon atoms and may contain 2 to 4, inclusive, amine or alcohol groups, with the proviso that at least one group is a primary or secondary amine. These include alkane aminoalcohols and aromatic containing aminoalcohols. Also included are polyhydric aminoalcohols containing ether, amino, amide, and ester groups in the organic residue.

Examples of the above compounds are described in, for example, Japanese publications J80030502, J80030503, and J80030504 and in U.S. Patent 3,470,079 and British Patent 905,186.

It is understood by those skilled in the art that the thermosettable organic materials described, supra, are only representative of those which may be used in the practice of this invention.

Any of these resins (1) to (11) may have admixed with it an ethylenically unsaturated monomer which forms a liquid homogeneous mixture with and is copolymerizable with these resins. The ethylenically unsaturated monomers contain at least a single -CH=C< group, and preferably a $CH_2$=C< group and include styrene and its derivatives and

homologues, divinylbenzene, diallylphthalate, nonfunctionalized esters of acrylic or methacrylic acid (such as ethyl acrylate, butyl acrylate, and methyl methacrylate) unsaturated nitriles (such as acrylonitrile and methacrylonitrile) and the like. Also, the monomers include vinyl esters, e.g., vinyl acetate, vinyl propionate, and the like. Also, included herein are low levels of maleic anhydride. Mixtures of the aforementioned monomers may be effectively employed in the practice of this invention.

Initiators are commonly used to initiate curing of such unsaturated resins and include diacyl peroxides, perketals, peresters, and azo compounds.

(12) An epoxide which contains at least one epoxy group having the following formula:

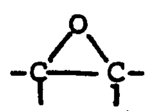

The epoxy groups can be terminal epoxy groups or internal epoxy groups. The epoxides are primarily cycloaliphatic epoxides. These cycloaliphatic epoxide resins may be blended with minor amounts of glycidyl type epoxides, aliphatic epoxides, epoxy cresol novolac resins, epoxy phenol novolac resins, polynuclear phenol-glycidyl ether-derived resins, aromatic and heterocyclic glycidyl amine resins, hydantoin epoxy resins, and the like, and mixtures

thereof. The cycloaliphatic epoxide resins may also be blended with minor amounts of cycloaliphatic epoxides having a viscosity of less than 200 centipoise such as:

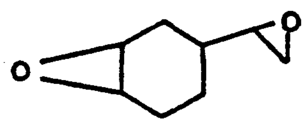

or

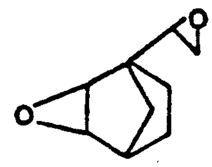

Further, such cycloaliphatic epoxides may be blended with the blends of cycloaliphatic epoxides and other epoxides described above. These epoxides are well known in the art and many are commercially available.

Suitable cycloaliphatic epoxide resins for purposes of this invention are those having an average of two or more vicinal epoxy groups per molecule. Illustrative of suitable cycloaliphatic epoxides are the following:

<u>FORMULA 1</u>

Diepoxides of cycloaliphatic esters of dicarboxylic acids having the formula:

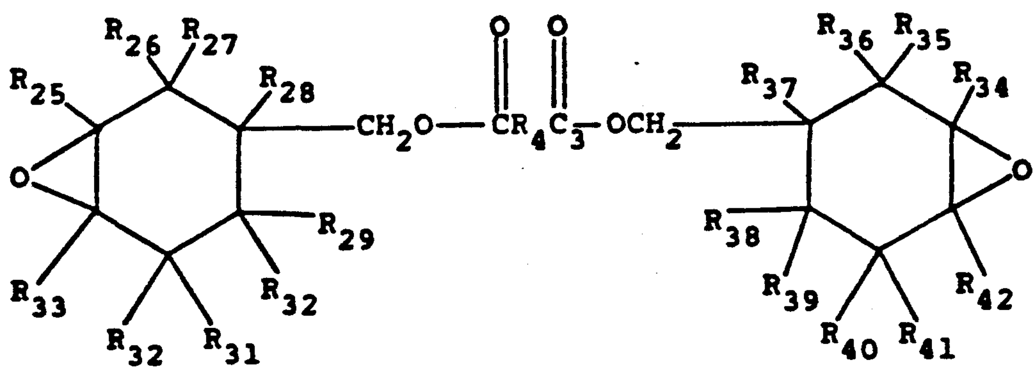

wherein $R_{25}$ through $R_{42}$, which can be the same or different, are hydrogen or alkyl radicals generally containing one to nine carbon atoms inclusive, and preferably containing one to three carbon atoms, inclusive, as for example methyl, ethyl, n-propyl, n-butyl, n-hexyl, 2-ethylhexyl, n-octyl, n-nonyl and the like; $R_{43}$ is a valence bond or a divalent hydro carbon radical generally containing one to twenty carbon atoms, inclusive, and preferably, containing four to six carbon atoms, inclusive, as for example, alkylene radicals, such as trimethylene, tetramethylene, pentamethylene, hexamethylene, 2-ethylhexamethylene, octamethylene, nonamethylene, and the like; cycloaliphatic radicals, such as 1,4-cyclohexane, 1,3-cyclohexane, 1,2-cyclohexane, and the like.

Particularly desirable epoxides, falling within the scope of Formula I, are those wherein $R_4$ through $R_{21}$ are hydrogen and R is alkylene containing four to six carbon atoms.

Among specific diepoxides of cycloaliphatic esters of dicarboxylic acids are the following:

bis(3,4-epoxycyclohexylmethyl)oxalate,

bis(3,4-epoxycyclohexylmethyl)adipate,

bis(3,4-epoxy-6-methylcyclohexylmethyl) adipate,

bis(3,4-epoxycyclohexylmethyl)pimelate, and the like.

Other suitable compounds are described in, for example, U.S. Patent No. 2,750,395.

FORMULA II

A 3,4-epoxycyclohexylmethyl-3,4-epoxycyclohexane carboxylate having the formula:

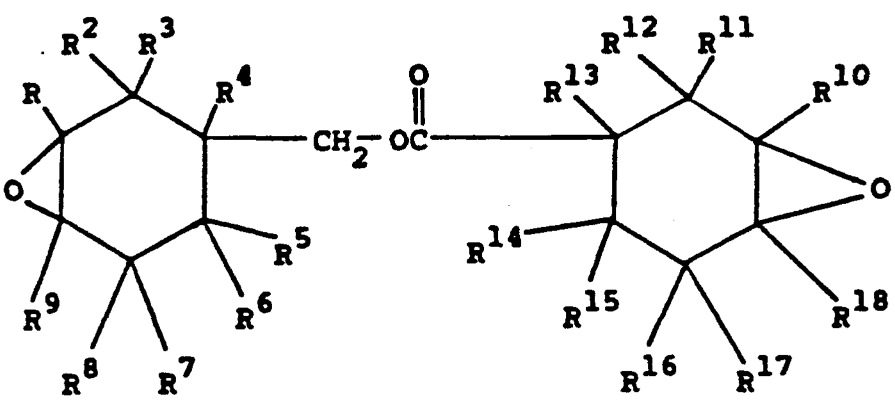

wherein $R^1$ through $R^{18}$ which can be the same or different are as defined for $R_{25}$ to $R_{42}$ in Formula I. Particularly desirable compounds are those wherein $R^1$ through $R^{18}$ are hydrogen.

Among specific compounds falling within the scope of Formula II are the following: 3,4-epoxycyclohexylmetnyl-3,4-epoxycyclohexane carboxylate; 3,4-epoxy-1-methylcyclohexylmethyl-3,4-epoxy-1-

1C367/734
SS*f



methylcyclohexane carboxylate; 6-methyl-3,4-epoxycyclohexylmethyl-6-methyl-3,4-epoxycyclohexane carboxylate; 3,4-epoxy-3-methylcyclohexylmethyl-3,4-epoxy-3-methylcyclohexane carboxylate; 3,4-epoxy-5-methylcyclohexylmethyl-3,4-epoxy-5-methylcyclohexane carboxylate. Other suitable compounds are described in, for example, U.S. Patent No. 2,890,194.

FORMULA III

Diepoxides having the formula:

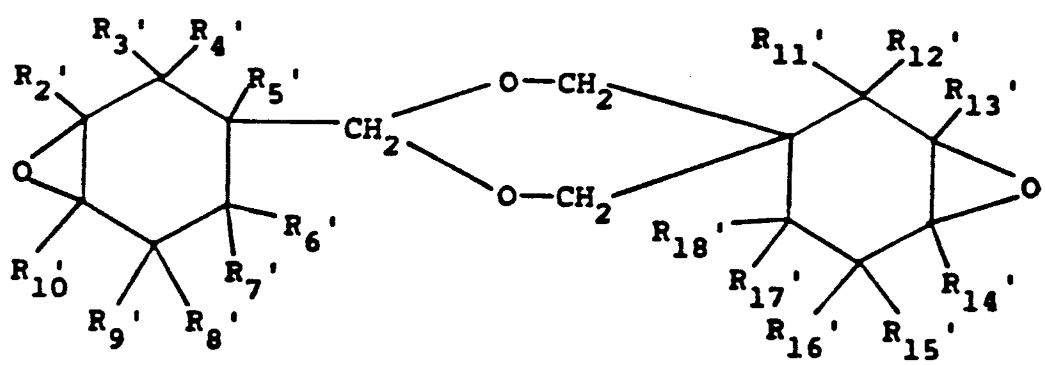

wherein the R's, which can be the same or different, are monovalent substituents such as hydrogen, halogen, i.e. chlorine, bromine, iodine or fluorine, or monovalent hydrocarbon radicals, or radicals as further defined in U.S. Patent No. 3,318,822. Particularly, desirable compounds are those wherein all the R's are hydrogen.

Other suitable cycloaliphatic epoxides are

the following:

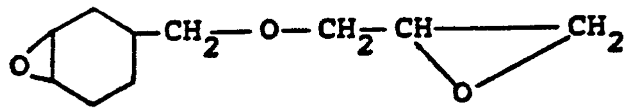

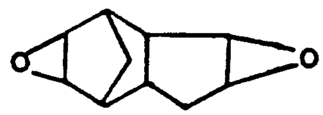

and the like.

The preferred cycloaliphatic epoxides are the following:

3,4-Epoxycyclohexylmethyl-3,4-Epoxycyclohexane carboxylate

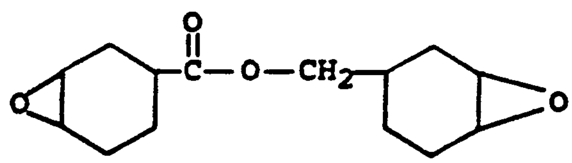

Bis(3,4-Epoxycyclohexylmethyl)adipate

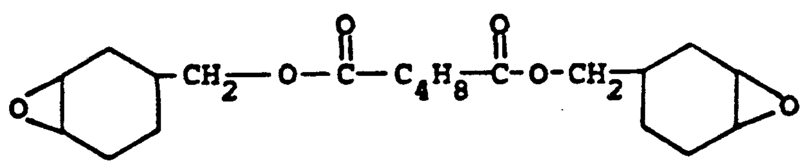

2-(3,4-Epoxycyclohexyl-5,5-spiro-3,4-epoxy)cyclohexane-meta-dioxane

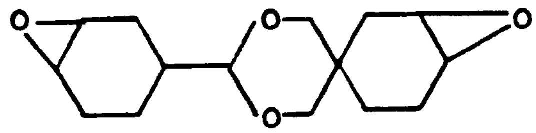

or mixtures thereof.

Epoxides with six membered ring structures may also be used, such as diglycidyl esters of phthalic acid, partially hydrogenated phthalic acid or fully hydrogenated phthalic acid. A representative diglycidyl ester of phthalic acid is the following:

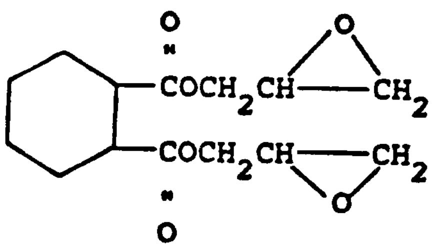

Diglycidyl esters of hexahydrophthalic acids being preferred.

The glycidyl-type epoxides are preferably diglycidyl ethers of bisphenol A which are derived from bisphenol A and epichlorohydrin and have the following formula:

1C367/734
SS*f



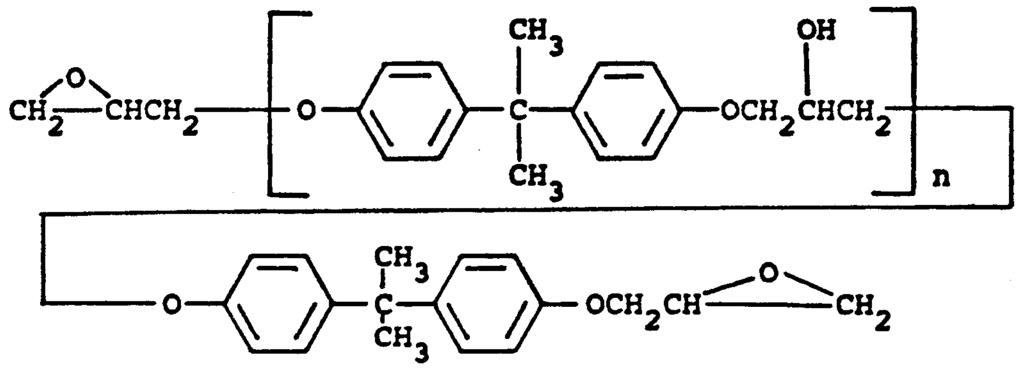

The cresol-novolac epoxy resins are multifunctional, solid polymers characterized by low ionic and hydrolyzable chlorine impurities, high chemical resistance, and thermal performance.

The epoxy phenol novolac resins are generally of the following formula:

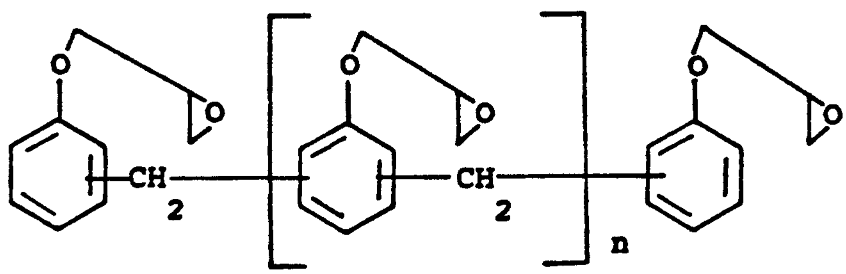

The polynuclear phenol-glycidyl ether-derived resins are generally of the formula:

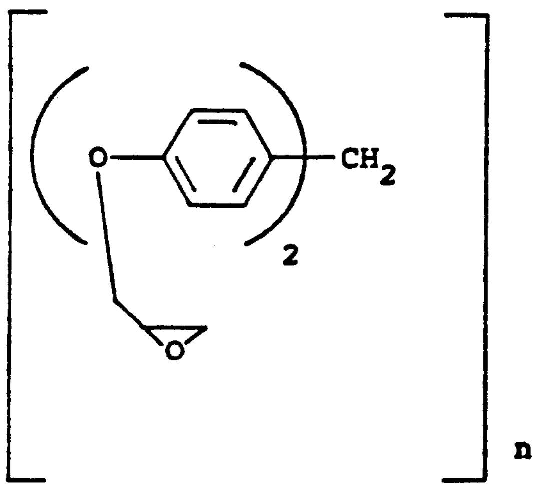

or

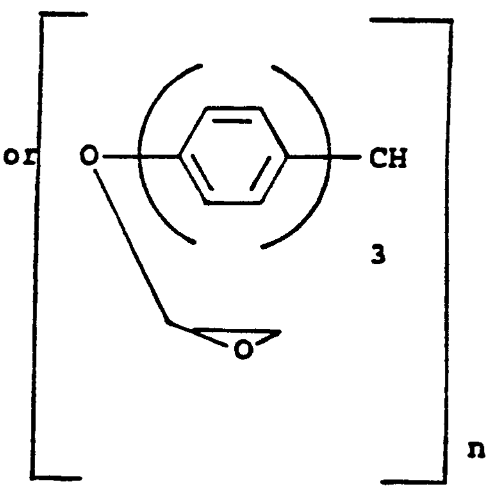

Among the aromatic and heterocyclic glycidyl amine resins which may be included herein are the following: tetraglycidylmethylenedianiline derived resins of the following formula:

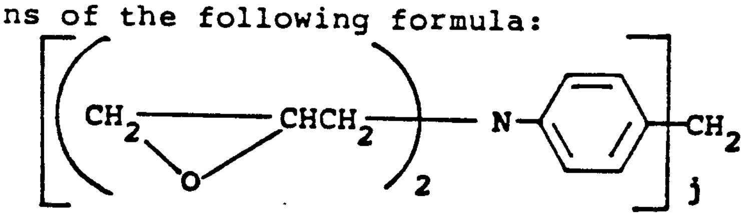

Triglycidyl-p-aminophenol derived resins, triazine based resins and hydantoin epoxy resins of the

1C367/734
SS*f



formula:

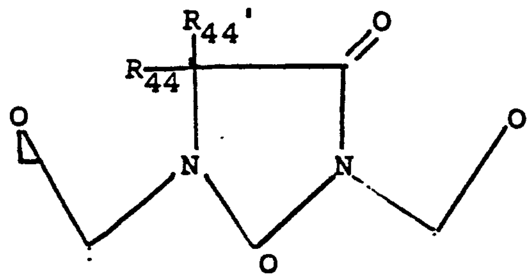

$R_{44}= CH_3$

Appropriate hardeners may be added to the epoxide compositions to effect cure.

Among suitable hardeners are the following:

1. phenolic hardeners having at least 2 phenolic hydroxyl groups and preferably having at least 3 phenolic hydroxyl groups per molecule.

2. polybasic acids having at least 2 carboxylic acid groups per molecule.

3. anhydrides of acids having at least 2 carboxylic acid groups per molecule.

Exemplary of suitable phenolic hardeners are the following polyhydric phenols: catechol, hydroquinone, hydroxyhydroquinone, chloroglucinol, resorcinol and pyrogallol; and di and polynuclear phenols such as the bisphenol is described in Bender et al., U.S. Pat. No. 2,506,486 and polyphenylols

such as novolac condensates of a phenol and a saturated or unsaturated aldehyde containing an average of from three to 20 or more phenylol groups per molecule (cf. book by T. S. Carswell entitled "Phenoplasts," published in 1947 by Interscience Publishers of New York).

Examples of suitable polyphenylols derived from a phenol and an unsaturated aldehyde such as acrolein are the triphenylols, pentaphenylols and heptaphenylols described in U.S. Pat. No. 2,885,385 to A. G. Farnnam, issued May 5, 1959.

The phenols may contain alkyl or aryl ring substituents or halogens, as exemplified by the alkyl resorcinols, the tribromo resorcinol and the diphenols containing alkyl and halogen substituents on the aromatic ring (Bender et al., U.S. Pat. No. 2,506,486).

The polyhydric phenols can consist of two or more phenols connected by such groups as methylene, alkylene, ether, ketone, or sulfone. The connecting groups are further exemplified by the following compounds: bis(p-hydroxyphenyl)ether, bis(p-hydroxyphenyl)ketone, bis(p-hydroxyphenyl)methane, bis(p-hydroxyphenyl)dimethyl methane, bis(p-hydroxyphenyl)sulfone and the like.

For purposes of stoichiometric calculations

with respect to phenolic hardeners, one phenolic hydroxyl group is deemed to react with one epoxy group.

Illustrative of suitable polybasic acids are the polycarboxylic acids of the formula:

$$HOOC-(CH_2)_1-COOH$$

wherein 1 is an integer generally having a value of from 1 to 20 inclusive, as for example, malonic, glutaric, adipic, pimelic, suberic, azelaic, sebacic and the like. Other examples of suitable acids are phthalic acid, isophthalic acid, terephthalic acid and the like. Further acids are enumerated in U.S. Pat. No. 2,918,444 to B. Phillips et al., issued Dec. 22, 1959.

Among other suitable polybasic acids, having at least two carboxylic groups per molecule, can be noted the following: tricarballylic acid, trimellitic acid and the like. Other such suitable polybasic acids, including polyesters thereof, are described in U.S. Pat. No. 2,921,925 to B. Phillips et al.

Suitable anhydrides are the anhydrides of the acids listed above.

Preferred hardeners include methyltetrahydrophthalic anhydride, hexahydrophthalic anhydride and

methylhexahydrophthalic anhydride.

The epoxides may also be cured by use of a photoinitiator. The photoinitiators which may be used herein include one or more of a metal fluoroborate and a complex of boron trifluoride, as described in U.S. Patent 3,379,653; a bis(perfluoroalkylsulfonyl)methane metal salt, as described in U.S. Patent 3,586,616; an aryldiazonium compound, as described in U.S. Patent 3,708,296; an aromatic onium salt of Group VIa elements, as described in U.S. Patent 4,058,400; an aromatic onium salt of Group Va elements, as described in U.S. Patent 4,069,055; a dicarbonyl cheleate of a Group IIIa-Va element, as described in U.S. Patent 4,086,091; a thiopyrylium salt, as described in U.S. Patent 4,139,655; a Group VIa element having an $MF_6^-$ anion where M is selected from P, As and Sb, as described in U.S. Patent 4,161,478; a triarylsulfonium complex salt, as described in U.S. Patent 4,231,951; and an aromatic iodonium complex salt and an aromatic sulfonium complex salt, as described in U.S. Patent 4,256,828. Preferred photoinitiators include triarylsulfonium complex salts, aromatic sulfonium or iodonium salts of halogen-containing complex ions, and aromatic onium salts of Group IIIa, Va and VIa elements. Some of such salts are commercially available, such as

FC-508 and FC-509 (available from Minnesota Mining and Manufacturing Company), and UVE-1014 (available from General Electric Company).

The photoinitiators are used in conventional amounts in the compositions of this invention such as in amounts from about 0.1 to 30 parts by weight per 100 parts by weight of the epoxides.

(13) Phenol formaldehyde resins having the typical formula:

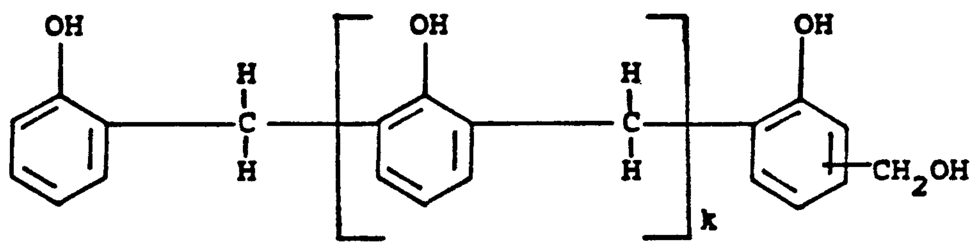

wherein k is a number greater than 1. Included are the resoles and novolacs.

(14) Polyurethanes derived from a polyol and an isocyanate. The polyols include hydrogen-containing components such as the hydroxyl-terminated polyhydrocarbons (U.S. Pat. No. 2,877,212); hydroxyl-terminated polyformals (U.S. Pat. No. 2,870,097); fatty acid triglycerides (U.S. Pat. Nos. 2,833,730 and 2,878,601); hydroxyl-terminated polyesters (U.S. Pat. Nos. 2,698,838, 2,921,915, 2,591,884, 2,866,762, 2,850,476, 2,602,783, 2,729,618, 2,779,689,

2,811,493, and 2,621,166); hydroxymethyl terminated perfluoromethylenes (U.S. Pat. Nos. 2,911,390 and 2,902,473); British Pat. No. 733,624); polyalkylenearyleneether glycols (U.S. Pat. No. 2,808,391); polyalkyleneether triols (U.S. Pat. No. 2,866,774).

Especially preferred polyhydroxyl-containing materials are the polyether polyols obtained by the chemical addition of alkylene oxides, such as ethylene oxide, propylene oxide and mixtures thereof, to water or polyhydric organic compounds, such as ethylene glycol, propylene glycol, trimethylene glycol, 1,2-butylene glycol, 1,3 butanediol, 1,4-butanediol, 1,5-pentanediol, 1,2-hexylene glycol, 1,10-decanediol, 1,2-cyclohexanediol, 2-butene-1,4-diol, 3-cyclohexene-1,1-dimethanol, 4-methyl-3-cyclo-hexene-1,1-dimethanol, 3-methylene-1,5-pentanediol, diethylene glycol, (2-hydroxyethoxy)-1-propanol,4-(2-hydroxyethoxy)-1-butanol, 5-(2-hydroxypropoxy)-1-pentanol, 1-[2-hydroxyethoxy]-2-hexanol, 1-(2-hydroxypropoxy)-2-octanol, 3-allyloxy-1,5-pentanediol, 2-allyloxymethyl-2-methyl-1,3-propanediol, 3-(o-propenylphenoxy)-1,2-propanediol, 4,4'-isopropylidenebis(p-phenyleneoxy)diethanol,

glycerol, 1,2,6-hexane-triol, 1,1,1-trimethylolethane, 1,1,1-trimethylolpropane, 3-(2-hydroxypropoxy)-1,2-propanediol, 2,4-dimethyl-2-(2-hydroxyethoxy)-methylpentanediol-1-, 5; 1,1,1-tris[2-hydroxyethoxy)methyl]-ethane, 1,1,1-tris-[(2-hydroxyethoxyl)methyl]ethane, 1,1,1-tris[2-hydroxypropoxy)-methyl]propane, dipropylene glycol, pentaerythritol, sorbitol, sucrose, lactose, alpha-methyl-glucoside, alphahydroxyalkylglucoside, novolac, resins, phosphoric acid, benzenephosphoric acid, polyphosphoric acids such as tripolyphosphoric acid and tetrapolyphosphoric acid, ternary condensation-products, caprolactone and the like. The alkylene oxides employed in producing polyoxyalkylene polyols normally have from 2 to 4 carbon atoms. Propylene oxide and mixtures of propylene oxide with ethylene oxide are preferred. The polyols listed above can be used per se as the active hydrogen compound.

Additional active hydrogen-containing materials are the polymers of cyclic esters having a reduced viscosity value of at least 0.15, and desirably from about 0.2 to about 15, and higher. The preferred polymers of cyclic esters have a reduced viscosity value of from about 0.3 to about 10. These polymers are homopolymers or copolymers

characterized as containing units of the formula:

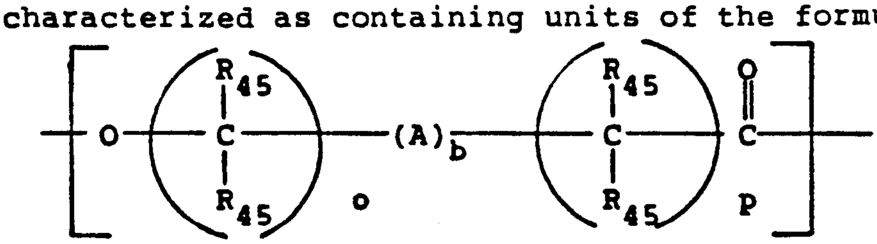 (I)

wherein each $R_{45}$, individually, is hydrogen, alkyl, halo, or alkoxy wherein A is an oxy group where x is an integer from 1 to 4; wherein c is an integer from 1 to 4; wherein b is an integer of zero or one; the sum of o + p + b is at least 4 and not greater than 6. It is preferred that the total number of carbon atoms in the $R_{45}$ substituents does not exceed eight.

In one embodiment, preferred polymers of cyclic esters contain both recurring structural Unit 1 and units of the formula:

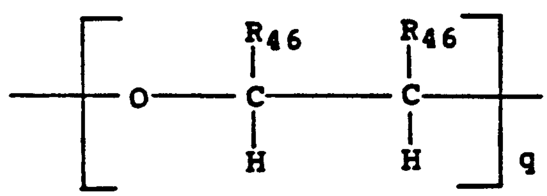 (II)

wherein each $R_{46}$, individually, is hydrogen, alkyl, cycloalkyl, aryl, or chloroalkyl, or in which the two R' variables together with the ethylene moiety of the oxyethylene chain of Unit II form a saturated cycloaliphatic hydrocarbon ring having from 4 to 8 carbon atoms, desirably from 5 to 6

carbon atoms and q is an integer of 1 or more, preferably 1 to 10. It is preferred that recurring Unit II contain from 2 to 12 carbon atoms.

The aforedescribed recurring Unit (I) is interconnected through the oxy group ( O ) of one unit with the carbonyl group

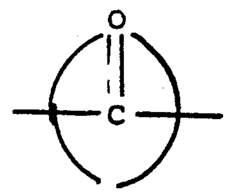

of a second unit, i.e., the interconnection does not involve the direct bonding of two carbonyl groups.

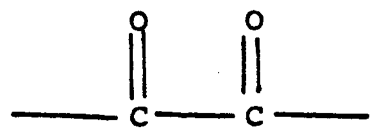

On the other hand, the relatively low molecular weight cyclic ester polymers, e.g., those having reduced viscosity values below about 0.3 are characterized by end groups which can be hydroxyl or carboxyl.

The preparation of the cyclic ester polymers is well documented in the patent literature as exemplified by U.S. Pat. Nos. 3,021,309 through 3,021,317; 3,169,945; and 2,962,524.

Polymers of cyclic esters can also be manufactured via the process described in U.S. Pat.

No. 2,962,524.

Another type of active hydrogen-containing materials useful in this invention are the polymer/polyol compositions obtained by polymerizing ethylenically unsaturated monomers in a polyol as described in British Pat. No. 1,063,222 and U.S. Pat. No. 3,383,351, the disclosures of which are incorporated herein by reference. Suitable monomers for producing such compositions include acrylonitrile, vinyl chloride, styrene, butadiene, vinylidene chloride and other ethylenically unsaturated monomers as identified and described in the above-mentioned British patent and U.S. patent. Suitable polyols include those listed and described hereinabove and in the British patent and U.S. patent. The polymer/polyol compositions can contain from about 1 to about 70 weight percent, preferably about 5 to about 50 weight percent, and most preferably about 10 to about 40 weight percent monomer polymerized in the polyol.

Mixtures of the above active hydrogen-containing compounds can be employed as reactants with polyisocyanate to form polyurethanes.

The isocyanates include any suitable polymeric isocyanate composition. This includes mixtures comprising one or more such isocyanates. Illustrative polymeric isocyanates are described in

U.S. Pat. No. 2,683,730, issued July 31, 1954 to Seeger et al., the entire disclosure of which is incorporated by reference herein.

Typical polymeric isocyanates are those of the formula as follows:

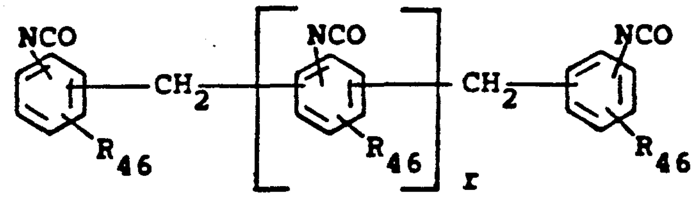 (III)

in which $R_{46}$ is hydrogen and/or lower alkyl, e.g., methyl, ethyl, propyl and butyl. The preferred polymeric isocyanates as defined by formula III are those in which r is a number ranging in value from 2.1 to 4.0 and $R_{46}$ is hydrogen and/or methyl.

Particularly preferred polymeric isocyanates are the polymethylene polyphenylisocyanates (i.e., those represented by formula III wherein $R_{46}$ is hydrogen) which are available commercially under the trademark "PAPI." These are usually supplied in the form of a mixture of polyisocyanates having an average NCO functionality of 2.2-3.5 and more commonly about 2.3-3.0. It is to be understood that the terms "polymeric isocyanate" and "polymethylene polyphenylisocyanate", as used herein are intended to include mixtures containing one or more such polyisocyanates. Further details concerning the

polymeric isocyanates and their preparation are provided in the above-noted Seeger et al. patent. Also, suitable for use herein are 2,4- and 2,6-toluene diisocyanate and mixtures thereof. Liquid methylene bis(phenyl isocyanate) as described in U.S. Patent 3,384,653; 4,4'-methylene bis(phenyl isocyanate); 2,4'-methylene bis(phenyl isocyanate); mixtures of 4,4'- and 2,4'- methylene bis(phenyl isocyanate); crude 4,4'- methylene bis(phenyl isocyanate); isomeric xylene diisocyanates and mixtures thereof; isomeric phenylene diisocyanate and mixtures thereof; isomeric naphthalene diisocyanates and mixtures thereof; substituted methylene bis(phenyl isocyanates), wherein the substituents include for example 3-alkoxy, 3,3-dimethyl and 3,3'-dimethoxy; substituted 2,6-toluene diisocyanates, wherein the substituents include, for example, p-methoxy, p-i-propyl, p-CN, p-methyl, p-CO-alkyl, p-N(alkyl)$_2$; halogenated isocyanates such as, monochloro 2,4-toluene diisocyanate, monochloro 2,6-toluene diisocyanate; terphenyl isocyanates such as: 4,4'4"-triisocyanato meta-terphenyl; 4,4'-diisocyanato diphenyl oxide, 4,4'-diisocyanato diphenyl sulfide, 4,4'-diisocyanato diphenyl disulfide, 4,4'diisocyanato diphenyl ethylene-1,2, 4,4'-diisocyanato naphthalene disulfide, and

4-isocyanato phenyl sulfonyl isocyanate; aliphatic isocyanates such as: 3-isocyanato methyl-3,5,5 trimethyl cyclohexyl isocyanate; 1,6-hexamethylene diisocyanate; 1,4-tetramethylene diisocyanate; 1,4 butylene (-2-) isocyanate; diisocyanato cyclohexane; triisocyanato cyclohexane, norbornane diisocyanates as described in U.S. Patents 3,493,330 and 3,470,248; bis(2-isocyanato ethyl) fumarates as described in U.S. Patent 3,579,482; polyoxyalkylene diisocyanates as described in U.S. Patent 3,370,077; dimeric fatty acid diisocyanates as described in U.S. Patent 3,455,883; 1,2-bis(p-(2-isocyanato ethyl)phenyl)-1-isocyanatomethyl ethane as described in U.S. Patent 3,539,611; 1,4-bis(isocyanato)-1-phenyl tetrahydronaphthalene as described in U.S. Patent 3,455,981; hydrogenated aryl isocyanates, such as 2,4-(p-isocyanato cyclohexylmethylene)-1-isocyanato cyclohexane; 4,4'-diisocyanato dicyclohexyl methane; 2,3-bis(difluoroamino)-1,4-diisocyanatobutane; 4,4'-bis(2-isocyanato hexafluoropropyl) diphenyloxide; acylated urea polyisocyanates as described in U.S. Patent 3,383,400; biuret polyisocyanates as described in U.S. Patent 3,350,438; silicon containing polyisocyanates as described in U.S. Patent 3,519,579.

Also, prepolymers derived from: the

diisocyanates and the glycols, supra, at mole ratios greater than about 3:1; the diisocyanates and polyols, supra, at NCO:OH mole ratios of about 7:1; the polymeric isocyanates and polydiols, supra, at NCO:OH ratio of about 7:1 or greater may be utilized. A wide variety of urethane forming catalysts can be used.

These catalysts include dialkyl tin carboxylates, such as dibutyl tin dilaurate, dioleate, diacetate, or di-2-ethylhexoate, and the like; dimethyl tin dithiolaurate, stannous octoate, stannous oleate, potassium octoate, potassium acetate, phenyl mercuric propionate, iron (III)-acetyl acetonate, copper (II) acetyl acetonate, zinc octoate, zinc acetate, cobalt (II) acetate, manganese (II) acetate, isopropyl titanate, triacryl isopropyl titanate, lead naphthanate, cobalt naphthanate, bismuth nitrate, ferric (III) chloride, sodium silicate, aluminum acetyl acetonate, zinc acetyl acetonate, nickel (II) acetyl acetonate, methyl titanate and zinc stearate.

Also, tertiary amines may be used as the catalyst. These tertiary amines can be illustrated

by the following formula:

(V) 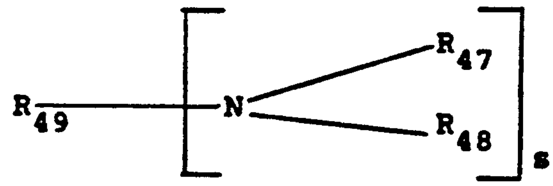

wherein $R_{47}$, $R_{48}$ are independently selected from the group consisting of aryl, alkylaryl, arylalkyl, alkyl, cycloalkyl, alkenyl radicals wherein the aryl, alkylaryl and arylalkyl radicals contain from about 6 to about 20 carbon atoms, the alkyl radicals contain from 6 to 18 carbon atoms, the alkenyl radicals contain from about 3 to 18 carbon atoms, and saturated 5 and 6 membered heterocyclic radicals containing from one to three nitrogen atoms, s is an integer of from 1 to 5.

(VI) 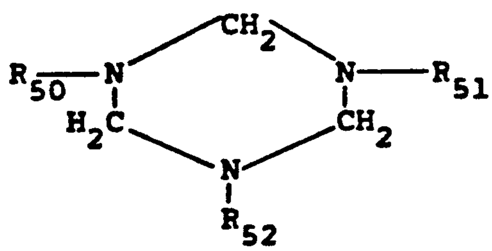

Wherein $R_{50}$, $R_{51}$ and $R_{52}$ are independently selected from 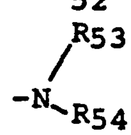 or monofunctional

optionally substituted hydrocarbon radicals, with the proviso that at least one of $R_{50}$, $R_{51}$ or $R_{52}$ is a 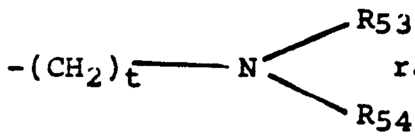 radical wherein $R_{50}$ and $R_{51}$ are selected from $C_1$ to $C_6$ alkyl, $C_2$ to $C_6$ hydroxyalkyl and t is 0 to 10. As examples of optionally substituted hydrocarbon radicals there may be mentioned morpholinoalkyl; piperidinoalkyl, alkylaminoalkyl; hydroxyalkyl; alkoxyalkyl and alkylcarbonyloxyalkyl. These triazine containing compounds are known in the art as shown for example in U.S Patent 3,884,917.

The amines suitable for use herein include triethylene diamine, N,N-dimethylcyclohexylamine, triethylamine, N-ethylmorpholine, N-methyl-2,2-dialkyl-1,3-oxazolidines, N-alkylpiperadines, N,N'-dialkypiperazines, tetramethyl-1,3-butane diamine, dimethylethanol amine, bis-dimethylamino diethyl ether, imidazole, N,N',N"-tris(3-dimethylaminopropyl)-S-hexahydrotriazine.

Also, mixtures of the above catalysts can be used. Blocked isocyanates may also be used. A blocked isocyanate comprises the reaction product of a polyisocyanate with a monofunctional hydroxyl compound. The resultant product is unreactive

towards hydroxyl compounds at room temperature but, at elevated temperatures, will function as an isocyanate. For example, an adduct of tolylene diisocyanate and trimethylolpropane is first prepared in solution, followed by the addition of phenol to block the remaining isocyanate groups.

A particularly preferred class of thermosetting resins for combining with the electrically conductive metal particles are the epoxy resins such as those based upon glycidyl ethers of Bisphenol A, or the glycidyl ethers of phenol-formaldehyde resins (such as the epoxidized novolacs discussed above) or the cycloaliphatic epoxides, and mixtures of them. Each is described above. They may be crosslinked by the incorporation of active hydrogen compounds as defined above, with or without acid or base additives. Sometimes the crosslinking density of such polymers is too great for coating integrity and/or they do not effect sufficient wetting of the metal particles in making the coating (ink) mixture. It has been determined that the performance of such resins are enhanced by incorporating in the formulation of the thermosetting resin some thermoplastic resins which possess the capacity of reacting with the epoxy resin during the various stages employed for the crosslinking reaction.

For example, thermoplastic resins such as: polyvinyl acetate containing some hydrolyzed acetate, thus providing some vinyl alcohol moieties; polyvinyl formal or butyral which provide vinyl alcohol or vinyl oxy moieties; or polyvinyl acetate wherein a small portion of the hydrolyzed groups are reacted with aromatic monoisocyanates to provide a blocked isocyanate structure which releases isocyanates and active hydrogen at cure conditions; may be added to the epoxy resin formulation along with the electrically conductive metal particles, solvents, and the like. The thermoplastic resins can supply part or all of the active hydrogen needed for crosslinking the epoxy resin and become part of the crosslinked thermoset structure.

THE DIELECTRIC SURFACE

The dielectric surface may be made of any of the known dielectric surfaces. It is preferred in the practice of this invention to employ as the dielectric surface an organic resin material. Suitable organic resins are thermosetting resins, such as those described above, used alone or reinforced by fillers and/or fibers. The usual reinforcing fillers and/or fibers are preferred. Such are described below in the ADDITIVES section. Without such reinforcement, such resins tend to

shrink on curing, thus formulations and molding conditions which at least minimize such shrinking is desired. The other dielectric materials include thermoplastic resins. They are described below.

Thermoplastic Polymers For the Dielectric Surface

The thermoplastic resin may be selected from one or more of a polyarylethersulfone, a poly(aryl ether), polyarylate, polyetherimide, polyester, aromatic polycarbonate, styrene resin, poly(aryl acrylate), polyhydroxylether, poly(arylene sulfide) or polyamide.

A. Polyarylethersulfones

The polyarylethersulfones of the invention are amorphous thermoplastic polymers containing units of the formula:

(I) 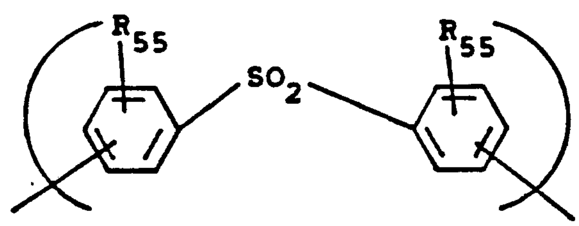 . and

(II) 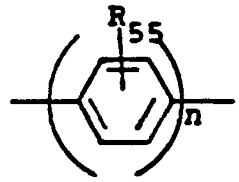

1C367/734
SS*f



and/or

(III) 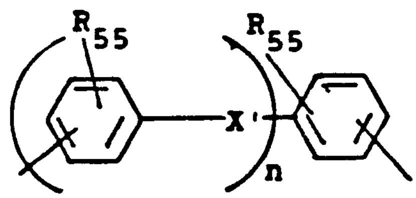

wherein $R_{55}$ is independently hydrogen, $C_1$ to $C_6$ alkyl or $C_4$ to $C_8$ cycloalkyl, X' is independently

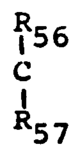

wherein $R_{56}$ and $R_{57}$ are independently hydrogen or $C_1$ to $C_9$ alkyl, or

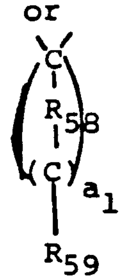

wherein $R_{58}$ and $R_{59}$ are independently hydrogen or $C_1$ to $C_8$ alkyl, and $a_1$ is an integer of 3 to 8; -S-, -O-, or 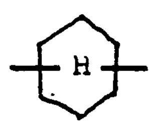 , a is an integer of 0 to 4 and n is independently an integer of 1 to 3 and

wherein the ratio of unit (I) to the sum of units (II) and/or (III) is greater than 1. The units are attached to each other by an -O- bond.

A preferred polymer of this invention contains units of the formula:

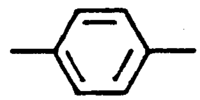

and

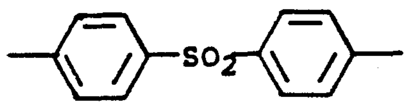

Another preferred polyarylethersulfone of this invention contains units of the formula:

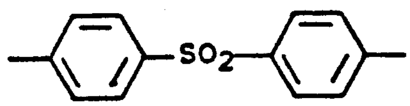

, and

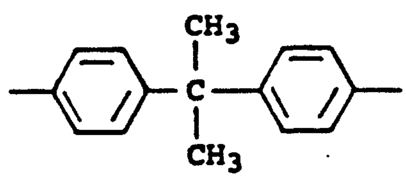

These units are attached to each other by an -O- bond.

The polyarylethersulfone may be random or may have an ordered structure.

The polyarylethersulfones of this invention have a reduced viscosity of from about 0.4 to greater than about 2.5, as measured in

N-methylpyrolidone, or other suitable solvent, at 25°C.

The polyarylethersulfones of this invention are prepared by reacting the monomers represented by the following formulae:

(IV)

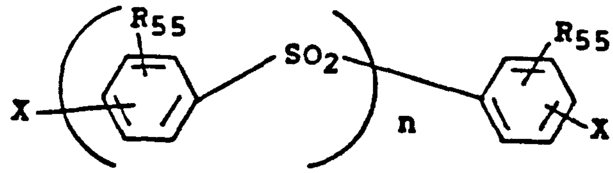

(V)

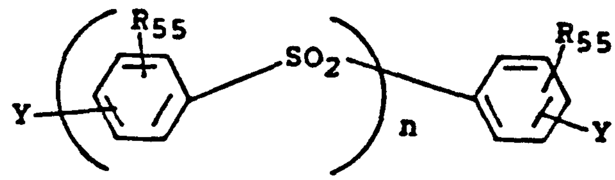

(VI)

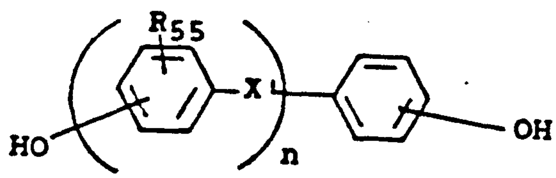

(VII) and/or

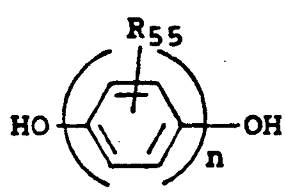

wherein $R_{55}$, a, X' and n are as previously

defined, and X and Y are independently selected from Cl, Br, F, $NO_2$ or OH and at least 50 percent of the Y's are OH.

The ratio of the concentration of OH groups to Cl, Br, F and/or $NO_2$ groups used to form the polyarylethersulfone is from about 0.90 to about 1.10, preferably from about 0.98 to about 1.02.

The monomers, represented by formulas (IV), (V), (VI) and (VII), include the following:

2,2-bis(4-hydroxyphenyl)propane,
bis(4-hydroxyphenyl)methane,
4,4'-dihydroxydiphenyl sulfide,
4,4'-dihydroxydiphenyl ether,
4,4'-dihydroxydiphenyl sulfone,
2,4'-dihydroxydiphenyl sulfone,
4,4'-dichlorodiphenyl sulfone,
4,4'-dinitrodiphenyl sulfone,
4-chloro-4'-hydroxydiphenyl sulfone,

4,4'-biphenol, hydroquinone, and the like.

The preferred monomers include hydroquinone, 4,4-biphenol, 2,2-bis(4-hydroxyphenyl) propane, 4,4'-dichlorodiphenyl sulfone, and 4,4'-dihydroxydiphenyl sulfone or 4 chloro -4'-hydroxydiphenyl sulfone.

The polymers of this invention are prepared by contacting substantially equimolar amounts of the hydroxy containing compounds (depicted in formulas

(IV) to (VII) supra) and halo and/or nitro containing compounds (depicted in formula (IV) and (V) supra) with from about 0.5 to about 1.0 mole of an alkali metal carbonate per mole of hydroxyl group in a solvent mixture comprising a solvent which forms an azeotrope with water in order to maintain the reaction medium at substantially anhydrous conditions during the polymerization.

The temperature of the reaction mixture is kept at from about 120 to about 180°C, for about 1 to about 5 hours and then raised and kept at from about 200 to about 250°C, preferably from about 210 to about 230°C, for about 1 to 10 hours.

The reaction is carried out in an inert atmosphere, e.g., nitrogen, at atmospheric pressure, although higher or lower pressures may also be used.

The polyarylethersulfone is then recovered by conventional techniques such as coagulation, solvent evaporation, and the like.

The solvent mixture comprises a solvent which forms an azeotrope with water and a polar aprotic solvent. The solvent which forms an azeotrope with water includes an aromatic hydrocarbon such as benzene, toluene, xylene, ethylbenzene, chlorobenzene, and the like.

The polar aprotic solvents employed in this invention are those generally known in the art for

the manufacture of polyarylether sulfones and include sulfur containing solvents such as those of the formula:

$$R_{60} - S(O)_{b'} - R_{60}$$

in which each $R_{60}$ represents a monovalent lower hydrocarbon group free of aliphatic unsaturation, which preferably contains less than about 8 carbon atoms or when connected together represents a divalent alkylene group with b being an integer from 1 to 2 inclusive. Thus, in all of these solvents all oxygens and two carbon atoms are bonded to the sulfur atom. Contemplated for use in this invention are such solvents as those having the formula:

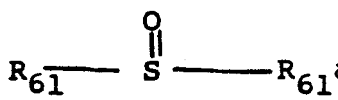 and 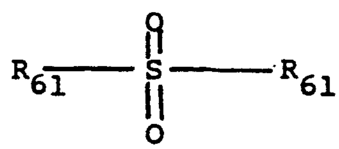

where the $R_{61}$ groups are independently lower alkyl, such as methyl, ethyl, propyl, butyl, and like groups, and aryl groups such as phenyl and alkylphenyl groups such as the tolyl group, as well as those where the $R_{61}$ groups are interconnected as in a divalent alkylene bridge such as:

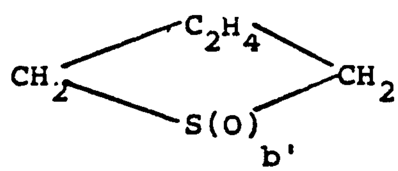

in tetrahydrothiophene oxides and dioxides. Specifically, these solvents include dimethylsulfoxide, dimethylsulfone, diphenylsulfone, diethylsulfoxide, diethylsulfone, diisopropylsulfone, tetrahydrothiophene 1,1-dioxide (commonly called tetramethylene sulfone or sulfolane) and tetrahydrothiophene-1 monoxide.

Additionally, nitrogen containing solvents may be used. These include dimethyl acetamide, dimethyl formamide and N-methylpyrolidone.

The azeotrope forming solvent and polar aprotic solvent are used in a weight ratio of from about 10:1 to about 1:1, preferably from about 7:1 to about 5:1.

In the reaction, the hydroxy containing compound is slowly converted, in situ, to the alkali salt thereof by reacting with the alkali metal carbonate. The alkali metal carbonate is preferably potassium carbonate. Mixtures of carbonates such as potassium and sodium carbonate may also be used.

Water is continuously removed from the reaction mass as an azeotrope with the azeotrope forming solvent so that substantially anhydrous conditions are maintained during the polymerization.

It is essential that the reaction medium be maintained substantially anhydrous during the polycondensation. While amounts of water up to

about one percent can be tolerated, and are somewhat beneficial when employed with fluorinated dihalobenzenoid compounds, amounts of water substantially greater than this are desirably avoided as the reaction of water with the halo and/or nitro compound leads to formation of phenolic species and only low molecular weight products are secured. Consequently, in order to secure the high polymers, the system should be substantially anhydrous, and preferably contain less than 0.5 percent by weight water during the reaction.

Preferably, after the desired molecular weight has been attained, the polymer is treated with an activated aromatic halide or an aliphatic halide such as methyl chloride or benzyl chloride, and the like. Such treatment of the polymer converts the terminal hydroxyl groups into ether groups which stabilize the polymer. The polymer so treated has good melt and oxidative stability.

B. Polyarylether resin

The poly(aryl ether) resin suitable for blending with the polyarylethersulfone, is different from the polyarylethersulfone and is a linear, thermoplastic polyarylene polyether containing

recurring units of the following formula:

-O-E-O-E'-

wherein E is the residuum of a dihydric phenol, and E' is the residuum of a benzenoid compound having an inert electron withdrawing group in at least one of the positions ortho and para to the valence bonds; both of said residua are valently bonded to the ether oxygens through aromatic carbon atoms. Such aromatic polyethers are included within the class of polyarylene polyester resins described in, for example, U.S. Patents 3,264,536 and 4,175,175. It is preferred that the dihydric phenol be a weakly acidic dinuclear phenol such as, for example, the dihydroxyl diphenyl alkanes or the nuclear halogenated derivatives thereof, such as, for example, the 2,2-bis(4-hydroxyphenyl)propane, 1,1-bis(4-hydroxphenyl)2-phenyl ethane, bis(4-hydroxyphenyl)methane, or their chlorinated derivatives containing one or two chlorines on each aromatic ring. Other materials also termed appropriately bisphenols are also highly valuable and preferred. These materials are the bisphenols of a symmetrical or unsymmetrical joining group, as,

O
‖

for example, ether oxygen (-O-), carbonyl $(-\overset{O}{\overset{\|}{C}}-)$, sulfone $(-\overset{O}{\overset{\|}{\underset{\underset{O}{\|}}{S}}}-)$, or hydrocarbon residue in which the two phenolic nuclei are joined to the same or different carbon atoms of the residue.

Such dinuclear phenols can be characterized as having the structure:

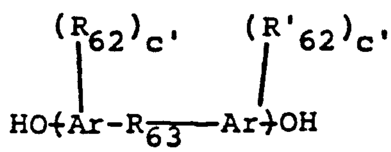

wherein Ar is an aromatic group and preferably is a phenylene group, the $R_{62}$ groups can be the same or different inert substituent groups such as alkyl groups having from 1 to 4 carbons atoms, aryl, halogen atoms, i.e., fluorine, chlorine, bromine or iodine, or alkoxyl radicals having from 1 to 4 carbon atoms, the c's are independently integers having a value of from 0 to 4, inclusive, and $R_{63}$ is representative of a bond between aromatic carbon atoms as in dihydroxyl-diphenyl, or is a divalent radical,

including for example, radicals such as $-\overset{O}{\overset{\|}{C}}-$, -O-, -S-, -SO-, -S-S-, $-SO_2$, and divalent hydrocarbon radicals such as alkylene, alkylidene, cycloalkylene, cycloalkylidene, or the halogen, alkyl, aryl or like substituted alkylene, alkylidene and cycloaliphatic radicals as well as aromatic radicals and rings fused to both Ar groups.

Examples of specific dihydric polynuclear phenols including among others: the bis-(hydroxyphenyl) alkanes such as
2,2-bis-(4-hydroxyphenyl)propane,
2,4'-dihydroxydiphenylmethane,
bis-(2-hydroxyphenyl)methane,
bis-(4-hydroxyphenyl)methane,
bis(4-hydroxy-2,6-dimethyl-3-methoxyphenyl)methane,
1,1-bis-(4-hydroxy-phenyl)ethane,
1,2-bis-(4-hydroxyphenyl)ethane,
1,1-bis-(4-hydroxy-2-chlorophenyl)ethane,
1,1-bis-(3-methyl-4-hydroxyphenyl)propane,
1,3-bis-(3-methyl-4-hydroxyphenyl)propane,
2,2-bis-(3-phenyl-4-hydroxyphenyl)propane,
2,2-bis-(3-isopropyl-4-hydroxyphenyl)propane,
2,2-bis-(2-isopropyl-4-hydroxyphenyl)propane,
2,2-bis-(4-hydroxy-naphthyl)propane,
2,2-bis-(4-hydroxyphenyl)pentane,
3,3-bis-(4-hydroxyphenyl)pentane,
2,2-bis-(4-hydroxyphenyl)heptane,

bis-(4-hydroxyphenyl)phenylmethane, 2,2-bis-(4-hydroxyphenyl)-1-phenyl-propane, 2,2-bis-(4-hydroxyphenyl)1,1,1,3,3,3,-hexafluoro-propane, and the like;

di(hydroxyphenyl)sulfones such as bis-(4-hydroxyphenyl)sulfone, 2,4'-dihydroxydiphenyl sulfone, 5-chloro-2,4'-dihydroxydiphenyl sulfone, 5'-chloro-4,4'-dihydroxydiphenyl sulfone, and the like;

di(hydroxyphenyl)ethers such as bis-(4-hydroxyphenyl)ether, the 4,3'-, 4,2'-2,2'-2,3-,dihydroxyphenyl ethers, 4,4'-dihydroxyl-2,6-dimethyldiphenyl ether,bis-(4-hydroxy-3-isobutylphenyl)ether, bis-(4-hydroxy-3-isopropylphenyl)ether, bis-(4-hydroxy-3-chlorophenyl)ether, bis-(4-hydroxy-3-fluorophenyl)ether, bis-(4-hydroxy-3-bromophenyl)ether, bis-(4-hydroxynaphthyl)ether, bis-(4-hydroxy-3-chloronaphthyl)ether, and 4,4'-dihydroxyl-3,6-dimethoxydiphenyl ether.

As herein used the E' term defined as being the "residuum of the dihydric phenol" of course refers to the residue of the dihydric phenol after the removal of the two aromatic hydroxyl groups. Thus as is readily seen these polyarylene polyethers contain recurring groups of the residuum of the

dihydric phenol and the residuum of the benzenoid compound bonded through aromatic ether oxygen atom.

Any dihalobenzenoid or dinitrobenzenoid compound or mixtures thereof can be employed in this invention which compound or compounds has the two halogens or nitro-groups bonded to benzene rings having an electron withdrawing group in at least one of the positions ortho and para to the halogen or nitro group. The dihalobenzenoid or dinitrobenzenoid compound can be either mononuclear where the halogens or nitro groups are attached to the same benzenoid rings or polynuclear where they are attached to different benzenoid rings, as long as there is an activating electron withdrawing group in the ortho or para position of that benzenoid nuclear. Fluorine and chlorine substituted benzenoid reactants are preferred; the fluorine compounds for fast reactivity and the chlorine compounds for their inexpensiveness. Fluorine substituted benzenoid compounds are most preferred, particularly when there is a trace of water present in the polymerization reaction system. However, this water content should be maintained below about 1% and preferably below 0.5% for best results.

An electron withdrawing group can be employed as the activator group in these compounds. It should be, of course, inert under the reaction

conditions, but otherwise its structure is not critical. Preferred are the strong activating

O
‖
groups such as the sulfone group (-S-) bonding two
‖
O

halogen or nitro substituted benzenoid nuclei as in the 4,4'-dichlorodiphenyl sulfone and 4,4'-difluorodiphenyl sulfone, although such other strong withdrawing groups hereinafter mentioned can also be used with equal ease.

The more powerful of the electron withdrawing groups give the fastest reactions and hence are preferred. It is further preferred that the ring contain no electron supplying groups on the same benzenoid nucleus as the halogen or nitro group; however, the presence of other groups on the nucleus or in the residuum of the compound can be tolerated.

The activating group can be basically either of two types:

(a) monovalent groups that activate one or more halogens or nitro-groups on the same ring such as another nitro or halo group, phenylsulfone, or alkylsulfone, cyano, trifluoromethyl, nitroso, and

hetero nitrogen, as in pyridine.

(b) divalent groups which can activate displacement of halogens on two different rings,

```
                              O
                              "
such as the sulfone group -S-; the carbonyl group
                              "
                              O

O                        H
"                        '
-C-; the vinylene group -C=C-; the sulfoxide group
                            '
                            H

O
"
-S-; the azo group -N=N-; the saturated fluorocarbon
        CF3
        '
groups -C-, -CF2 -CF2CF2-; organic phosphine
        '
        CF3

        O
        "
oxides -P-:
        "
        R64
```

where $R_{64}$ is a hydrocarbon group, and the ethylidene group A-C-A where A can be

```
                   "
                  -C-
```

hydrogen or halogen.

If desired, the polymers may be made with mixtures of two or more dihalobenzenoid or dinitrobenzenoid compounds. Thus, the E' residuum of the benzenoid compounds in the polymer structure may be the same or different.

It is seen also that as used herein, the E' term defined as being the "residuum of the benzenoid compound" refers to the aromatic or benzenoid residue of the compound after the removal of the halogen atom or nitro group on the benzenoid nucleus.

The polyarylene polyethers of this invention are prepared by methods well known in the art as for instance the substantially equimolar one-step reaction of a double alkali metal salt of dihydric phenol with a dihalobenzenoid compound in the presence of specific liquid organic sulfoxide or sulfone solvents under substantially anhydrous conditions. Catalysts are not necessary for this reaction.

The polymers may also be prepared in a two-step process in which a dihydric phenol is first converted in situ in the primary reaction solvent to the alkali metal salt of the reaction with the alkali metal, the alkali metal hydride, alkali metal hydroxide, alkali metal alkoxide or the alkali metal alkyl compounds. Preferably, the alkali metal hydroxide is employed. After removing the water

which is present or formed, in order to secure substantially anhydrous conditions, the dialkali metal salts of the dihydric phenol are admixed and reacted with about stoichiometric quantities of the dihalobenzenoid or dinitrobenzenoid compound.

Additionally, the polyethers may be prepared by the procedure described in, for example, U.S. Patent 4,176,222 in which a substantially equimolar mixture of at least one bisphenol and at least one dihalobenzenoid are heated at a temperature of from about 100° to about 400°C with a mixture of sodium carbonate or bicarbonate and a second alkali metal carbonate or bicarbonate having a higher atomic number than that of sodium.

Further, the polyethers may be prepared by the procedure described in Canadian Patent 847,963 wherein the bisphenol and dihalobenzenoid compound are heated in the presence of potassium carbonate using a high boiling solvent such as diphenylsulfone.

Preferred polyarylene polyethers of this invention are those prepared using the dihydric polynuclear phenols of the following four types, including the derivatives thereof which are

substituted with inert substituent groups

(a) 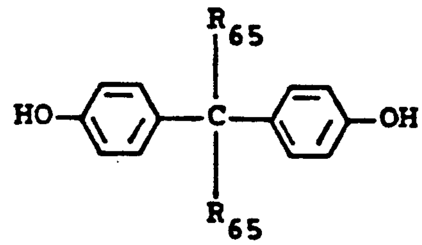

in which the $R_{65}$ groups represent independently hydrogen, lower alkyl, aryl and the halogen substituted groups thereof, which can be the same or different;

(b) 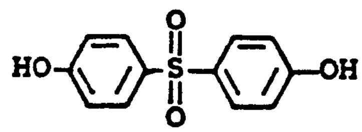

(c) 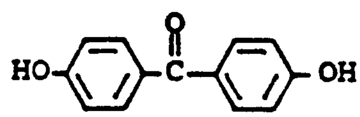

(d) 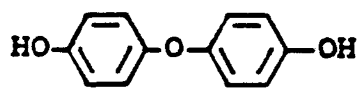

and substituted derivatives thereof.

It is also contemplated in this invention to use a mixture of two or more different dihydric phenols to accomplish the same ends as above. Thus when referred to above the -E- residuum in the

polymer structure can actually be the same or different aromatic residua.

The poly(aryl ether)s have a reduced viscosity of from about 0.35 to about 1.5 as measured in an appropriate solvent at an appropriate temperature depending on the particular polyether, such as in methylene chloride at 25°C.

The preferred poly(aryl ether)s have repeating units of the formula:

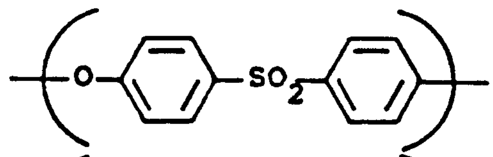 ,

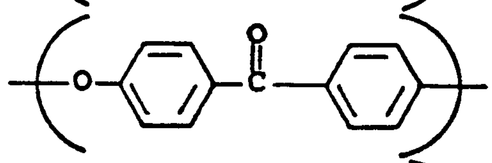 ,

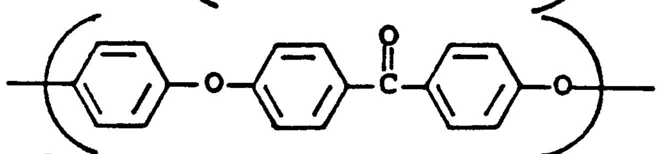 , and

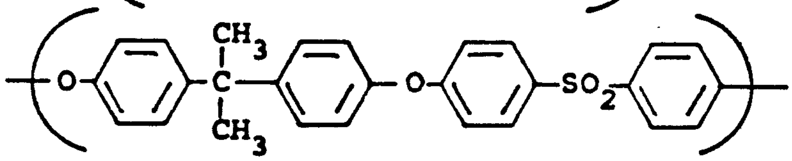

C. Polyarylates

The thermoplastic polymers which may be

blended with the polyarylethersulfone or blend of polyarylethersulfone and poly(aryl ether) include polyarylates, polyetherimides, polyesters, aromatic polycarbonates, styrene resins, poly(alkyl acrylates), polyhydroxyethers, poly(arylene sulfide) and polyamides.

A. Polyarylates

The polyarylates which are suitable for use in this invention are derived from a dihydric phenol and at least one aromatic dicarboxylic acid and have a reduced viscosity of from about 0.4 to greater than about 1.0, preferably from about 0.6 to about 0.8 dl/gm, as measured in chloroform (0.5 g/100ml chloroform) or other suitable solvent at 25°C.

A particularly desirable dihydric phenol is of the following formula:

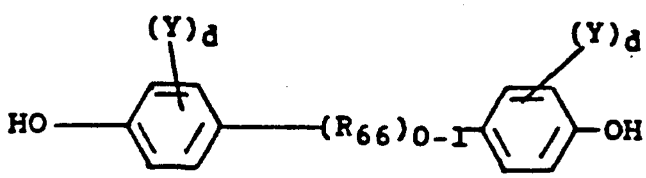

wherein Y is independently selected from, hydrogen, alkyl groups of 1 to 4 carbon atoms, chlorine or bromine, each d, independently, has a value of from 0 to 4, inclusive, and $R_{66}$ is a divalent saturated or unsaturated aliphatic hydrocarbon radical, particularly an alkylene or alkylidene radical

having from 1 to 6 carbon atoms, or a cycloalkylidene or cycloalkylene radicals having up to and including 9 carbon atoms, O, CO, $SO_2$, or S. The dihydric phenols may be used individually or in combination.

The dihydric phenols that may be used in this invention include the following:

2,2-bis-4(4-hydroxyphenyl)propane;
bis-(2-hydroxyphenyl)methane,
bis-(4-hydroxyphenyl)methane,
bis-(4-hydroxy-2,6-dimethyl-3-methoxyphenyl) methane,
1,1-bis-(4-hydroxyphenyl)ethane,
1,2-bis-(4-hydroxyphenyl)ethane,
1,1-bis-(4-hydroxy-2-chlorophenyl)ethane,
1,3-bis-(3-methyl-4-hydroxyphenyl)ethane,
1,3-bis-(3-methyl-4-hydroxyphenyl)propane,
2,2-bis-(3-phenyl-4-hydroxyphenyl)propane,
2,2-bis-(3-isopropyl-4-hydroxyphenyl) propane,
2,2-bis-(2-isopropyl-4-hydroxyphenyl) propane,
2,2-bis-(4-hydroxyphenyl)pentane,
3,3-bis-(4-hydroxyphenyl)pentane,
2,2-bis-(4-hydroxyphenyl)heptane,
1,2-bis-(4-hydroxyphenyl)1,2-bis-(phenyl)-propane,
4,4'-(dihydroxyphenyl)ether,
4,4'-(dihydroxyphenyl)sulfide,
4,4'-(dihydroxyphenyl)sulfone,
4,4'-(dihydroxyphenyl)sulfoxide,
4,4'-(dihydroxybenzophenone), and
naphthalene diols

The aromatic dicarboxylic acids that may be used in this invention include terephthalic acid, isophthalic acid, any of the naphthalene dicarboxylic acids and mixtures thereof, as well as alkyl substituted homologs of these carboxylic acids, wherein the alkyl group contains from 1 to

about 4 carbon atoms, and acids containing other inert substituents, such as halides, alkyl or aryl ethers, and the like. Acetoxybenzoic acid can also be used. Preferably, mixtures of isophthalic and terephthalic acids are used. The isophthalic acid to terephthalic acid ratio in the mixture is about 0:100 to about 100:0, while the most preferred acid ratio is about 75:25 to about 50:50. Also, from about 0.5 to about 20 percent of aliphatic diacids containing from 2 to about 10 carbon atoms, such as adipic acid, sebacic acid, and the like may be additionally used in the polymerization reaction.

The polyarylates of the present invention can be prepared by any of the well known prior art polyester forming reactions, such as the reaction of the acid chlorides of the aromatic dicarboxylic acids with the dihydric phenols; the reaction of the diaryl esters of the aromatic dicarboxylic acids with the dihydric phenols; or the reaction of the aromatic diacids with diester derivatives of the dihydric phenol. These processes are described in, for example, U.S. Patents 3,317,464; 3,948,856; 3,780,148; 3,824,213; and 3,133,898.

The polyarylates are preferably prepared by the process as set forth in U.S. Patent 4,321,355. This process comprises the following steps:

(a) reacting an acid anhydride derived from an acid containing from 2 to 8 carbon atoms with at least one dihydric phenol to form the corresponding diester; and

(b) reacting said diester with at least one aromatic dicarboxylic acid at a temperature sufficient to form the polyarylate, wherein the improvement comprises removing residual acid anhydride after formation of the dihydric phenol diester so that its concentration is less than about 1500 parts per million.

The acid anhydride suitable is derived from an acid containing from 2 to 8 carbon atoms. The preferred acid anhydride is acetic anhydride.

The dihydric phenol is described above.

Generally, the dihydric phenol reacts with the acid anhydride under conventional esterification conditions to form the dihydric phenol diester. The reaction may take place in the presence or absence of a solvent. Additionally, the reaction may be conducted in the presence of a conventional esterification catalyst or in the absence thereof.

D. Polyetherimides

The polyetherimides suitable for use in this invention are well known in the art and are described in, for example, U.S. Patents 3,847,867, 3,838,097 and 4,107,147.

The polyetherimides are of the following formula:

(VIII) 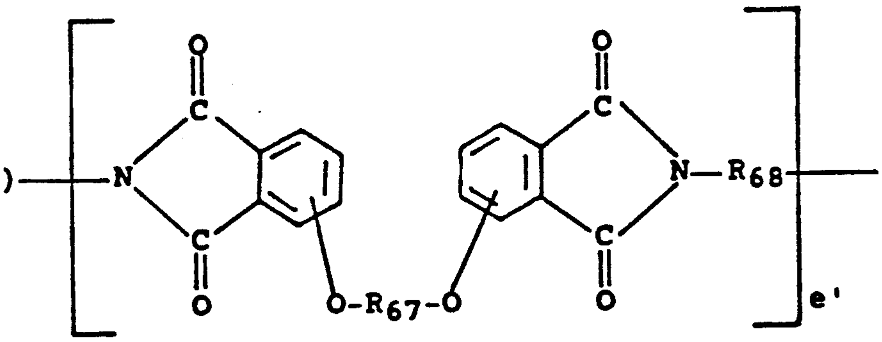

wherein e is an integer greater than 1, preferably from about 10 to about 10,000 or more, $-O-R_{12}-O-$ is attached to the 3 or 4 and 3' or 4' positions and $R_{12}$ is selected from (a) a substituted or unsubstituted aromatic radical such as

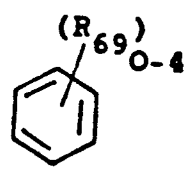

, or

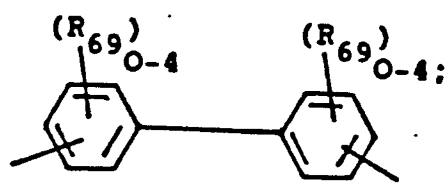

(b) a divalent radical of the formula:

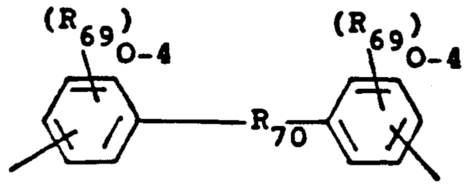

wherein $R_{69}$ is independently $C_1$ to $C_6$ alkyl, aryl or halogen and

$R_{70}$ is selected from -O-, -S-, $-\overset{O}{\overset{\|}{C}}-$, $-SO_2-$, -SO-, alkylene of 1 to 6 carbon atoms, cycloalkylene of 4 to 8 carbon atoms, alkylidene of 1 to 6 carbon atoms or cycloalkylidene of 4 to 8 carbon atoms, $R_{68}$ is selected from an aromatic hydrocarbon radical having from 6 to 20 carbon atoms and halogenated derivatives thereof, or alkyl substituted derivatives thereof, wherein the alkyl group contains 1 to 6 carbon atoms, alkylene and cycloalkylene radicals having from 2 to 20 carbon atoms and $C_2$ to $C_8$ alkylene terminated polydiorganosiloxane or a divalent radical of the formula

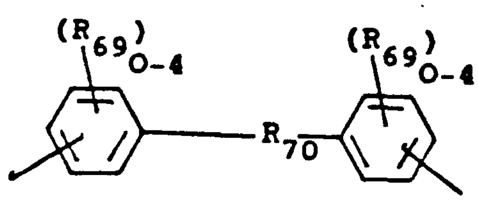

wherein $R_{69}$ and $R_{70}$ are as previously defined.

The polyetherimides may also be of the following formula:

(IX) 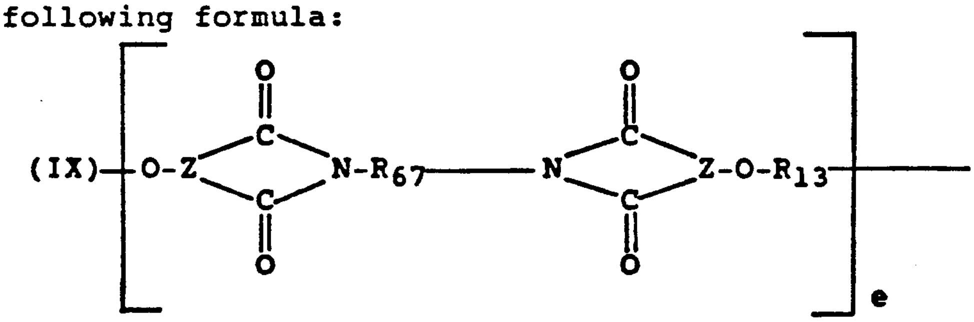

wherein -O-Z is a member selected from

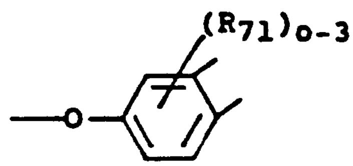

wherein $R_{71}$ is independently hydrogen, lower alkyl or lower alkoxy

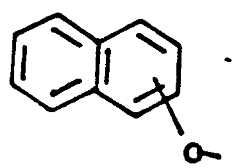

and,

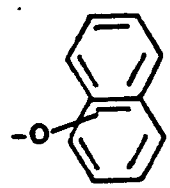

wherein the oxygen may be attached to either ring and located ortho or para to one of the bonds of the imide carbonyl groups, $R_{67}$ and $R_{68}$ and e are as previously defined.

These polyetherimides are prepared by methods well known in the art as set forth in, for example, U.S. Patents 3,833,544, 3,887,588, 4,017,511, 3,965,125 and 4,024,110.

The polyetherimides of Formula (VIII) can, for example, be obtained by any of the methods well-known to those skilled in the art including the reaction of any aromatic bis(ether anhydride)s of the formula

(X) 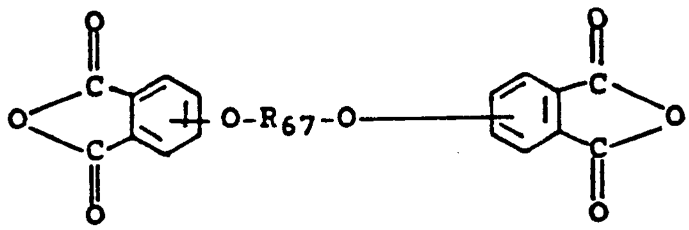

where $R_{67}$ is as defined hereinbefore, with a diamino compound of the formula

(XI) $H_2N-R_{68}-NH_2$

where $R_{68}$ is as defined hereinbefore. In general, the reactions can be advantageously carried out employing well-known solvents, e.g., o-dichlorobenzene, m-cresol/toluene, N,N-dimethylacetamide, etc., in which to effect interaction between the dianhydrides and diamines, at temperatures of from about 20 to about 250°C. Alternatively, the polyetherimides can be prepared by melt

polymerization of any dianhydrides of Formula (X) with any diamino compound of Formula (XI) while heating the mixture of the ingredients at elevated temperatures with concurrent intermixing. Generally, melt polymerization temperatures between about 200° to 400°C and preferably 230° to 300°C can be employed. Any order of addition of chain stoppers ordinarily employed in melt polymerizations can be employed. The conditions of the reaction and the proportions of ingredients can be varied widely depending on the desired molecular weight, intrinsic viscosity, and solvent resistance. In general, equimolar amounts of diamine and dianhydride are employed for high molecular weight polyetherimides, however, in certain instances, a slight molar excess (about 1 to 5 mole percent) of diamine can be employed resulting in the production of polyetherimides of Formula I have an intrinsic viscosity h greater than 0.2 deciliters per gram, preferably 0.35 to 0.60, or 0.7 deciliters per gram or even higher when measured in m-cresol at 25°C.

The aromatic bis(ether anhydride)s of Formula (X) include, for example,

2,2-bis[4-(2,3-dicarboxyphenoxy)phenyl]-propane dianhydride;

4,4'-bis(2,3-dicarboxyphenoxy)diphenyl ether dianhydride;

1,3-bis(2,3-dicarboxyphenoxy)benzene dianhydride;

4,4'-bis(2,3-dicarboxyphenoxy)diphenyl sulfide dianhydride;

1,4-bis(2,3-dicarboxyphenoxy)benzene dianhydride;

4,4'-bis(2,3-dicarboxyphenoxy)benzophenone dianhydride;

4,4'-bis(2,3-dicarboxyphenoxy)diphenyl sulfone dianhydride;

2,2-bis[4-(3,4-dicarboxyphenoxy)phenyl]-propane dianhydride;

4,4'-bis(3,4-dicarboxyphenoxy)diphenyl ether dianhydride;

4,4'-bis(3,4-dicarboxyphenoxy)diphenyl sulfide dianhydride;

1,3-bis(3,4-dicarboxyphenoxy)benzene dianhydride;

1,4-bis(3,4-dicarboxyphenoxy)benzene dianhydride;

4,4'-bis(3,4-dicarboxyphenoxy)benzophenone dianhydride;

4-(2,3-dicarboxyphenoxy)-4'-(3,4-dicarboxy-phenoxy)diphenyl-2,2-propane dianhydride; etc. and mixtures of such dianhydrides.

The organic diamines of Formula (XI) include, for example, m-phenylenediamine,

p-phenylenediamine, 2,2-bis(p-aminophenyl)propane, 4,4'-diaminodiphenyl-methane, 4,4'-diaminodiphenyl sulfide, 4,4'-diamino-diphenyl sulfone, 4,4'-diaminodiphenyl ether, 1,5-diaminonaphthalene, 3,3'-dimethylbenzidine, 3,3'-dimethoxybenzidine,

The polyetherimides of formula (X) may, for example, be prepared by effecting reaction in the presence of a dipolar aprotic solvent of a mixture of ingredients comprising, for instance, (1) a bis(nitrophthalimide) of the general formula:

(XII) 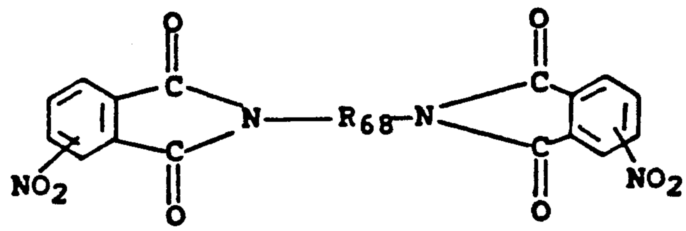

wherein $R_{68}$ is defined as hereinabove, and (2) an alkali metal salt of an organic compound of the general formula:

(XIII) $MO-R_{67}-OM$

wherein M is an alkali metal and $R_{67}$ is defined as hereinabove.

The bis(nitrophthalimide) used in preparing the polymer is formed by reacting a diamine of the formula described above, $NH_2-R_{68}-NH_2$, with a nitro-substituted aromatic anhydride of the formula:

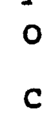

(XIV)

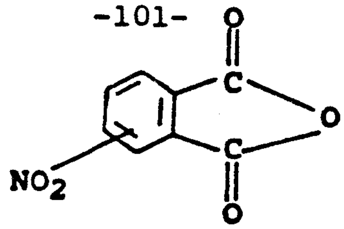

The molar ratio of diamine to anhydride should ideally be about 1:2 respectively. The initial reaction product is a bis(amide-acid) which is subsequently dehydrated to the corresponding bis(nitrophthalimide).

The diamines are described, <u>supra</u>.

The preferred nitrophthalic anhydrides useful in the present invention are 3-nitrophthalic anhydride, 4-nitrophthalic anhydride and mixtures thereof. These reactants are commercially available in reagent grade. They may also be prepared by the nitration of phthalic anhydride using procedures described in Organic Syntheses, Collective Vol. I, Wiley (1948), page 408. Certain other closely related nitroaromatic anhydrides may also be used in the reaction and are illustrated for example by 2-nitronaphthalic anhydride, 1-nitro-2,3-naphthalene-dicarboxylic anhydride and 3-methoxy-6-nitrophthalic anhydride, and the like.

With reference to the alkali metal salts of formula (XIII) among the divalent carbocyclic aromatic radicals which $R_{67}$ may represent (mixtures of such radicals are also included) are, for instance, divalent aromatic hydrocarbon radicals

of from 6 to 20 carbon atoms, such as phenylene, biphenylene, naphthylene, etc. Included are residues of, e.g. hydroquinone, resorcinol, chlorohydroquinone, etc. In addition, $R_{67}$ may be a residue of a dihydroxyl diarylene compound in which the aryl nuclei are joined by either an aliphatic group, a sulfoxide group, sulfonyl group, sulfur, carbonyl group, oxygen, etc. Typical of such diarylene compounds are the following:

2,4-dihydroxydiphenylmethane;
bis(2-hydroxyphenyl)methane;
2,2-bis(4-hydroxyphenyl)propane;
bis(4-hydroxyphenyl)methane;
bis(4-hydroxy-5-nitrophenyl)methane;
bis(4-hydroxy-2,6-dimethyl-3-methoxyphenyl)methane;
1,1-bis(4-hydroxyphenyl)ethane;
1,2-bis(4-hydroxyphenyl)ethane;
1,1-bis(4-hydroxy-2-chlorophenyl)ethane;
1,1-bis(2,5-dimethyl-4-hydroxyphenyl)ethane;
1,3-bis(3-methyl-4-hydroxyphenyl)propane;
2,2-bis(3-phenyl-4-hydroxyphenyl)propane;
2,2-bis(3-isopropyl-4-hydroxyphenyl)propane;
2,2-bis(4-hydroxynaphthyl)propane;
hydroquinone;
naphthalene diols;
bis(4-hydroxyphenyl)ether;

bis(4-hydroxyphenyl)sulfide;

bis(4-hydroxyphenyl)sulfone; and the like.

When dialkali metal salts of formula (XIII) are used with the compound illustrated by formula (XII), the ingredients are advantageously present in an equal molar ratio for optimum molecular weight and properties of the polymer. Slight molar excesses, e.g., about 0.001 to 0.10 molar excess of either the dinitro-substituted organic compound or of the dialkali metal salt of formula (XIII) may be employed. When the molar ratios are approximately equal, the polymer is substantially terminated by a = $Z-NO_2$ at one end and a phenolic group at the other end. If there is a molar excess of one compound, that particular terminal group will predominate.

The conditions of reaction whereby the alkali-metal salt of formula (XIII) is reacted with the dinitro-substituted organic compound of formula (XII) can be varied widely. Generally, temperatures of the order of about 25 to about 150°C are advantageously employed, although it is possible to employ lower or higher temperature conditions depending on the ingredients used, the reaction product sought, time of reaction, solvent employed, etc. In addition to atmospheric pressure, superatmospheric pressures and subatmospheric

pressures may be employed depending upon the other conditions of reaction, the ingredients used, the speed at which it is desired to effect reaction, etc.

The time of reaction also can be varied widely depending on the ingredients used, the temperature, the desired yield, etc. It has been found that times varying from about 5 minutes to as much as 30 to 40 hours are advantageously employed to obtain the maximum yield and desired molecular weight. Thereafter the reaction product can be treated in the appropriate manner required to effect precipitation and/or separation of the desired polymeric reaction product. Generally, common solvents such as alcohols (e.g. methanol, ethanol, isopropyl alcohol, etc.) and aliphatic hydrocarbons (e.g. pentane, hexane, octane, cyclohexane, etc.) may be employed as precipitants for this purpose.

It is important that the reaction between the dinitro-substituted organic compound of formula V and the alkali-metal salt of formula VI (mixtures of such alkali-metal salts can also be used) be carried out in the presence of a dipolar aprotic solvent.

The polymerization is performed under anhydrous conditions usually using dipolar aprotic solvents such as dimethylsulfoxide which are added in varying amounts depending upon the particular

polymerization. A total quantity of solvent, dipolar aprotic solvent or mixture of such solvent with an aromatic solvent sufficient to give a final solution containing 10 to 20% by weight of polymer is preferably employed.

The preferred polyetherimides include those having repeating units of the following formula:

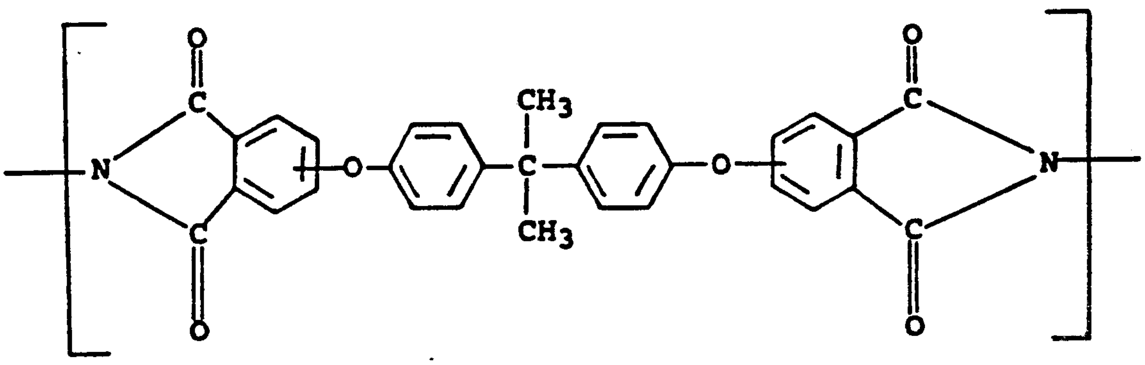

E. Polyesters

The polyesters which are suitable for use herein are derived from an aliphatic or cyloaliphatic diol, or mixtures thereof, containing from 2 to about 10 carbon atoms and at least one aromatic dicarboxylic acid. The polyesters which are derived from an aliphatic diol and an aromatic dicarboxylic acid have repeating units of the

1C367/734

SS*f



following general formula:

XV

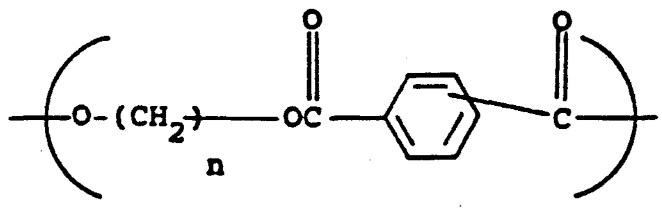

wherein n is an integer of from 2 to 10.

The preferred polyester is poly(ethylene terephthalate).

Also contemplated herein are the above polyesters with minor amounts, e.g., from 0.5 to about 2 percent by weight, of units derived from aliphatic acids and/or aliphatic polyols, to form copolyesters. The aliphatic polyols include glycols, such as poly(ethylene glycol). These can be made following the teachings of, for example, U.S. Patents 2,465,319 and 3,047,539.

The polyesters which are derived from a cycloaliphatic diol and an aromatic dicarboxylic acid are prepared by condensing either the cis - or trans-isomer (or mixtures thereof) of, for example, 1,4-cyclohexanedimethanol with an aromatic dicarboxylic acid so as to produce a polyester

having recurring units of the following formula:

(XVI) 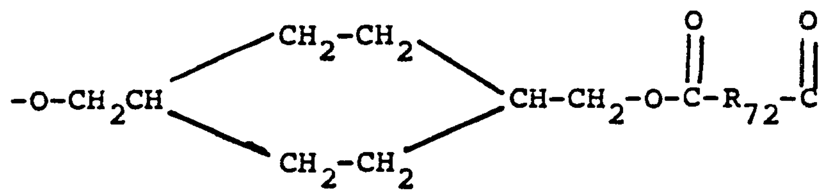

wherein the cyclohexane ring is selected from the cis- and trans- isomers thereof and $R_{72}$ represents an aryl radical containing 6 to 20 carbon atoms and which is the decarboxylated residue derived from an aromatic dicarboxylic acid.

Examples of aromatic dicarboxylic acids indicated by $R_{72}$ in formula IX, are isophthalic or terephthalic acid, 1,2-di(p-carboxyphenyl)ethane, 4,4'-dicarboxydiphenyl ether, etc., and mixtures of these. All of these acids contain at least one aromatic nucleus. Fused rings can also be present, such as in 1,4-or 1,5-naphthalenedicarboxylic acids. The preferred dicarboxylic acids are terephthalic acid or a mixture of terephthalic and isophthalic acids.

A preferred polyester may be derived from the reaction of either the cis-or trans-isomer (or a mixture thereof) of 1,4-cyclohexanedimethanol with a mixture of isophthalic and terephthalic acids. These polyesters have repeating units of the formula:

(XVII) 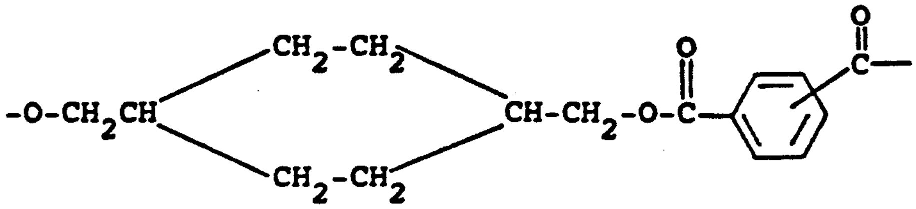

Another preferred polyester is a copolyester derived from a cyclohexane dimethanol, an alkylene glycol and an aromatic dicarboxylic acid. These copolyesters are prepared by condensing either the cis- or trans-isomer (or mixtures thereof) of, for example, 1,4-cyclohexanedimethanol and an alkylene glycol with an aromatic dicarboxylic acid so as to produce a copolyester having repeating units of the following formula:

(XVIII) 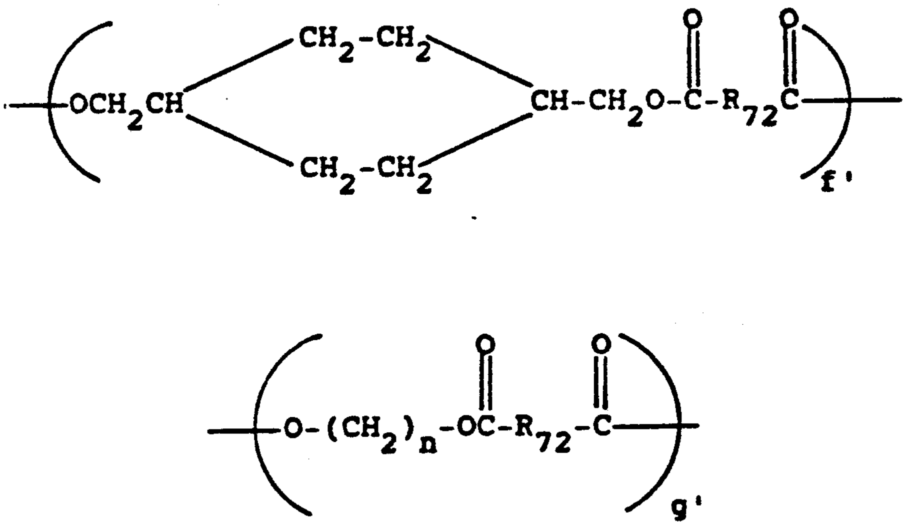

wherein the cyclohexane ring is selected from the cis- and trans- isomers thereof, $R_{72}$ is as previously defined, n is an integer of 2 to 10, the f' units comprise from about 10 to about 90 percent by weight and the g' units comprise from about 10 to about 90 percent by weight.

The preferred copolyester may be derived from the reaction of either the cis- or trans-isomer (or mixtures thereof) of 1,4-cyclohexanedimethanol and ethylene glycol with terephthalic acid in a molar ratio of 1:2:3. These copolyesters have repeating units of the following formula:

(XIX) 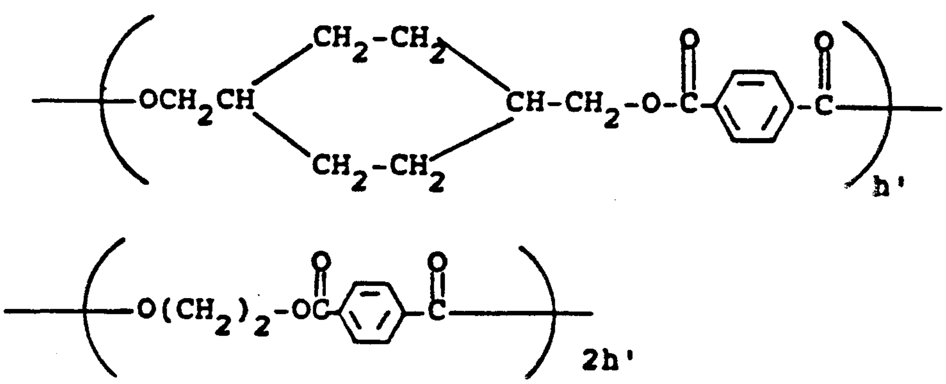

wherein h can be 10 to 10,000. Block as well as random copolymers are possible.

The polyester as described herein are either commercially available or can be produced by methods well known in the art, such as those set forth in, for example, U.S. Patent 2,901,466.

The polyesters used herein have an intrinsic viscosity of from about 0.4 to about 2.0 dl/g. as measured in a 60:40 phenol/tetrachloroethane mixture or similar solvent at 23 to 30°C.

## F. Aromatic Polycarbonate

The thermoplastic aromatic polycarbonates that can be employed herein are homopolymers and copolymers and mixtures thereof, which have an intrinsic viscosity of from about 0.4 to about 1.0 dl./g. as measured in methylene chloride at 25°C. The polycarbonates are prepared by reacting a dihydric phenol with a carbonate precursor. Typical of some of the dihydric phenols that may be employed are bisphenol-A, bis(4-hydroxyphenyl)methane, 2,2-bis(4-hydroxy-3-methylphenyl)propane, 4,4-bis(4-hydroxyphenyl)heptane, 2-2-(3,5,3', 5'tetrabromo-4,4'-dihydroxydiphenyl)propane, (3,3'dichloro-4,4'dihydroxydiphenyl)methane, and the like. Other dihydric phenols of the bisphenol type are described in, for example, U.S. Patents, 2,999,835, 3,028,365 and 3,334,154.

It is, of course, possible to employ two or more different dihydric phenols or a copolymer of a dihydric phenol with a glycol or with hydroxy or acid terminated polyesters.

The carbonate precursor may be either a

carbonyl halide, a carbonate ester, or a haloformate. The carbonyl halides which can be employed herein are carbonyl bromide, carbonyl chloride and mixtures thereof. Typical of the carbonate esters which may be employed herein are diphenyl carbonate, di-(halophenyl)carbonates, such as di-(chlorophenyl)carbonate or di-(bromophenyl)carbonate, etc., di-(alkylphenyl)carbonates such as di(tolyl)carbonate, di(napnthyl)carbonate, di(chloronaphthyl)carbonate, etc. or mixtures thereof. The haloformates suitable for use herein include bis-haloformate of dihydric phenols for example, bischloroformates of bisphenol-A, of hydroquinone, etc. or glycols for example, bishaloformates of ethylene glycol, neopentyl glycol, polyethylene glycol, etc. While other carbonate precursors will be apparent to those skilled in the art, carbonyl chloride, also known as phosgene, is preferred.

The aromatic polycarbonate polymers may be prepared by methods well known in the art by using phosgene or a haloformate and by employing a molecular weight regulator, an acid acceptor and a catalyst. The molecular weight regulators which can be employed in carrying out the process include monohydric phenols, such as phenol,

para-tertiary-butylphenol, para-bromophenol, primary and secondary amines, etc. Preferably, a phenol is employed as the molecular weight regulator.

A suitable acid acceptor may be either an organic or an inorganic acid acceptor. A suitable organic acid acceptor is a tertiary amine and includes materials, such as pyridine, triethylamine, dimethylaniline, tributylamine, etc. The inorganic acid acceptor may be one which can be either a hydroxide, a carbonate, a bicarbonate, or a phosphate of an alkali or alkaline earth metal.

The catalysts which are employed herein can be any of the suitable catalysts that aid the polymerization of, for example, bisphenol-A with phosgene. Suitable catalysts include tertiary amines, such as triethylamine, tripropylamine, N,N-dimethylaniline, quaternary ammonium compounds, such as tetraethylammonium bromide, cetyl triethyl ammonium bromide, tetra-n-heptylammonium iodide, and quaternary phosphonium compounds, such as n-butyltriphenyl-phosphonium bromide and methyl-triphenyl phosphonium bromide.

The polycarbonates can be prepared in a one-phase (homogeneous solution) or a two-phase (interfacial) systems when phosgene, or a haloformate are used. Bulk reactions are possible when the diarylcarbonate precursors are used.

Also, aromatic polyester carbonates may be used. These are described in, for example, U.S. Patent 3,169,121. The preferred polyester carbonate results from the condensation of phosgene, terephthaloyl chloride, isophthaloyl chloride with bisphenol-A and a small amount of p-tertbutylphenol.

G. Styrenic Resin

The styrene resins suitable for use herein include ABS type polymers, the molecules of which contain two or more polymeric parts of different compositions that are bonded chemically. The polymer is preferably prepared by polymerizing a conjugated diene, such as butadiene or a conjugated diene with a monomer copolymerizable therewith, such as styrene, to provide a polymeric backbone. After formation of the backbone, at least one grafting monomer, and preferably two, are polymerized in the presence of the prepolymerized backbone to obtain the graft polymer. These resins are prepared by methods well known in the art.

The backbone polymer, as mentioned, is preferably a conjugated diene polymer such as polybutadiene, polyisoprene, or a copolymer, such as butadiene-styrene, butadiene-acrylonitrile, or the like.

The specific conjugated diene monomers

normally utilized in preparing the backbone of the graft polymer are generically described by the following formula:

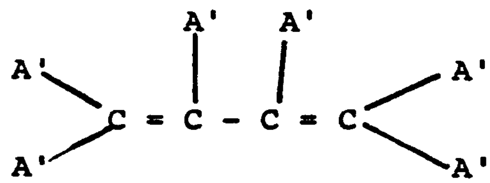

wherein A' is selected from the group consisting of hydrogen, alkyl groups containing from one to five carbon atoms, chlorine or bromine. Examples of dienes that may be used are butadiene, isoprene, 1,3-heptadiene, methyl-1,3-pentadiene, 2,3-dimethyl-1,3,-butadiene, 2-ethyl - 1,3-pentadiene; 1,3- and 2,4-hexadienes, chloro and bromo substituted butadienes such as dichlorobutadiene, bromobutadiene, dibromobutadiene, mixtures thereof, and the like. A preferred conjugated diene is butadiene.

One monomer or group of monomers that may be polymerized in the presence of the prepolymerized backbone are monovinylaromatic hydrocarbons. The monovinylaromatic monomers utilized are generically

described by the following formula:

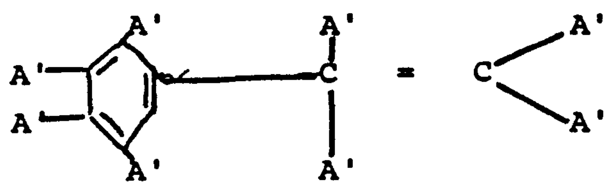

wherein A'is as previously defined. Examples of the monovinylaromatic compounds and alkyl-, cycloalkyl-, aryl-, alkaryl-, aralkyl-, alkoxy-, aryloxy-, and other substituted vinylaromatic compounds include styrene, 3-methylstyrene; 3,5-diethylstyrene, 4-n-propylstyrene, w-bromostyrene, dichlorostyrene, dibromostyrene, tetra-chlorostyrene, mixtures thereof, and the like. The preferred monovinylaromatic hydrocarbons used are sytrene and/or a w-methylstyrene.

A second group of monomers that may be polymerized in the presence of the prepolymerized backbone are acrylic monomers such as acrylonitrile, substituted acrylonitrile and/or acrylic acid esters, exemplified by acrylonitrile, and alkyl acrylates such as ethyl acrylate and methyl methacrylate.

The acrylonitrile, substituted acrylonitrile, or acrylic acid esters are described

generically by the following formula:

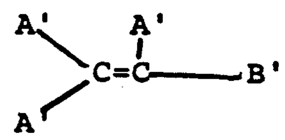

wherein A' is as previously defined and B' is selected from the group consisting of cyano and carbalkoxy wherein the alkoxy group of the carbalkoxy contains from one to about twelve carbon atoms. Examples of such monomers include acrylonitrile, ethacrylonitrile, methacrylonitrile, w-chloroacrylonitrile, ö-chloroacrylonitrile, w-bromoacrylonitrile, and ö-bromoacrylonitrile, methyl acrylate, methyl methacrylate, ethyl acrylate, butyl acrylate, propyl acrylate, isopropyl acrylate, and mixtures thereof. The preferred acrylic monomer is acrylonitrile and the preferred acrylic acid esters are ethyl acrylate and methyl methacrylate.

In the preparation of the graft polymer, the conjugated diolefin polymer or copolymer exemplified by a 1,3-butadiene polymer or copolymer comprises about 50% by weight of the total graft polymer composition. The monomers polymerized in the presence of the backbone, exemplified by styrene and acrylonitrile, comprise from about 40 to about

95% by weight of the total graft polymer composition.

The second group of grafting monomers, exemplified by acrylonitrile, ethyl acrylate or methyl methacrylate, of the graft polymer composition, preferably comprise from about 10% to about 40% by weight of the total graft copolymer composition. The monovinylaromatic hydrocarbon exemplified by styrene comprise from about 30 to about 70% by weight of the total graft polymer composition.

In preparing the polymer, it is normal to have a certain percentage of the polymerizing monomers that are grafted on the backbone combine with each other and occur as free copolymer. If styrene is utilized as one of the grafting monomers and acrylonitrile as the second grafting monomer, a certain portion of the composition will copolymerize as free styrene-acrylonitrile copolymer. In the case where γ-methylstyrene (or other monomer) is substituted for the styrene in the composition used in preparing the graft polymer, a certain percentage of the composition may be an γ-methylstyrene-acrylonitrile copolymer. Also, there are occasions where a copolymer, such as γ-methylstyrene-acrylonitrile, is added to the graft polymer copolymer blend. When the graft polymer-copolymer blend is referred to herein, it is meant optionally

to include at least one copolymer blended with the graft polymer composition and which may contain up to 90% of free copolymer.

Optionally, the elastomeric backbone may be an acrylate rubber, such as one based on n-butyl acrylate, ethylacrylate, 2-ethylhexylacrylate, and the like. Additionally, minor amounts of a diene may be copolymerized in the acrylate rubber backbone to yield improved grafting with the matrix polymer.

These resins are well known in the art and many are commercially available.

H. Poly(Alkyl Acrylate) Resin

The poly(alkyl acrylate) resin which may be used herein includes a homopolymer of methyl methacrylate (i.e., polymethyl methacrylate) or a copolymer of methyl methacrylate with a vinyl monomer (e.g., acrylonitrile, N-allylmaleimide, vinyl chloride or N-vinyl maleimide), or an alkyl acrylate or methacrylate in which the alkyl group contains from 1 to 8 carbon atoms, such as methyl acrylate, ethyl acrylate, butyl acrylate, ethyl methacrylate and butyl methacrylate. The amount of methyl methacrylate is greater than about 70% by weight of this copolymer resin.

The alkyl acrylate resin may be grafted onto an unsaturated elastomeric backbone, such as

polybutadiene, polyisoprene, and/or butadiene or isoprene copolymers. In the case of the graft copolymer, the alkyl acrylate resin comprises greater than about 50 weight percent of the graft copolymers.

These resins are well known in the art and are commercially available.

The methyl methacrylate resins have a reduced viscosity of from 0.1 to about 2.0 dl/g in a one percent chloroform solution at 25°C.

## I. Polyhydroxyethers

The thermoplastic polyhydroxyethers which may be used herein have the following general formula:

$$-\!\!\left[ F\ O\ F'\ O \right]\!\!-_{j'}$$

where F is the radical residuum of a dihydric phenol, F' is a radical residuum of an epoxide selected from mono- and diepoxides and which contain from 1 to 2 hydroxyl groups, and j is an integer which represents the degree of polymerization and is at least about 30 and preferably is above about 80.

In general, thermoplastic polyhydroxyethers

are prepared by contacting, under polymerization conditions, a dihydric phenol and an epoxide containing from 1 to 2 epoxide groups in substantially equimolar amounts by methods well known in the art.

Any dihydric phenol can be used in forming polyhydroxyethers. Illustrative dihydric phenols are mononuclear dihydric phenols such as hydroquinone, resorcinol, and the like as well as the polynuclear phenols. The dihydric polynuclear phenols have the general formula:

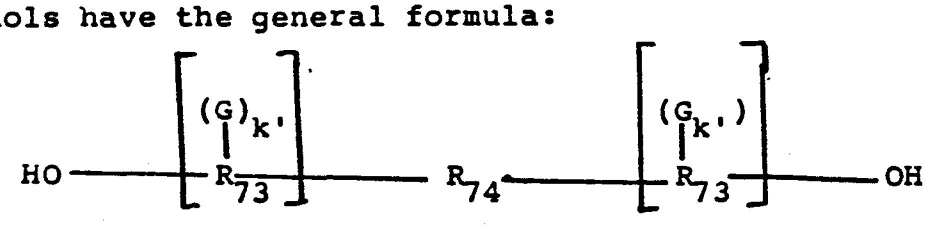

wherein the $R_{73}$'s are independently an aromatic divalent hydrocarbon radical, such as naphthylene and phenylene with phenylene being preferred, the G's may be the same or different and are selected from alkyl radicals, such as methyl, n-propyl, n-butyl, n-hexyl, n-octyl and the like, preferably alkyl radicals having 1 to 4 carbon atoms; halogen atoms, i.e., chlorine, bromine, iodine, or fluorine; or alkoxy radicals such as methoxy, methoxymethyl, ethoxy, ethoxyethyl, n-butyloxy, amyloxy and the like, preferably an alkoxy radical having 1 to 4

carbon atoms, the k's are independently integers of 0 to 4, $R_{74}$ is independently selected from a divalent saturated aliphatic hydrocarbon radical particularly alkylene or alkylidene radicals having from 1 to 8 carbons atoms, especially $C(CH_3)_2$, cycloalkylene, cycloalkylidene or any other divalent group such as O, S, SO, $SO_2$, CO, a chemical bond, etc. Particularly preferred are dihydric polynuclear phenols having the general formula:

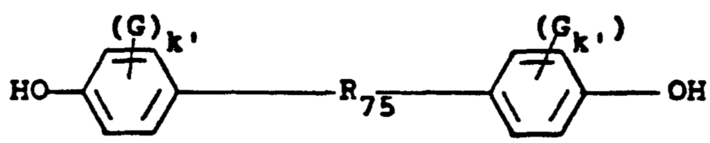

wherein G and k are as previously defined, and $R_{75}$ is an alkylene or alkylidene group, preferably having from 1 to 3 carbon atoms, cycloalkylene or cycloalkylidene having 6 to 12 carbon atoms.

Diepoxides useful for the preparation of polyhydroxyethers may be represented by repeating

units of the following formula:

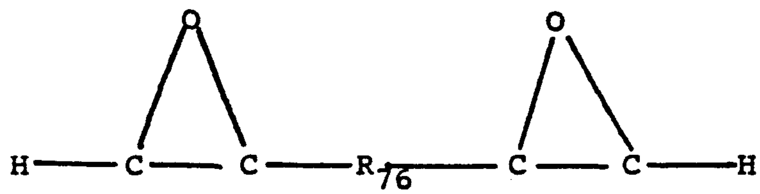

wherein $R_{76}$ is representative of a bond between adjacent carbon atoms or a divalent organic radical such as an aliphatic, aromatic, alicyclic, heterocyclic or acyclic arrangement of atoms.

Other diepoxides which can be mentioned include those wherein two oxirane groups are linked through an aromatic ether, i.e., compounds having the grouping:

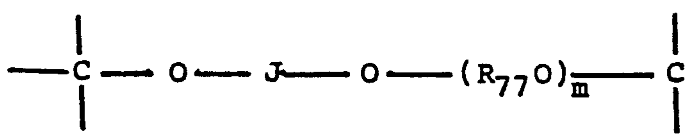

wherein $R_{77}$ is a divalent organic radical, J is a divalent aromatic radical residuum of a dihydric phenol, such as those listed above in the description of dihydric phenols, and m is an integer from 0 to 1 inclusive.

Still other diepoxides include ethers wherein the oxirane groups are connected to vicinal carbon atoms at least one pair of which is a part of a cycloaliphatic hydrocarbon.

These polyhydroxy ethers are prepared by methods well known in the art, such as those described in, for example, U.S. Patents 3,238,087; 3,305,528; 3,924,747; and 2,777,051.

J. Polyamides

The polyamide polymers which may be used herein are well known in the art. The polyamide polymers include homopolymers as well as copolymers. These polymers may be formed by conventional methods from the condensation of bifunctional monomers, by the condensation of diamines and dibasic acids, as well as by addition polymerization. Numerous combinations of diacids, such as carbonic acid, oxalic acid, glutaric acid, adipic acid, pimelic acid, suberic acid, azelaic acid, sebacic acid, dodecanedioic acid, isophthalic acid, terephthalic acid, and the like, diamines, such as hydrazine, ethylenediamine, hexamethylenediamine, 1,8-octanediamine, piperazine, and the like, and amino acids are possible. The chains between functional groups in the reactants may comprise linear or branched aliphatic hydrocarbons, or alicyclic or aromatic rings. They may also contain hetero atoms such as oxygen, sulfur, and nitrogen. Secondary diamines lead to the formation of N-substituted polyamides

Also, included herein are the aromatic polyamide polymers which are aromatic in both the diamine and the dibasic acid. The dibasic acids include terephthalic acid, isophthalic acid, phthalic acid, and the like. The aromatic diamines include o-phenylenediamine, 2,4-diaminotoluene, 4,4'-methylenedianiline, and the like.

The polyamide polymers are prepared by methods well known in the art, such as by direct amidation which is the reaction of amine groups with carboxyls accompanied by elimination of water; low temperature polycondensation of diamines and diacid chlorides, ring-opening polymerization, addition of amines to activated double bonds, polymerization of isocyanates and reaction of formaldehyde with dinitriles.

The polyamide polymers include polyhexamethylene-adipamide, i.e., nylon 6,6; poly(ε-caprolactam), i.e., nylon-6; polypropiolactam, i.e., nylon-3; poly(pyrrolidin-2-one), i.e., nylon-4; poly(ω-enanthamide), i.e., nylon-7; polycapryllactam, i.e., nylon-8; poly(ω-pelargonamide), i.e., nylon-9; poly(11-aminodecanoic acid), i.e., nylon-10; poly(ω-undecaneamide), i.e., nylon-11; polyhexamethyleneterephthalamide, i.e., nylon-6,T,

nylon 6,10, and the like

K. Poly(arylene sulfide)

The poly(arylene sulfide)s which are suitable for use herein are solid, have a melting point of at least about 150°F. and are insoluble in common solvents. Such resins can be conveniently prepared by the process disclosed in, for example, U.S. Pat. No. 3,354,129. Briefly, the process comprises the reaction of an alkali metal sulfide and a polyhalo ring-substituted aromatic compound in the presence of a suitable polar organic compound, as for example, the reaction of sodium sulfide with dichlorobenzene in the presence of N-methyl-2-pyrrolidone to form poly(phenylene-sulfide).

The resulting polymer contains the aromatic nucleus of the polyhalo-substituted monomer coupled in repeating units predominantly through a sulfur atom. The polymers which are preferred for use according to this invention are those polymers having the repeating unit $-R_{78}-S-$ where $R_{78}$ is phenylene, biphenylene, naphthylene, or a lower alkyl-substituted derivative thereof. By lower alkyl is meant alkyl groups having one to six carbon atoms such as methyl, propyl, isobutyl, n-hexyl and the like.

1C367/734
SS*f



The preferred poly(arylene sulfide) is poly(phenylene sulfide), a crystalline polymer with a repeating structural unit comprising a para-substituted benzene ring and a sulfur atom which may be described by the following formula, where p has a value of at least about 50.

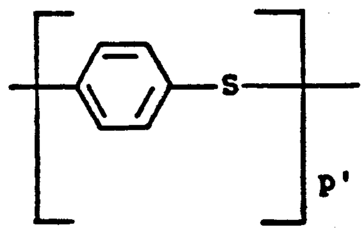

Suitable poly(phenylene sulfide) compositions are available commercially under the trade name Ryton of the Phillips Petroleum Company. Preferably, the poly(phenylene sulfide) component has a melt flow index, measured at 600°F. using a 5 Kg. weight and a standard orifice, within the range of from about 10 to about 7000 dg./min..

The term poly(arylene sulfide) is meant to include not only homopolymers but also arylene sulfide copolymers, terpolymers and the like.

## Liquid Crystalline Polyesters

The liquid crystalline polyesters which may be used herein are well known in the art. These liquid crystalline polyesters are described in, for example, U.S. Patents 3,804,805; 3,637,595;

3,845,099; 3,318,842; 4,076,852; 4,130,545; 4,161,470; 4,230,817 and 4,265,802. Preferably, the liquid crystalline polyesters are derived from one or more of the following: p-hydroxy benzoic acid, m-hydroxy benzoic acid, terephthalic acid, sophthalic acid, bisphenol-A, hydroquinone, resorcinol, 4,4'-biphenol, 2,6-naphthalene diol, 2,6-naphthalene dicarboxylic acid, 6-hydroxy-2-naphthoic acid and 2,6-dihydroxy anthraquionone. Two commercially available liquid crystalline copolyesters (obtained from the Carborundum Corporation) are Ekkanol, a homopolymer of p-hydroxy benzoic acid, and Ekkcel, a copolymer of p-hydroxy benzoic acid, terphthalic and isophthalic acids, and 4,4'-biphenol. Other liquid crystalline polyesters of interest include a copolyester of p-hydroxybenzoic acid and 6-hydroxy-2-naphthoic acid in a 75/25 molar ratio; a copolyester obtained by polymerizing p-acetoxybenoic acid in a polyethylene terphtalate matrix.

Substrates of low moisture absorbence are desired especially for vapor phase soldering. While substrates exhibiting 0.1 to 0.2 weight percent increase at 23$^{o}$ C for 24 hours of water absorbence (ASTM D570 test) perform satisfactorily under wave soldering, preferably they should not have a moisture absorbence in excess of about 0.05 weight

percent increase at 23°C for 24 hours for vapor phase soldering. Thus, it is desirable in some instances to dry the substrate prior to its undergoing either vapor phase soldering or wave soldering.

ADHESIVE

The adhesive component may be any one or more of the Thermosettable resins described above or combinations of such resins with seemingly thermoplastic resins which are reactive sufficiently with the binder portion of the circuit element film and/or with another reactive resin with which it is blended so as to form a cured thermoset interfacial bonding layer between the adherend (the dielectric surface) and the other adherend (the circuit element film). The theories underlying adhesion are well developed, see e.g. Skiest, "Handbook of Adhesives," 2nd Edition, 1977, pp. 11-16, published by Van Nostrand Reinhold Company, New York, N.Y. U.S.A. A wide variety of adhesive materials are employable in the practice of this invention. Without intending to be limited, a preferred adhesive combination is the mixture of an acetal resin, viz. polyvinyl acetal, and an epoxy resin, as generally described by Skiest, *supra*, pp. 507-527. Particularly good results are obtained from a blend of

polyvinylbutyral or polyvinylacetal and an epoxy substituted novolak as described below. Other desirable adhesives include thermoplastic polyester polyurethanes crosslinked by polyfunctional blocked isocyanates whereby crosslinking is achieved by binret and/or allophanate linkages. Straight epoxy systems are desirable such as the cycloaliphatic epoxides blended with polyols such as polycaprolactone polyols. Where interreaction is achievable by catalysis, a catalyst is supplied. Many resin systems are crosslinked to a cured condition using heat alone. Where the dielectric surface is pre-preg, then the resin used in forming the final composite of the dielectric surface may also be used as the adhesive layer or interface. Many thermosetting resins are employable to not only bind the dielectric surface (composite formation) they also can enhance adhesion between the circuit element film or another layer of adhesive. Thus the options in respect to adhesives are many and varied. Many additives may be incorporated into an adhesive formulation and they are generally described in the ADDITIVES section, infra.

ADDITIVES

Additives which may be used with the thermoplastic and/or thermosetting resin for making

the dielectric substrate as for example a printed circuit board include reinforcing and/or non-reinforcing fillers such as wollastonite, asbestos, talc, alumina, clay, mica, glass beads, fumed silica, gypsum and the like; reinforcement fibers such as aramid, boron, carbon, graphite, and glass. Glass fiber are the most widely used reinforcement in the form of chopped strands, ribbon, yarn, filaments, or woven mats. Mixtures of reinforcing and non-reinforcing fillers may be used, such as a mixture of glass fibers and talc or wollastonite. These reinforcing agents are used in amounts of from about 10 to about 80 weight percent, whereas the non-reinforcing fillers are used in amounts of up to 50 weight percent. Other additives include stabilizers, pigments, flame retardants, plasticizers, processing aids, coupling agents, lubricants, mold release agents, plasticizers and the like. These additives are used in amounts which achieve the desired result.

## DETAILED DESCRIPTION OF THE DRAWINGS

In FIGS. 1 and 2, the dielectric substrate is shown at 10, the cured adhesive is shown at 11 and the electrical conductive pathways (electric circuit element) are shown at 12. In this figure, three pathways 12 are shown and form what is known

as the conductive pattern (circuit pattern) of a printed circuit board to which components are connected. In FIGS. 1 and 2 the pathways are provided with a solder film surface 13 and a plated metal layer 14 between surface 13 and pathway 12 to facilitate connection and repair thereof.

The thickness of the metal plating will typically be about .25 mil to 1 mil and the thickness of the pathway is typically from about .1 to 10 mils, preferably between about 0.5 mil and about 3 mils. Most preferably the metal plating is printed onto the transfer sheet by conventional techniques such as screening, transfer roller or pad and the thickness of the printing is a maximum of 1 mil.

In FIG. 3 is shown a non-preferred embodiment wherein the electrically conductive pathways 12 prior to compacting and curing of the binder of the pathways, are positioned on a dielectric material 10. The pathways 12 may be formed by printing (offset, silk screen) or drawing a slurry (ink) containing the resin binder containing the metal particles (and a volatile solvent to aid in the printing). The pathways may also be brushed on or applied in any other conventional manner. An adhesive, most preferably a curable thermosetting adhesive, 11 is provided

between the substrate 10 and the pathway 12. The solvent is thereafter vaporized and the substrate 10 containing the pathways is provided in an oven, e.g., for 10 minutes at 165°C (330°F), to partially cure the binder and adhesive. Thereafter the board is placed between heated press sections 13a and 13b in FIG. 4 at pressure, e.g. 330°F for 20 minutes at 150 psi is applied to compact the pathway by at least about 25 percent while completing the curing of the resin binder holding the particles and the adhesive. It is most preferred that the contacting surface of section 13a include a 5 mil silicone rubber (thermally conductive) and of 65 durometer. It should be understood that the substrate 10 may be rigid or flexible.

FIG. 5 illustrates the compacted pathways 12 (now reduced in thickness by about 25 to 40 percent) which have preferably partially flowed into the adhesive due to the heat.

A metal slurry of metal particles, e.g. noble metals such as silver, palladium, gold and platinum, is preferably mixed with the combination of other metal particles such as nickel and tin. A

FIG. 5 illustrates the compacted pathways 12 (now reduced in thickness by about 25 to 40 percent) which have preferably partially flowed into the adhesive due to the heat.

1C367/734
SS*f



A metal slurry of metal particles, e.g. noble metals such as silver, palladium, gold and platinum, is preferably mixed with the combination of other metal particles such as nickel and tin. A vaporizable solvent is mixed therewith as well as a small amount of a curable plastic binder. The metal content based on total solids is very high, e.g., over about 93 percent and preferably 94 to about 98 percent by weight. Thereafter the slurry is silkscreened or applied in any other conventional manner, as by spraying, etc. to form slurry lines 20 in Figure 6 in the shape of the circuit pattern pathways to be ultimately formed on a removable layer 19. The layer 19 is preferably of the release type so that it may ultimately be peeled away. Suitable papers are commercially known as Fish paper and may include a release agent on the surface thereof. An example of a suitably available release layer is sold as Warren's TRANSKOTE ETL106 DUPLEX UNOTO SIDE 67854 FR---1.

In FIG. 7, there is the application of heat to boil off the solvent, e.g. 330°F. for 10 minutes. The release layer 19 is shown preferably positioned on a support 10.

Thereafter the metal particles in lines 20 may be compacted by applying 150 psi by a press for 5 minutes at 330°F. to increase the conductivity.

Alternatively an adhesive 21, e.g. a curable plastic adhesive, may first be applied over lines 20 and on the release layer 19 and then compacted by a press comprising sections 22-1 and 22-2 to effect compacting of the particles in the lines 20, e.g., 150 psi at 350 psi. Preferably sheets of silicone rubber (thermally conductive) 65 durometer and Teflon Sheet are positioned on both sides of the material being compacted with the Teflon sheet in contact with the paper 19 and the adhesive 21 as shown in FIGS. 8 and 9.

Thereafter the release layer supporting the lines 20 and the adhesive 21 are positioned in a heated press comprising sections 24A and 24B, having heaters 24-1. The press produces a temperature, e.g., 330°, for 5 minutes, which is sufficient to cure the adhesive and the binder, and cause lamination of the adhesive to a substrate, e.g., plastic (dielectric layer) 10 to form the circuit shown in FIGS. 10 and 11. In addition, the press produces 150 psi to cause a compacting of metal particles in the lines (electrically conductive pathways) 20. In FIG. 11 there is shown the now formed circuit lines 20 which have been partially embedded into the substrate 10 when a thermoplastic type plastic substrate which can partially soften

under heat and pressure is used. Often there is no embedding and the circuit lines or pathway 20 is directly on the surface of the dielectric substrate. After step 4 the layer 19 is removed by peeling it off to leave the circuit shown as in FIGS. 10 and 11.

In practicing the method it is most preferred that the contacting surface of the section include a 60 mil silicone rubber layer (thermally conductive) and of 65 durometer. It should also be understood that the substrate 10 may be rigid or flexible.

PREPARATION OF THE DIELECTRIC SURFACE

The thermoplastic and thermosetting resins described above can be molded to form a base and dielectric surface using conventional techniques. For example, the thermoplastic resins can be injection molded, or extruded into films, sheets or boards.

The choice of the resin will depend in part on the mechanical and electrical characteristics desired. Mechanical properties of substrate materials which often have an important bearing on the printed wiring assembly are water absorption, coefficient of thermal expansion, flexural strength, impact strength, tensile strength, shear strength

and hardness. Thus, a comparison of the various substrate material properties will help the designer select the optimum substrate for the application.

The substrate can be subjected to a conditioning treatment, e.g., a swell and etch treatment. In this technique, swelling of the surface is accomplished by the use of a solvent system. This can be followed by etching in a strong oxidizing medium such as a mixture of chromic and sulfuric acids. This technique is well known in the art.

## PREPARATION OF THE COMPOSITION CONTAINING CONDUCTIVE MATERIAL AND APPLICATION TO A RELEASE SURFACE

A release surface is provided and then a thermosetting resin composition containing at least 54% volume fraction thereof of conductive metal particles is applied to the solid release surface in the configuration of at least an electric circuit element.

The release surface which may be used herein is any surface which is suitable for accepting the conductive metal particle film which is applied thereto in the configuration of at least an electrical circuit element. The solid release surface may be a release paper, a film made from the

plastics described above providing a release surface or a rigid plastic or metal release surface. Preferred release surfaces are release papers and include those formed from a vinyl coating such as Stripkote ER & EHR CIS, Transkote ER & EHR CIS, and rubber separation such as Rubberleaf CZC2S (obtained from S. D. Warren Co., Westbrook, Maine).

The metal particles and the binder (the thermosetting resin) are blended to form an ink with or without solvent depending upon the viscosity desired for the ink and the method to be employed for printing or coating the circuit element film (pathway) onto the release surface. Conventional organic printing ink solvents can be used. The viscosity of the ink is preferably that suitable for screen printing as for example a Brookfield viscosity limit of about 35,000 to 45,000 centipoise at $25^{o}C$.The film is dried by removing the solvent, and the film may be advanced from an A-stage to a B-stage.

Oftentimes it will be desirable to coat the element and indeed the full surface of the release paper with an adhesive to hold the conductive metal particle film more securely to the paper but this is not critical to the invention. Thus in some cases only the conductive metal particle film is coated with the adhesive. The adhesive may be based on a

phenol-formaldehyde resin such as resole and novolac resins, described above, resorcinol formaldehyde resin; amino-formaldehyde resins, such as urea or melamine-formaldehyde resins;the epoxy resins described above, particularly those derived from bisphenol-A and epichlorohydrin and the epoxy novalac resins such as those derived from epichlorohydrin with novolac resins; polyurethane based adhesives particularly those polyurethanes derived from an isocyanate such as toluene diisocyanate, diphenylmethane-4,4'-diisocyanate, polymethylene polyphenyl isocyanate together with various polyester and polyether glycols; blends of the epoxy resins and polyvinyl acetal resins derived from an aldehyde and polyvinyl alcohol.

The electrically conductive metal is preferably in the form of metal particles at least a portion of which are precious or noble metal. The precious or noble metals include at least one of silver, gold, platinum, palladium, rhodium and ruthenium. Broadly, the metal particles may comprise at least one of the metals from Groups 5b, 6b, 7b, 8, 1b, 2b and 3b of the Periodic Table of the Elements. The particle size of the metal ranges so all of the particles pass a 100 mesh size screen and are retained on a 350 mesh screen.

The electrically conductive metal particles

can be only precious metals such as silver and/or gold. They can contain mixtures of particles, some of which are precious metals such as silver, gold and platinum, the remainder being particles of other metals or solids such as nickel, copper, zinc, aluminum, gallium, glass, metal oxides, and nonmetal oxide solids (e.g., silica, mica, etc.), and the like. In a preferred practice of the invention, the amount of precious metal comprising the particles in the thermosetting resin composition is at least about 15 weight percent up to 100 weight percent of the particles in the composition. In a more preferred embodiment, the amount of precious metal is at least about 20 weight percent to 100 weight percent of the particles in the composition. The combination of precious metal and other material need not only be a simple particulate mixture. For example, precious metals plated on other metals, such as nickel, copper, or hollow glass spheres coated with precious metal (viz. silver), can be employed. However, in the preferred practice of this invention, the precious metal used is silver, and it is in the form of flakes or platelets or rods which allow for maximum contact within the thermoset resin layer on the adhesive containing dielectric surface. The shape of the other particle component is not narrowly critical so long as it allows

adequate silver to silver contact in the layer to provide the level of electrical conductance herein described for the invention. In some cases the conductive particles can be wholly non-precious metal particles.

The preferred conductive metal is silver flake. However, to reduce costs, the silver flake may be used with metal particles (also referred to as powder) such as nickel or tin. A particularly desirable combination is 25 to 50 weight percent silver particles and 75 to 50 weight percent nickel particles based on the particulate content only.

The conductive metal is used together with a binder and this combination is used to form the conductive pathways (lines). The binder is the curable thermosetting resin. Suitable thermosetting resins are fully described above. Especially preferable binders include phenol blocked isocyanates reacted with novolac epoxides alone or blended with polyvinyl acetals, e.g., polyvinyl butyral or polyvinyl formal resins. The blocked isocyanates may be deleted from such resin if desired.

The conductive metal and binder are mixed together in a high boiling solvent to form a slurry (the ink). Suitable solvents include cellosolve acetate, n-butyl carbitol, n-methyl-2-pyrolidine,

N,N-dimethyl formamide, dimethyl sulfoxide, ethylene glycol, anisole, decaline, diethylene glycol diethyl ether, aniline, diethylene glycol dibutyl ether, diethylene glycol dimethyl ether, glycerol, tetralin, xylene, ethylene glycol monoethyl ether, chlorobenzene, diethyl carbonate, butyl acetate, ethylene glycol monomethyl ether, toluene and the like. The solvent is vaporized during the curing process. The amount of resin in the ink or dry basis is from about 2 to about 10, preferably from about 2 to about 6 percent by weight.

The electrically conductive metal is present in the slurry in amounts of at least 90, preferably from 94 to less than 100 and most preferably from about 94-95 to 98 percent on a 100% solids basis. In order to achieve the most desired level of conductivity, e.g., surface resistivity of 0.1 to 0.005 ohm/sq., the conductive metal content should be between 94 and 98 percent of the total metal content in the pathway, or expressed in another way, from about 68 to about 87 percent of the volume fraction based on the volume of the dry film of the ink. The latter characterization is the more valid basis for describing the limits of particulate content since when conductive metal coated dielectric core particles are used the percentage by weight of metal does not determine

electrical conductive properties but the volume fraction is determinative. However, where certain maximized solderability values, plateability values and conductivity values are not required some advantages of the invention can be obtained with metal particle volume fractions of down to 54%.

An adhesive layer may be applied over the surface of the substrate which is to support the conductive pathway in addition to or in place of an adhesive layer placed directly on the pathway when it is carried on the release surface. The adhesive may be applied to the entire surface which is to support the conductive pathway or only under the pathway. The adhesive contains functionally reactive groups therein which have the capability of reacting with and becoming bonded to the thermosetting resin binder composition and also with the dielectric base. The adhesive may interact with the thermosetting resin composition to become partially or fully cured therewith and form a composite structure. Preferred adhesives include epoxides and polyurethanes and those which contain blocked isocyanate groups therein.

The release surface and the dielectric surface are contacted such that the electrical circuit is facing the dielectric surface and is separated therefrom by the adhesive resin.

Sufficient heat and pressure are applied to form a composite structure whereby the thermosetting resin is essentially fully cured and the adhesive is essentially fully interreacted whereby the electrical circuit is transferred from the release surface to become bonded to the dielectric surface. In some cases only partial curing and/or reaction need be obtained. The release surface is The release surface is then separated from the composite structure preferably to provide an electrical circuit having a surface resistivity of at least 0.1 ohm per.

The release surface and the dielectric surface are contacted at a temperature of from about 120°C to about 180°C and preferably 130°C to 170°C and a pressure of from about 100 psi to about 1,000 psi and preferably 180 psi to 500 psi but not so great as to cause distortion of components.

In said process the metal content concentrates to a greater degree in the portion of the thermosetting composition deposited as the electric circuit element in contact with the release surface than the other portion of the element's composition.

It should be appreciated that the release surface can be a solid non-flexible or semi-flexible

1C367/734
SS*f



surface such as part of a drum surface on to which the circuit configuration is deposited by one of a variety of means such as silk screening, printing, electrostatic transfer, then the drum rotates to a next stage where there is applied sufficient heat to impart the first stage of the crosslinking reaction, viz. from an A-stage resin to a B-stage resin. That stage on the drum can include a heated roller for partially curing and compacting the resin/metal particle composition. Then the drum can be advanced to another stage where a coating of adhesive or a solid film of the adhesive is applied to the partially cured resin/metal particle composition. This stage can include simultaneous supplying of the dielectric surface, followed by passage of the assembly through a space provided by an adjacent compression calendar role, heated sufficiently or relying on the temperature of the drum, whereby the total composite may be formed and the thermosetting resin is finally cured, viz. advanced from the B-stage to the C-stage.

Multi-layer electrical circuits are included within the scope of this invention. In producing these multi-layer electrical circuits the release surface onto which has been deposited the thermosetting resin and electrically conductive metal particles described above is treated with a

dielectric masking layer which leaves exposed contact points of the circuit element which can be electrically interconnected with another circuit element deposited over the masking layer. This masking layer may be a pigment (viz. $TiO_2$, $TiO_2/SiO_2$ combinations, etc.) thermosetting resin which is applied over at least a portion of the electrical circuit on the release paper or the masking layer may be a dielectric solder of the type as described in Example 3, for example. A conductive ink is then screened in register with the mask pattern. Another mask is then screened in register with the conductive ink pattern. Another layer of conductive ink is then screened in register with the other layer of ink and layers of mask. An adhesive may be applied over this layer. These layers may be built up as desired. This assembly is then transferred to a dielectric substrate which has been coated with an adhesive or built up on a dielectric substrate. The assembly is then heated under pressure initiating an adhesion of the conductive ink layers, adhesive layer, and dielectric substrate. The release carrier may then be stripped away from the assembly if not already removed in an earlier step.

FIG. 12 illustrates a multi-layer electric circuit formed in accordance with this invention as

above described. In FIG. 12, the dielectric base or circuit board 10 has an adhesive layer 21 thereover mounting a conductive circuit element or pathway 20. Overlying the adhesive surface 21 and the pathways 20 is a dielectric mask 100 formed as from a dielectric ink. The layer 100 covers all but selected portions or areas of the pathways 20 which are to be electrically connected with a second set of pathways 20A parallel to the plane of the first pathways 20. Thus the dielectric layer 100 overlies all but selected areas of the pathways 20. The pathways 20A are preferably the same in composition as the pathways 20 and are electrically interconnected through integrally formed portions 103 with inks as above described. Overlying the pathways 20A is a conventional solder mask 101 which may leave selected areas of the pathways 20 for electrical connection to circuit elements or other pathways as may be desired. Note that the printed circuit device of FIG. 12 mounted on a solid support 10 of dielectric base or board can have any numbers of layers of pathways lying in different planes as desired. In each case, the layers of pathways are preferably formed by building up on a transfer sheet as described in the previous paragraph, although in some cases the multi-layer circuits can be built up directly on the substrate. For example, a transfer sheet having a single planar layer of pathways can be used to form a first layer of pathways as shown in FIG. 12. A dielectric ink mask 100 can then be

applied directly to the pathways on the substrate and a second preformed transfer sheet having pathways 20A with protruding electrical connection portions used to form the second layer of pathways as shown in FIG. 12. The method of forming the plural layers on the transfer sheet is preferred for use. The pathway, adhesive, dielectric base as used in FIG. 12 are as described above with respect to the same numbered components. The pathways 20 in the multilayer printed circuit board 104 shown in FIG. 12 are in compacted form after pressing and heating and could be illustrated as number 12 of FIG. 5 which is another representative showing of the cross section.

Note that FIG. 12 at its left hand end shows an electric circuit pathway 20B formed in accordance with this invention from a highly-metal particle loaded ink and extending with two planar portions 20C-20D at angles to each other in different planes. Effectively conductive pathway 20B extends from a top surface of the substrate or printed circuit board 10 over an edge thereof and onto the surface of a side thereof. Thus a three dimensional circuit pathway is provided extending in planes at angles to each other. This can be done by the use of the transfer sheets of this invention merely folding the sheets over the edge of the circuit board when applying heat and pressure to adhere the conductive pathways to the substrate.

Thus the transfer sheets of this invention provide for formation of three dimensional conductive circuits in a variety of forms.

Many variations to the aforedescribed multi layer electrical circuits are included herein. The masking layer may be a thermosetting resin which is partially cured and then cured when the assembly is heated under pressure. Further, three dimensional multi-layer electrical circuits are included herein. Since the dielectric surface onto which the circuit is printed may be flexible, it may be applied as an interlayer such that a border of it exists beyond the confines of the cured composite device. The border could thereafter be masked leaving contact points with the exposed circuit thereon, and by the technique of this invention, the border can be integrated with another circuit device thereby achieving the most complex integrated circuitry.

SOLDERING STANDARD TEST

This test defines three (3) criteria by which to determine the soldering capabilities of a printed circuit element. The test involves (A) a determination of solder wettability of the circuit element, (B) the pull (tensile) strength of the circuit element (i.e., measure of adhesion to the

dielectric surface) and (C) the electrical conductivity of the circuit element. A printed circuit article satisfies the Soldering Standard Test as herein set forth if it satisfies the wettability, pull strength and conductivity values set forth in A, B and C below, respectively.

A. With respect to the soldering wettability, this can be determined on a Meniscograph model no. 201344, or its equivalent (manufactured by Hollis Engineering, 15 Charron Avenue, Nashua, New Hampshire U.S.A.).

The Meniscograph monitors the solder-to-circuit wetting process from beginning to end by measuring the net force acting between specimen and solder. When recorded as a function of time it displays the time to commence wetting, the rate of wetting, the time to reach equilibrium, and the ultimate extent of wetting.

It operates on the principle that when a specimen is partially immersed in molten solder, a downward meniscus is formed against the specimen surface while it remains unwetted. At this stage the specimen suffers a hydrostatic upthrust, or loss in weight equal to the weight of solder displaced. This is the maximum buoyancy point. As wetting takes place, the contact angle decreases and solder moves up the sides of the specimen producing a

gradually increasing downward force. When the weight of the specimen is continuously monitored, the change in forces, and hence the progress of wetting, can be observed. In the Meniscograph, this is achieved by suspending the specimen from a load cell, adjusting the system to obtain zero net force (weight) reading at the start of a test, and raising a solder bath until the specimen is immersed to a predetermined depth. The upthrust and wetting forces are converted to electrical signals by the load cell and fed out for recording as a function of time to either a chart recorder or oscilloscope.

The read-out signal from the Meniscograph results from deflection of the cantilever spring system in the mechanism's load cell caused by any change in the forces acting on the specimen. At the start of each test the weight of the specimen is cancelled by the zero adjustment, therefore the only forces which need to be considered are those due to the surface tension of the molten solder acting on the specimen and the upthrust due to the weight of solder displaced by the specimen on immersion. Until wetting commences, the surface tension forces cause a downward meniscus to form and thus increase the apparent upthrust signal. As wetting proceeds, the direction in which the surface tension forces act changes with the changing angle of contact.

Eventually with an upward meniscus the forces on the specimen act downwards, i.e., are opposite in sign to the upthrust signal. When an equilibrium wetting condition has been reached the vertical component of the surface tension force acting on unit length of the specimen-solder interface maximum is $\gamma \cos \theta$ where $\gamma$ is the surface tension force and $\theta$ is the angle of contact. Since the depth of immersion is set by the bath lift mechanism the upthrust force can be calculated from the geometry of the specimen and the density of the molten solder. The Meniscograph calibration is normally set to produce a signal of 50 mv for an applied load of 1 gm force. i.e. a signal of E millivolts indicates an applied force of E/50 gm weight (i.e. E/50 g dynes, where g is the gravitational constant). This measured force balances the resolved surface tension force $\gamma$ less the weight of solder displaced, i.e., $E/50\ g = \gamma \cos \theta\ l - Vp$ where l is the length of the interface between specimen and solder, V is the volume of the specimen immersed in the solder, and p is the density of the solder at the test temperature.

All of these factors are known, or can be measured, except $\gamma$ and the angle of contact. It is therefore necessary to assume one in order to derive the other.

A favorable soldering wettability, i.e., a

product which has a wettability value which satisfies A, is the exhibiting in employing a Meniscograph, of a positive slope, i.e., increasing force with increasing time, starting at the nadir of the plot (the maximum bouyancy point) continuing positive or zero, i.e., constant force over increasing time, until completion of the test, which desirably for this invention shall be eight (8) seconds for 215°C tests and five (5) seconds for 260°C tests. Determination of the sign of the slope shall be based on the beginning and end point readings of any 0.5 second interval on the plot line. In the practice of this invention the absolute value between the nadir and the peak of the curve (assuming a positive force) shall be a minimum of 0.8 grams.

The specimen used for the wettability test should employ a plastic substrate having the following dimensions:

| | |
|---|---|
| Width: | 0.750" + .010" |
| Thickness: | 0.62" + .003" (excluding circuit element) |
| Height: | 1.80" + .10" |

The two faces of the plastic should contain fully coated circuitry element thereon.

The test specimen insertion depth is 3 mm, the temperatures are 215°C (to simulate vapor phase

solder wettability) or 260°C (to simulate wave solder wettability), solder -- Sn 60/Pb 40

The procedure involves preparing the specimen with an appropriate flux (viz., Kester 1429, etc.) thereon and install it on the force transducer holder. Calibrate an X-Y recorder to sensitivities of 200 milligrams per inch on the Y axis, and 1 second per inch on the X axis. Set the timer for 10 seconds and perform the tests. The entire wetting (and dewetting) event must be recorded. Wetting is defined as a positive slope, i.e. increasing force with increasing time on the curve. Dewetting is defined as a negative slope, i.e., decreasing force with increasing time on the curve.

For a further discussion on solder wettability, reference is made to Coombs, "Printed Circuits Handbook", 2nd Ed., 1979, pp. 14-5 to 14-8, and 19-24 and 19-25, published by McGraw-Hill Book Company, New York, N.Y.

B. With respect to the pull strength of the circuit element, it should be a minimum value of 700 p.s.i. (pounds per square inch) pull for the plated circuit element in order to satisfy the requirements of pull strength for this test. In this regard, the test is not the peel strength test, see Coombs, <u>supra</u>, page 19-23, but a test similar to it. This procedure measures the tensile strength of the bond of an electroless Ni plated circuit element (as

described in the plateability section herein) and measures ultimately either adhesive or cohesive failure of the composite.

The specimen consists of a plastic substrate layer (coupon) having dimensions: thickness $>$0.06 inch; length $>$0.75 inch; width $>$0.75 inch; upon which a layer of adhesive equal or greater than 0.3 inch diameter by a prescribed thickness, is attached. A layer of ink 0.250 $\pm$ .005 diameter by a prescribed thickness is applied next. The ink is then electroless Ni plated to a prescribed thickness. A length of bare copper wire 16 ga. (0.05 dia.) by 2 inches long is soldered perpendicularly to the top layer using Sn 60 or Sn solder Type S or flux cored type K or RMA conforming to QQL-S-571 which is applied in a conical configuration about the centrally located wire to bond it to the Ni plate.

The specimen is mounted on a flat base plate (1/8" min. steel or 1/4" min. aluminum). A top cover plate (1/8" min. steel or 1/4" min. aluminum) having a 0.3 to 0.5 inch diameter hole, capable of clamping the specimen in compression and allowing the wire/solder to be located in the center of the hole is fixed over the specimen. Attachment of a tensile test machine and the wire of the specimen adaptable to the top attachment (grip) of

the machine. The test machine (Instron model 1130 made by Instron Corp. of Canton, MA.) has a constant velocity capability of 1 inch/minute $\pm$ 2% pull and a force capability of 100 lbs. full scale, and 10 lbs. full scale, with a force sensitivity of $\pm$ 1% of full scale. A chart recorder of similar sensitivity shall be used for data acquisition.

The specimen is mounted securely between the base and cover plates, with the wire vertical and in line with the test machine pull axis. The wire is installed into the grip of the test machine, making sure there is no residual force on the wire. The recorder is calibrated to zero and then start the pull at 1 inch/minute. Record the force at failure.

C. With respect to electrical conductivity of the circuit element (unplated or electroless Ni plated), it is measured as a maximum surface resistivity. In order to satisfy this test unplated circuit elements must have a surface resistivity value of no higher than 0.1 ohm per square and plated circuit elements must have a surface resistivity value of no higher than 50 milliohmns per square. However, useful unplated circuits can be made in accordance with this invention which have maximum surface resistivities up to .5 ohms per square although the preferred

range is from 0.1 ohms per square to 0.01 ohms per square.The procedure followed is described herein and the surface resistivity shall be determined in accordance with method 4041 of FED-STD-406.

The specimen contains any otherwise acceptable dielectric plastic substrate having a surface area adequate to contain the circuit geometry of two .25" diameter end points and a "65 square" simple line (.07" wide x 4.55" long). The circuit end points have wires soldered in the manner described for the pull test. The two circuit end points are probed on the wires at a distance of 0.2 inch above the board surface and the measurement is recorded.

PLATEABILITY STANDARD TEST

This test defines the criteria by which the capability to apply, adhere and maintain adhesion of electroless nickel plating to the printed circuit is determined.

(Note: This is not a plating standard test which would define quality, quantity and process control related yield values.)

In the Plateability Standard Test, a plastic board substrate, having additive lines each distinct physically and electrically separated from

each other, is prepared for the electroless plating process using (Enthone Ni 418 manufactured by Enthone, Inc., West Hartford, Connecticut, U.S.A.) at 90$^{o}$C for 45 minutes. The board is a 4 x 4 inch size and carries printed circuit lines of this invention in a pattern of two series of 112 lines, 0.5 cm length, one series 0.008 inch wide and the other series 0.025 inch wide.

A value satisfying the Plateability Standard Test is defined inclusively as:

1. 100% coverage of any distinct line which accepts the plating, (as determined by a 10 x magnification visual examination).

2. no less than 80% of the lines must accept plating.

In addition to passing the test values above, the most preferred products of this invention have the following features:

1. Substantially all lines that accept plating are free of blisters and cracks (as determined by 10 x magnification visual inspection), and

2. Substantially all lines that accept plating adhere and maintain the plating as determined by an adhesion peel test per I.P.C. Test Methods Manual Method Number 2.4.1., in which no plating may separate

from the printed circuit interface. This test is performed both before and after submission to a salt spray environment per ASTM B-117 (5% neutral salt spray at 95$^{O}$F for 72 hours).

## EXAMPLES

The following Examples serve to give specific illustration of the practice of this invention but they are not intended in any way to act to limit the scope of this invention.

### Example 1

The following ingredients were blended together at room temperature:

(I) 3 percent by weight of an epoxy novolak resin having an average of 3.6 oxirane groups per molecule, having a viscosity in the range of 1100 to 1700 centipoise (at 52°C). Its epoxy equivalent was in the range of 172 to 179. The average value of repeat units was 0.2, (D.E.N.431-obtained from Dow Chemical Co., Midland, Michigan), and

1C367/734
SS*f



(II) 2 percent by weight of poly(vinyl formal) resin having a molecular weight of 10,000 to 15,000 and a solution viscosity of 100 to 200 centipoise (measured as 15% by weight in a 4:1 solution of dibasic ester[1]: N-methyl pyrrolidine at 25°C). Formvar 5/59 is obtained from Monsanto Plastic & Resins Co., St. Louis, Missouri.

(III) 0.0005% by weight of trifluoro methane-sulfonic acid having a pH of 4 to 6.5.

To this mixture was added the following ingredients.

(I) 25% by weight of silver having a particle size of 2 to 12 microns, an apparent density of 21.5 to 23.5 g/in$^3$, a tap density of 1.5 to 2.5 g/in$^3$ and a weight loss at 1000°F of approximately 1%, and

---

1 an ester mixture of 23 weight percent dimethyl succinate,
56% dimethyl glutarate,
21 weight percent dimethyl adipate.

(II) 70.0% by weight of nickel powder which is about 100% spherical, having an average particle size of 12 microns and an apparent density of 56.8% $g/in^3$.

This mixture was stirred at room temperature until completely homogenized and then put through a three roll mill for two passes with the back roller at 4 to 6 mi' and the front roller at 1 to 3 mil.

This conductive ink was screen printed (U. S. Sieve size 250), using conventional techniques, onto VNS Supermat release paper (obtained from S. D. Warren Co., Westbrook, Maine) to a thickness of approximately 1 mil after drying.

The printed paper was dried in a convective air oven at 330°F for five minutes.

A substrate was molded from a composition containing 26.4 weight percent of a polysulfone of the following formula:

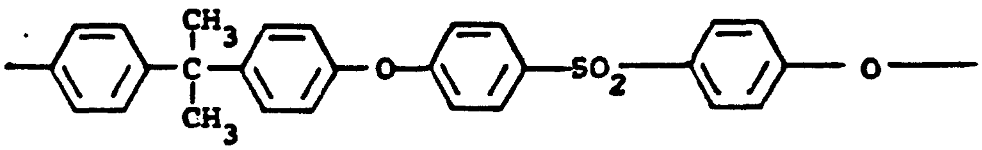

(P-3703 obtained from Union Carbide Corporation having a reduced viscosity of 0.51 as measured in chloroform at 25°C, 0.2 gr/100 ml), 40 weight percent of a polymer containing the following unit:

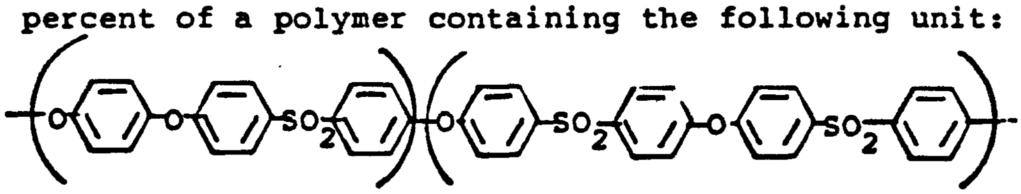

having a reduced viscosity of 0.61 dl/g as measured in N-methyl-pyrrolidinone (0.2 g/100 ml) at 25°C. 15 weight percent of 1/2 inch chopped glass fibers (197B obtained from Owens Corning), and 16.6 weight percent of wollastonite having a particle size of about 10 microns (Nyad 1250 obtained from Nyco, a Division of Process Minerals, Inc.).

The substrate composition was compression molded at 300°C in a 4x4x0.20 inch cavity mold using a hydraulic press to form a sheet of that dimension.

The substrate sheet was immersed in a 50% aqueous solution of dimethylformamide solvent for 5 minutes at 25°C. The substrate was then rinsed in water at 25°C. The substrate was then immersed in a chromic acid solution containing the following ingredients (number value is parts by weight):

30 deionized water

3.0 chromium trioxide

10.0 85-87% phosphoric acid

55.9 96% sulfuric acid

for 5 minutes at 80°C.

The substrate was then rinsed in water at 25°C and dried for 10 minutes at 100°C.

Separately, a two part adhesive containing the following ingredients was prepared:

<u>Part A</u>

(I) 11.41 parts by weight of an epoxy resin derived from epichlorohydrin and bisphenol A (Epon 1009F obtained from Shell Chemical Co.),

(II) 40.88 parts by weight of a saturated polyester having an average equivalent weight of 260, a hydroxy content of 6.5%, a maximum acid number of 4.0, an approximate specific gravity of 1.12 at 25°C (Desmophen 1100 obtained from Mobay Chemical Corporation, Pittsburgh, PA.), and

(III) 0.068 parts by weight of a nonionic surfactant which is a liquid fluorinated alkyl ester (FC-430 obtained from 3M Corporation).

Part B

47.67 parts by weight of polytoluene diisocyanate, containing 6 to 7% free monomer (CB-60 obtained from Mobay Chemical Co.).

Parts A and B were then mixed together. A solvent containing isopropanol and methylethylketone (in a ratio of 3/2) was added to obtain a viscosity of 18 seconds Zhan cup No. 2 at 25°C.

The prepared adhesive was sprayed onto the treated substrate sheet. Then the adhesive coated substrate was placed in a convective oven at 149°C for 5 minutes until the adhesive coat was dry but not fully cured. The printed release paper formed above was contacted with the adhesive coated substrate such that the printed surface contacted the adhesive surface of the substrate sheet, and then laminated at a pressure of 200 psi for 30 seconds at 166°C. The paper was then stripped away from the assembly. The substrate was then heated at 166°C for 30 minutes in a convective oven to assure

final cure.

The printed substrate was then pretreated with a 6% solution of sulfuric acid for 5 minutes at 65°C. The substrate was rinsed with water and treated with a 2% solution of sodium borohydride and sodium hydroxide in 1:1 proportion for 30 seconds at 40°C.

The printed substrate was nickel plated to deposit a nickel plate onto the exposed ink surface in an electroless plating bath (Ni-418, Ethone) at 88°C, using a pH of 4.8-5.2, and a plating time of 60 minutes.

## Example 2

The procedure of Example 1 was repeated except that the adhesive was a one part system which contained the following ingredients:

(I) 56.17 parts by weight of a polyvinylformal resin (Formvar 5/95E obtained from Monsanto Plastics & Resins Co.) in a 4/1 solution of dibasic ester (see footnote p. 159) /n-methyl-2-pyrrolidone.

Crosslinker

(a) 33.7 parts by weight of a phenol blocked toluene diisocyanate in cellosolve acetate, (Mondur S obtained from Mobay Chemical Co.)

(b) 4.21 parts by weight of hexamethyl ether of hexamethyol melamine (Cymel 303,

100% solids, obtained from American Cyanamid),

(c) 5.6 parts by weight of the allyl ether of a phenol formaldehyde resin (Methylon 75108, 100% solids, obtained from General Electric Co.), and

(d) 0.28 parts by weight of a dimethyl silicone oil (DC-11 obtained from the Dow Chemical Co.).

All of the above ingredients were mixed together at room temperature. A solvent containing a 4/1 solution of dibasic ester (see footnote p. 118)/n-methyl-2- pyrolidone was used to obtain a viscosity of 38 seconds at Zhan Cup. No. 2 and 25°C.

The adhesive was then open screen (screen mesh) printed on the release paper and dried in a convective oven at 200°F for 2 minutes. The release paper was then laminated on the substrate as described in Example 1 and then heated at 350°F for 30 minutes in a convective oven.

The substrate was pretreated and plated by the procedure described in Example 1.

Although the adhesive layer is described as positioned on the dielectric surface, if desired it can be applied instead to the ink outer or free surface when the ink is on the release surface.

Then the release surface mounts the conductive pattern and the adhesive layer for transfer to the dielectric surface. Preferably the adhesive used here is a one component thermosetting adhesive.

Example 3

This Example describes the preparation of a two layer circuit board.

The substrate and adhesive, of example 1, and prepared all according to the procedure described in Example 1 was employed.

The following solder mask is prepared:

Part A

1. 26.88 parts by weight of an epoxy Novolak resin having an average of 3.6 oxirane groups per molecule, epoxy equivalent (172-179) and n=0.2.

2. 1.12 parts by weight of ethylacrylate and 2-ethylhexylacrylate copolymer as resin modifier.

3. 5.56 parts by weight of butylated urea-formaldehyde resin, containing 60% solid in butanol. (Beetle resin produced by American Cyanamid of Stamford, Connecticut).

4. 46.07 parts by weight of high purity titanium dioxide pigment (Titanox 1070LW produced by E. I. DuPont deNemours of Wilmington, Delaware)

Part B

1. 5.56 parts by weight of polyamide (product of dimerized tall oil fatty (T.O.F.) acid reaction with ethylendiamine) with amine value of 345, e.g. Versamid 125, produced by Henkel of America of New York, New York.

2. 12.96 parts by weight of 4:1 dibasic ester (see footnote page 159): N-2-methylpyrrolidone solvent.

Parts A and B were mixed at room temperature.

The dielectric solder mask was screened onto the release carrier and dried in a convection oven for 1 minute at 166°C. The ink of Example 1 was screened in registration with the dielectric solder mask pattern and dried in a convection oven for 2 minutes at 166°C. The dielectric solder mask was screened in registration with the ink pattern and dried in a convection oven for 1 minute at 166°C. This step was repeated, resulting in a double layer of a dielectric solder mask. The partially completed sub-assembly was compressed at 21°C for 30 seconds, at a compressive pressure of 1000 psi.

The ink of Example 1 was screened in registration with the other layer of ink and layers of dielectric solder mask and the assembly dried in

a convection oven for 3 minutes at 166°C, completing the sub-assembly.

The sub-assembly was then transferred from the release carrier to the adhesive coated substrate at a temperature of 166°C and a compressive pressure of 500 psi for 30 seconds initiating an adhesion between the ink, adhesive and substrate. The release carrier was then stripped from the assembly and post cured at 166°C for 30 minutes in a convective oven.

The same result can be achieved by placing the adhesive over the subassembly on the release carrier rather than placing the adhesive on the substrate.

## Example 4

A slurry for making an electrically conductive pathway is prepared as follows from the following ingredients (parts by weight):

| Item | Material |
|---|---|
| 1. | Polyvinyl formal resin (FORMVAR brand No. 15/95E)<br>13.75% in N-methyl-2 pyrolidone (Monsanto)<br>Net weight 14.38; dry weight 1.97 |
| 2. | Epoxy NOVOLAC (100%) DEN 431 Dow Chemical<br>wet and dry weight 3.0 |

3. Silflake 135; wet and dry weight 25

4. Nickel powder; wet and dry weight 60

5. Tin 266; wet and dry weight 10

6. Diacetone alcohol; wet weight 10

Step I:

The items 1, 4 and 5 and three parts of item 6 are stirred together and two passes are made through a three roll mill to make a homogenous mixture.

Step II:

Thereafter items 2 and 3 and 1.5 parts of item 6 are stirred and the resulting material is passed twice through a three roll mill to make a homogenous mixture.

Step III:

The mixtures from steps I and II are combined in a three roll mill until a homogenous mixture is formed.

Step IV:

5.5 parts of item 6 are added to the product of Step III for screening or brushing on the substrate on top of the adhesive. The adhesive and screened on pathways are both cured at a temperature of 170°C for 45 minutes in an oven.

Example 5

The procedure of Example 1 was repeated except that the conductive ink contained the following ingredients:

A. 4.137% by weight (20.55% by volume) of a thermoplastic polyester based polyurethane derived from the reaction of a hydroxy terminated polytetramethylene adipate oligomer, 1,4 butane diol and 4,4-diisocyanate diphenylmethane (Estane 5715 obtained from B. F. Goodrich),

B. 0.085 % by weight (4.85% by volume) of a phenol blocked toluene diisocyanate in cellosolve solvent (Mondur S obtained from Mobay Chemical),

C. 0.05% by weight (0.30% by volume) of FC-430 (described above), and

D. 16% by weight of hydroxyethyl cellulose in ethanol (0.05% by weight).

These ingredients were blended together and the following added thereto:

E. 22% by weight (13.22 by volume) silver having particle size 2-15 μm average 12μ with apparent density of 21.5 - 23.5 gm/inch$^3$, tap density 1.5-2.5 gm/inch$^3$ and weight loss at 1000°F ≃1% (Silflake obtained from Handy and Harmon Chemical Products Center).

F. 73% by weight (60.76 by volume) of powdered tin (Tin 266 obtained from Atlantic

Equipment Engineering, Bergenfield, New Jersey) having particle size of 2-5$\mu$m and specific gravity of 7.28 gm/cc.

The procedure of Example 1 was repeated except that after being screened onto the paper the ink was dried for 10 minutes at 60°C. (hereinafter Is). Also the printed release paper was laminated to the substrate at a pressure of 200 psi for 3 minutes at 121°C (hereinafter Ip) and then transferred at a pressure of 200 psi for 4 minutes at 149°C.

Examples 6 to 10

The procedure of Example 5 was exactly repeated except that the amount of silver was varied in the formulation as shown in Table I. The total amount of filler was kept at 95% by weight (73.98% by volume) for all of the formulations. This table illustrates that higher amounts of silver have to be used to obtain similar surface resistivity if the transfer process of this invention is not used.

TABLE I

| Example | Silver (%) | Thickness in mills $I_s$ | Thickness in mills $I_p$ | $I_s$ Surface Resistivity After Screening (ohm/sq.) | $V_s$ Volume Resistivity After Screening (micro ohm/cm) | $I_p$ Surface Resistivity After Pressing (ohm/sq.) | $V_s$ Volume Resistivity After Pressing (micro ohm/cm) | $I_p/I_s$ | $V_s/V_p$ |
|---|---|---|---|---|---|---|---|---|---|
| 6 | 15 | 1.83 | 1.44 | 1.07 | 5091 | 0.91 | 340.7 | 11.7 | 14.9 |
| 7 | 20 | 1.1 | 0.92 | 0.33 | 943.8 | 0.051 | 120 | 6.4 | 7.8 |
| 8 | 30 | 1.5 | 0.90 | 0.32 | 1250 | 0.038 | 88 | 8.4 | 12.2 |
| 9 | 40 | 1.25 | 0.90 | 0.135 | 438.75 | 0.020 | 46.8 | 6.75 | 9.4 |
| 10 | 50 | 1.0 | 0.90 | 0.09 | 234 | 0.010 | 23.4 | 9 | 10.0 |

S = screen

P = pressen

I = surface resistivity

V = volume resistivity

It may appear from the above specification and considering the appended Claims, that some additional features can be summed up as follows :

(i) A print transfer article of claim 1 wherein the thermosetting resin comprises a mixed resin composition of a crosslinkable resin and a thermoplastic resin possessing functionally reactive groups capable of reacting with functionally reactive groups in the crosslinkable resin.

(ii) The article of point (i) wherein the crosslinkable resin is an epoxy resin and the thermoplastic resin comprises a functionally reactive group capable of reacting with vicinal epoxy groups or the product of the reaction of vicinal epoxy.

(iii) The article of point (i) wherein the crosslinkable resin and the thermoplastic resin are compatible.

IV. The article of claim 1 wherein the thermosetting resin is uncured.

V. The article of claim 1 wherein the solid release surface is a release paper.

VI. The article of claim 1 wherein the solid release surface is a plastic film.

VII. The article of claim 1 wherein the solid release surface is a rigid release surface.

VIII. The article of claim 2 wherein said layer of reactive adhesive is provided and said electric circuit element after transfer utilizing said reactive adhesive satisfies the Soldering Standard Test.

IX. The article of point VIII wherein said metal particles are present in an amount of about 94 to 98 percent by weight of (b) and said electric circuit element after transfer satisfies the Plateability Standard Test.

X. The article of point IX wherein the precious metal is at least one of silver, gold, platinum, palladium, rhodium, and ruthenium.

XI. The article of point IX wherein at least 20 weight percent of the metal particles contain precious metal.

XII. The article of point VIII wherein the metal particles comprise at least one of the metals from Groups 5b, 6b, 7b, 8, 1b, 2b, and 3b of the Periodic Table of the elements.

XIII. The article of point XII wherein the metal particles contain a mixture of metals.

1C367/734
SS*f



XIV. The article of point XIII wherein the mixture of metal particles contains silver and nickel.

XV. The article of point XI wherein the particle size of the metal particles is such that all pass through a 100 mesh screen and are retained on a 350 mesh screen.

XVI. The article of point IX wherein said metal particles are a mixture of a major amount of nickel particles and a minor amount of silver particles.

XVII. The article of claim 1 wherein the metal particles concentrate to a greater degree in the portion of the layer of the thermosetting resin composition in contact with the solid release surface.

XVIII. The article of point XVI wherein the adhesive is provided over the thermosetting resin composition and is selected to adhere to polysulfone materials.

XIX. The article of point XVIII wherein the adhesive contains functionally reactive groups therein which have the capability of reacting with and becoming bonded to the thermosetting resin composition.

1C367/734
SS*f

XX. The article of point XVI wherein the adhesive is capable of interreacting with the thermosetting resin composition to become cured therewith and form a composite structure.

XXI. The article of point XX wherein a further layer of an adhesive is provided over the composite structure.

XXII. The article of points XVIII and XIX wherein the adhesive contains blocked isocyanate groups therein.

XXIII. The printing ink of claim 3 wherein said metal particles comprise noble and non-noble particles and said ink on compacting and curing satisfies the Plateability Standard Test.

XXIV. The process of claim 6 wherein said film is compacted by at least 25 percent, and said electrical circuit holds its shape and electrical properties when subjected to temperature of 260° F for 20 seconds.

XXV. The process of claim 4 wherein the thermosetting resin is partially cured prior to any contact with the adhesive resin.

XXVI. The process of claim 4 wherein the amount of metal particles in the thermosetting resin composition comprises from about 94 weight percent thereof up to to about 98 weight percent thereof.

XXVII. The process of claim 6 wherein the resultant electrical circuit satisfies the Plateability Standard Test and the Soldering Standard Test.

XXVIII. The process of claims 4, 5 or 6 wherein the metal content concentrates to a greater degree in the portion of the thermosetting composition in contact with the release surface than the other portion of the composition.

XXIX. The process of claim 4 wherein a masking layer of a thermosetting resin is applied over a portion of the electrical circuit of the composite structure.

XXX. The process of point XXIX wherein a further electrical circuit is supplied to the surface of the masking layer by application of steps (1), (2), (4), (5), (6) and (7) in which the masking layer and any non-masked portion thereof constitutes the dielectric surface for deposition purposes.

XXXI. Tne process of point XXX wherein another masking layer according to the process of claim 33 is applied over the resulting treated composite of claim 34.

XXXII. The process of claim 6 and further comprising plating said electric curcuit with an electrically conductive metal.

XXXIII. The processes of point XXXII wherein the composite is exposed to vapor phase reflow to leave solder on the circuit.

XXXIV. The processes of claim 4 and further comprising plating said electric circuit with an electrically conductive metal.

XXXV The process of claim 4 wherein the dielectric surface is a nonconductive plastic comprising one or more of a polyarylethersulfone, a poly(aryl ether), polyarylate, polyetherimide, polyester, aromatic polycarbonate, styrene resin, poly(aryl acrylate), polyhydroxyether, poly(arylene sulfide), polyamide, and plastics which are reinforced with fillers and/or fibers.

XXXVI. A printed circuit article in accordance with claim 7 wherein said circuit element has a surface resistivity of from 0.1 to 0.01 ohms per square and holds its shape when exposed to temperature of 260°F for 20 seconds.

XXXVII. The printed circuit article of claim 7 wherein the metal content concentrates to a greater degree in the portion of the layer (b) contiguous to an upper surface thereof.

XXXVIII. The printed circuit article of point XXXVII wherein the metal particles contain precious metal.

XXXIX. The printed circuit article of point XXXVIII wherein the precious metal is silver.

XL. The printed circuit article of point XXXIX wherein the metal particles contain at least 20 weight percent precious metal.

XLI. The printed circuit article of point XXXIX wherein one metal is silver and another metal is nickel.

XLII. The printed circuit article of claim 7 wherein the layer (b) had been compacted during the thermosetting thereof.

XLIII. The printed circuit article of claim 7 wherein a layer of a thermosetting resin is adhesively bonded to said surface of layer (b).

XLIV. The printed circuit article of point XLIII wherein solder is provided on at least a portion of the upper surface of layer (b).

XLV A printed circuit article in accordance with claim 7 and further comprising a second layer comprising a thermoset resin and conductive metal particles as in (b) overlying said first layer and separated therefrom at selected areas by dielectric material to form a multilayer printed circuit article.

XLVI. A printed circuit article in accordance with point XLV wherein said first and second layers are electrically interconnected at other selected areas.

XLVII. A print transfer composition as defined in claim 11 wherein the coated release surface is sufficiently tack free to allow stacking of the surfaces with the coating thereon without deleteriously altering the coating.

XLVIII. A print transfer composition in accordance with claim 11 wherein said electric circuit satisfies the Plateability Standard Test when transferred.

XLIX. The system according to claim 14 in which the substrate is a plastic substrate and the pathways are in the form of a circuit pattern.

L. The system of claim 14 in which the pathway has a film of solder thereon on a surface thereof opposite said substrate.

LI. The system of claim 14 in which there is a metal layer on said pathway.

LII The system of point LI in which the metal layer is nickel.

LIII. The system of claim 14 wherein said pathways satisfy the Soldering Standard Test and the Plateability Standard Test.

LIV. A system comprising a dielectric material, a plurality of electrically conductive pathways supported thereby, said conductive pathways comprising between 93 to 98% metal particles with no less than 15% thereof being silver and a film of solder over the surface of said pathways opposite said dielectric material.

LV The system of point LIV in which a plated nickel layer is on said pathway between said solder and said pathway.

LVI The system of point LV in which an adhesive is positioned between said pathways and said material.

LVII The method of claim 15 in which the pattern is compacted prior to or after covering the powdered metal and binder with the adhesive.

LVIII The method of claim 15 in which the slurry includes an amount of silver which is less than about 50 per cent by weight of the solids in the slurry.

LIX The method of point LVII in which the powdered metal includes fluxing lubricants.

LX. The method of claim 15 wherein said plastic substrate comprisies a polysulfone.

LXI. The method of claim 15 in which the circuit pattern comprises greater than about 93 per cent to about 98 per cent by weight of metal powder and said pattern after lamination has a substantially uniform thickness which does not vary by more than ± 5 microns.

LXII The method of claim 15 in which a curable adhesive is used and in which the adhesive is cured in step (d).

LXIII. The circuit transfer system of claim 15 wherein the adhesive and a binder of the circuit pattern are partially cured prior to step (d) and then fully cured in step (d).

LXIV The system of claim 16 in which the metal powder is compacted.

LXV. The system of claim 17 in which the noble metal is silver flake and the non-noble metal is nickel and nickel and tin.

LXVI. The system according to claim 17 in which the pathway is bonded to the substrate by an adhesive.

LXVII The system according to claim 16 in which the non-noble metal comprises tin in an amount of 2 to 15 per cent by weight and the nickel in an amount of 30 to 75 per cent by weight of the total weight of the pathway.

LXVIII. The system according to claim 18 in which an adhesive bonds the pathway to the dielectric substrate.

LXIX. The pathway of claim 18 in which the total amount of metal particulate in the pathway comprises 80 to 98 per cent by weight of the pathway with silver being 15 to 50 per cent, tin being 2 to 15 per cent and the nickel being 30 to 75 per cent.

LXX. An electrical system comprising a dielectric substrate and a compacted electrically conductive pathway comprising 90 to 98 percent particulate by weight of the pathway and which contains by weight 15 to 50 per cent of noble metal in the pathway with the remainder non-noble metal and/or inert particles and an organic binder, the thickness of the compacted pathway varying not more than $\pm 5$ microns and having a surface resistivity below 0.1 ohms/sq.

LXXI. A print transfer article in accordance with claim 1 and further comprising over layer (b) and under layer (c) if present,

at least one further layer in accordance with layer b and spaced from layer (b) and acting as a further electric circuit element useful to form multi-layer conductive circuit articles.

LXXII. A print transfer article in accordance with point LXXI wherein said further layer and first mentioned layer are in electrical contact at selected areas.

LXXIII. A print transfer article in accordance with claim 2 and further comprising over layer (b) and under layer (c) if present,

at least one further layer in accordance with layer b and spaced from layer (b) and acting as a further electric circuit element useful to form multi-layer conductive circuit articles.

LXXIV. A print transfer article in accordance with point LXXIII wherein a dielectric layer separates said further layer and first mentioned layer at selected areas.

LXXV. A print transfer composition in accordance with claim 4 further comprising a second pathway in the configuration of a second circuit element overlying and electrically separated at least at selected portions from said first pathway.

## CLAIMS

1. A print transfer article for use in making an electrically conductive circuit article and suitable for transferring a metal circuit to a dielectric solid support surface which comprises

(a) a solid release surface;

(b) a layer, in the form of at least an electric circuit element, deposited on the release surface containing a thermosetting resin composition which includes (i) a thermosetting resin and (ii) electrically conductive metal particles, wherein the amount of metal particles in the resin composition is from about 54 to about 87 percent of the volume fraction based on the volume of the dried layer; and <u>optionally</u>,

(c) a layer of a reactive adhesive provided over the thermosetting resin composition.

2. The article of claim 1 wherein the amount of metal particles in the resin composition is from about 68 to about 87 percent of the volume fraction based on the volume of the dried layer.

3. A printing ink comprising in admixture (i) a thermosetting resin in an amount of about 13 to about 32 percent volume fraction and (ii) an amount of electrically conductive metal particles from about 68 to about 87 percent volume fraction of the dried ink,

said ink being suitable for printing and on compacting and curing forming an electric circuit element satisfying the Soldering Standard Test.

1C367/734
SS*f



4. The process of forming a printed circuit article which comprises:

(1) providing a release surface;

(2) applying an ink comprising a thermosetting resin composition containing a desired amount of the electrically conductive metal particles to the release surface as a film (viz. pathway) in the configuration of at least an electric circuit element;

(3) providing a dielectric surface;

(4) providing a reactive adhesive interface capable of inter-acting with the thermosetting resin composition of (2) above and the dielectric surface;

(5) bringing together the release surface and the dielectric surface so that the film of electrical circuit element is facing the dielectric surface and is separated therefrom by the adhesive interface;

(6) applying sufficient heat and pressure to form a composite structure whereby the thermosetting resin is cured and the adhesive is inter-acted whereby the electrical circuit is transferred from the release surface to become effectively bonded to the dielectric surface

and providing an electrical circuit having a good platability by electroless plating technique.

5. The process of claim 4 wherein the release surface is removed from the composite structure and said resin and adhesive are fully cured in step 6.

6. The process of claim 4 wherein the volume fraction of metal particles is from about 68 to 87 percent and the volume fraction of thermosetting resin is from about 13 to 32 percent.

7. A printed circuit article comprising:

(a) a solid dielectric support surface having a surface; and

(b) a first layer or pathway on said surface and comprising a thermoset resin and electrically conductive metal particles, in the configuration of at least an electric circuit element,

said metal particles being present in an amount of from about 68 to about 87 percent by weight of the volume fraction based on the weight of the layer,

said electric circuit element having good plateability by electroless plating techniques.

8. A printed circuit article in accordance with claim 7 wherein said article satisfies the Soldering Standard Test.

9. A printed circuit article in accordance with claim 8 wherein said article satisfies the Platability Standard Test.

10. A printed circuit article in accordance with claim 7 wherein said first layer has a portion lying substantially in a first plane and a portion at an angle thereto extending over a portion of said support surface which is non-planar.

11. A print transfer composition comprising a solid release surface having coated thereon a pathway in the configuration of an electric circuit or a precursor to or an element of an electric circuit formed from a thermosetting resin composition comprising electrically conductive metal particles to satisfy the Soldering Standard Test when transferred and to provide at least an electric circuit or element of an electric circuit having a surface resistivity of below 0.1 ohm per square.

12. A print transfer composition as defined in claim 11 wherein the thermosetting resin has advanced by some degree of crosslinking.

13. A print transfer composition as defined in claim 11 wherein the thermosetting resin is essentially tack free.

14. An electrical system comprising:

(1) a dielectric substrate;

(2) electrically conductive pathways comprising 93 to 98% metal particles by weight of the pathway and a cured plastic;

(3) an adhesive holding said pathway to said substrate, said pathways being able to withstand 260°C for 20 seconds without appreciably changing their shape.

15. A low temperature method of forming a circuit pattern on a plastic substrate which comprises the steps of:

a) applying a slurry, comprising a vaporizable solvent, powdered metal and a small quantity of thermosetting binder in the shape of the circuit pattern desired to a removable layer;

b) vaporizing the solvent;

c) covering the powdered metal and binder with an adhesive layer to hold the powdered metal and carrier in place on the removable layer;

d) laminating the plastic substrate with pressure and heat to cause compacting of said powder and bonding of said compacted powder to said substrate by said adhesive layer, said heat being insufficient to destroy said adhesive, substrate and removable layer; and

e) separating the removable layer.

16. A circuit transfer system comprising a separatable layer, said layer having a circuit pattern of metal powder substantially free from organic material on a surface thereof and an adhesive overlying said circuit pattern and at least a portion of the layer.

17. An electrical system comprising a dielectric substrate and a compacted electrically conductive pathway comprising 90 to 98 per cent metal particulate by weight of the pathway and which contains by weight 15 to 50 per cent of noble metal in the pathway with the remainder non-noble metal and/or inert particles and an organic binder, the thickness of the compacted pathway varying not more than ± 5 microns and having a conductivity below 0.1 ohms/sq.

18. A system comprising a dielectric substrate supporting a compacted electrically conductive pathway comprising an organic binder having by weight 15 to 50 per cent silver particles with the remainder selected from nickel and tin particulate, the total of the particles in the pathway being 90 to 98 per cent, the pathway having substantially the same conductivity achievable when all silver particles are used.

19. The method of producing electrically conductive pathways on a dielectric substrate comprising compacting and heating a curable resin containing a noble metal, tin and nickel particulate to cure the same and compact the same to reduce the height thereof on the substrate by at least about 25 per cent from its initial height.

20. A printed circuit board comprising an insulating support surface carrying a conductive circuit pattern having an inner surface and outer surface with said circuit pattern inner surface adhered to said support surface by an organic adhesive layer,

said organic adhesive layer being a thermosetting organic adhesive,

said conductive circuit pattern having an organic thermosetting binder in an amount of about 32 to about 13% by volume of said pattern,

said adhesive and binder being stable at temperatures of up to at least 260°C for times of at least 20 seconds,

said pattern further comprised of conductive metal particles in an amount of from about 68 to about 87% by volume,

said conductive circuit pattern having a gradient of binder extending from surface to surface with more binder at said inner surface,

said circuit pattern having a surface resistivity of between 0.1 to 0.01 ohm/sq.,

said circuit pattern being,

a) capable of being electrolessly plated with nickel without surface activation,

b) repeatedly resolderable at a temperature of 260°C for 20 seconds,

c) having a high bond strength, and

d) being plattable and wettable with solder.

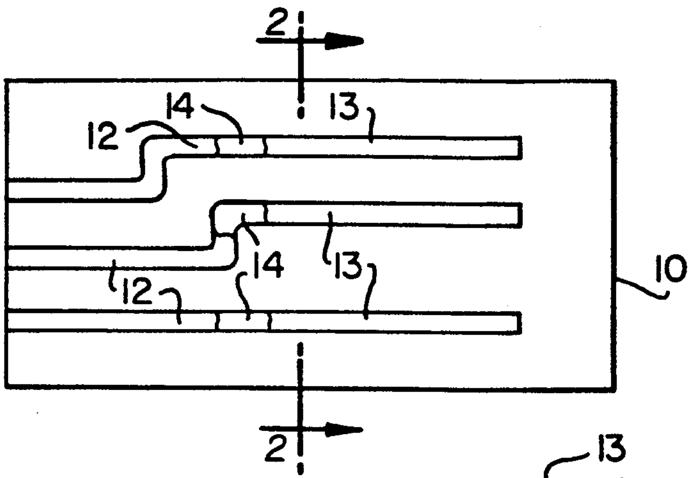


FIG. 1

FIG. 2

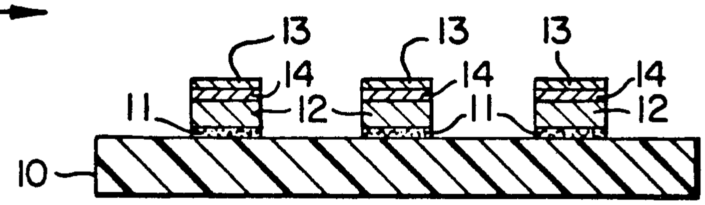


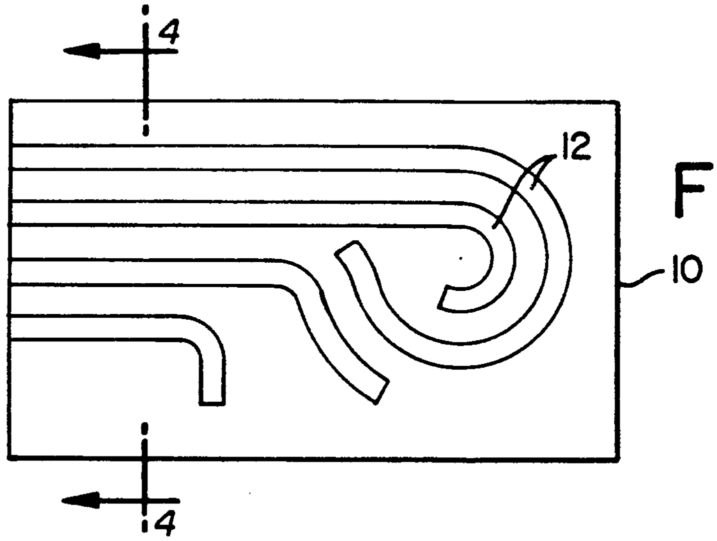


FIG. 3

FIG. 4

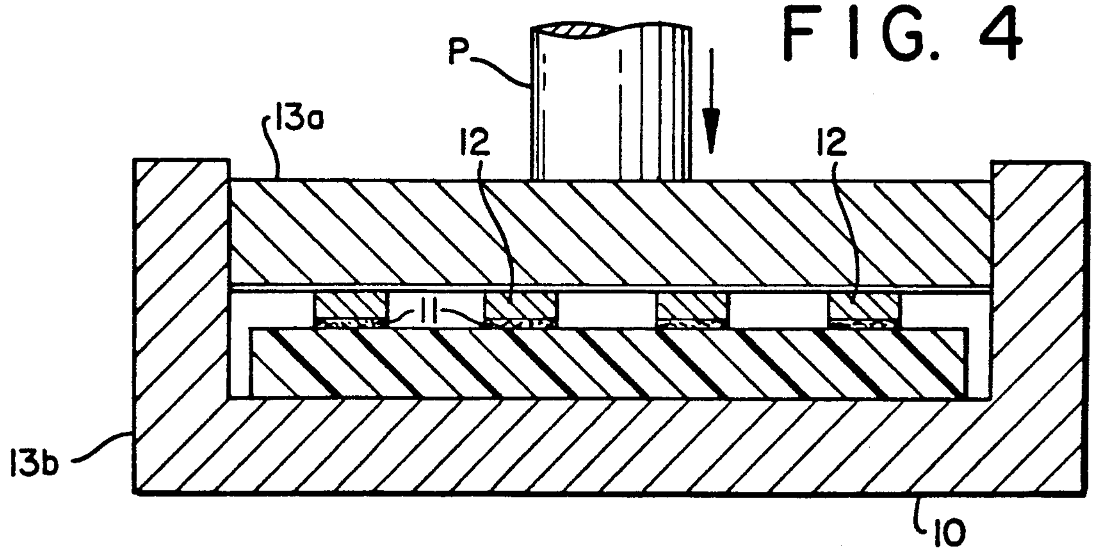

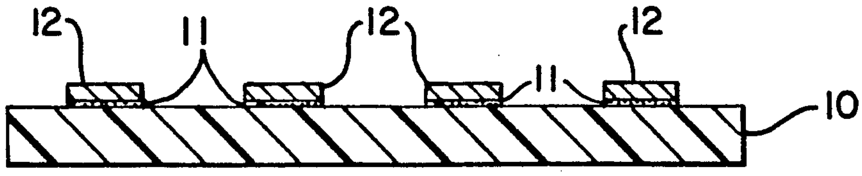


FIG. 5

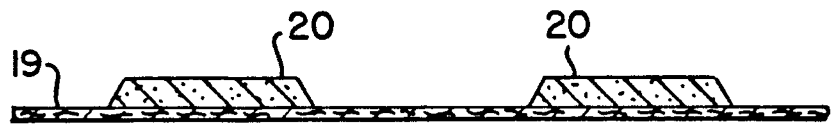


FIG. 6

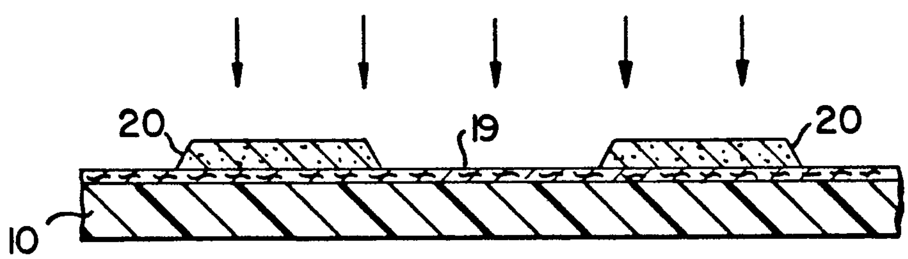


FIG. 7

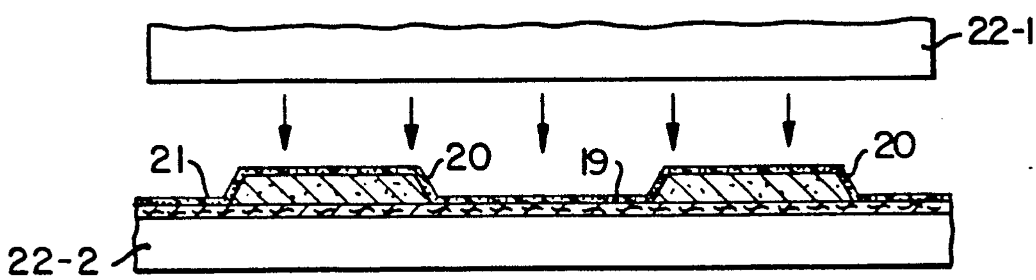


FIG. 8

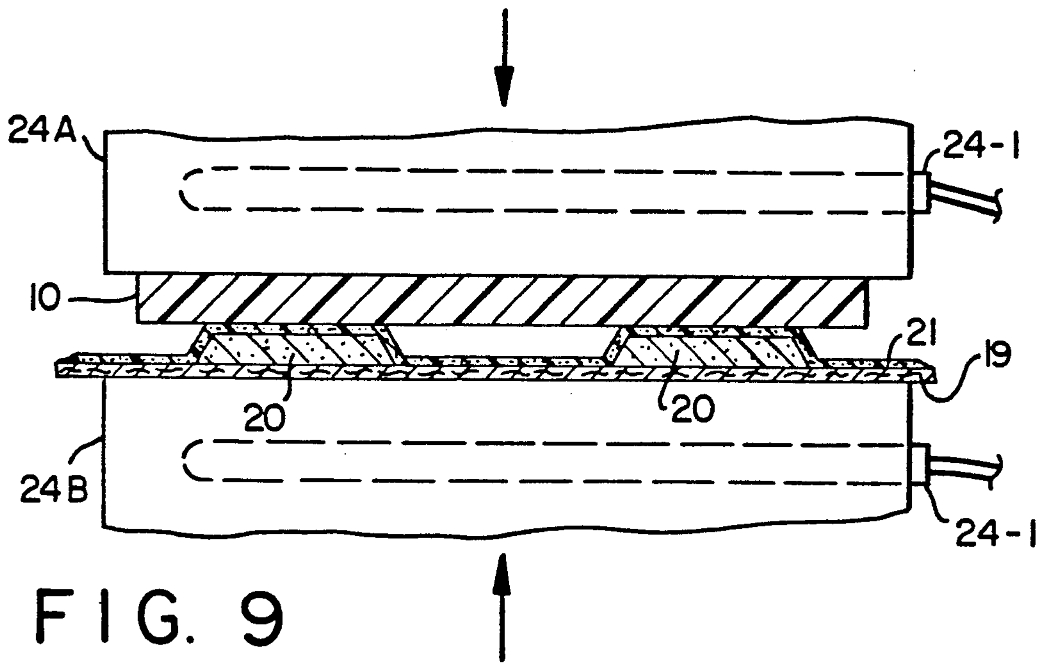


FIG. 9

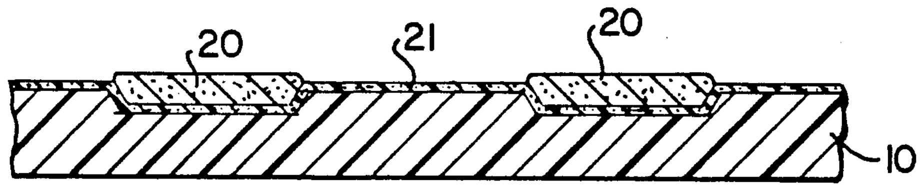


FIG. 11

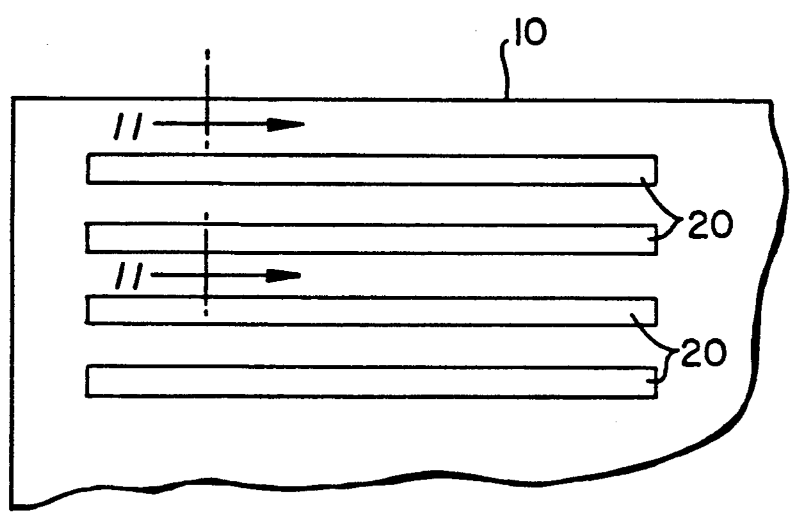


FIG 10

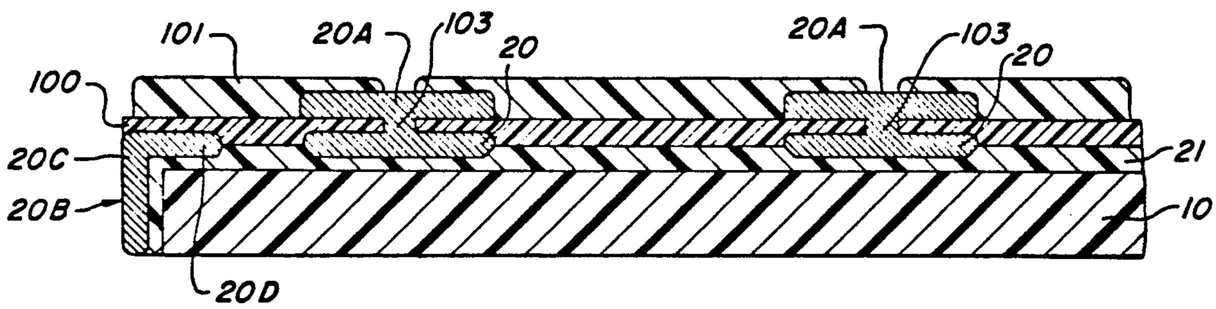


FIG. 12